# EUROPEAN PATENT APPLICATION

(11) **EP 4 851 716 A1**
(43) Date of publication of application: **09.12.2026**
(21) Application number: 25748092.1
(22) Date of filing: 23.01.2025
(51) Int. Cl.: G03F 7/11, C08G 8/28, G03F 7/004, H01L 21/027

(54) **COMPOSITION FOR FORMING RESIST UNDERLAYER FILM, RESIST UNDERLAYER FILM, METHOD FOR FORMING RESIST PATTERN, AND METHOD FOR MANUFACTURING SEMICONDUCTOR DEVICE**

(30) Priority: 02.02.2024 JP 2024015151
(71) Applicant: Nissan Chemical Corporation, Tokyo 103-6119 (JP)
(72) Inventor: MITSUTAKE Yuki, Toyama-shi, Toyama 939-2792 (JP)
(74) Representative: Hoffmann Eitle
(86) International application number: PCT/JP2025/002120
(87) International publication number: WO 2025/164510

(57) **Abstract**

Provided is a resist underlayer film-forming composition including: a resin (G) having a composite unit structure; and
a solvent, wherein the composite unit structure has
a unit structure (A) having an aromatic ring, and a unit structure (B) having one or more carbon atoms, the resin (G) is a resin obtained by a reaction of generating a covalent bond between a carbon atom constituting the aromatic ring of the unit structure (A) and a carbon atom in the unit structure (B), the unit structure (A) includes a unit structure (A-I) containing at least a biphenyl skeleton, and the unit structure (B) includes a unit structure (B-I) having a quaternary carbon atom bonded to a carbon atom constituting the aromatic ring of the unit structure (A).

## Description

### Technical Field

The present invention relates to a resist underlayer film-forming composition, a resist underlayer film, a method for forming a resist pattern, and a method for manufacturing a semiconductor device.

### Background Art

In recent years, the advancement of semiconductor manufacturing processes has progressed rapidly, and accordingly, higher quality and improved characteristics of resist underlayer films have been strongly demanded (see, for example, Patent Literature 1 to 6). In particular, for resist underlayer films known as high carbon materials, imparting etching resistance is strongly demanded.

### Citation List

### Patent Literature

Patent Literature 1: US 2016/311975 A1
Patent Literature 2: WO 2018/198960 A1
Patent Literature 3: JP 2021-81686 A
Patent Literature 4: JP 2020-105513 A
Patent Literature 5: WO 2013/146670 A1
Patent Literature 6: JP 2016-151024 A

### Summary of Invention

### Technical Problem

However, it is very difficult to produce a material that achieves both characteristics such as solvent resistance, coatability onto a stepped substrate, and planarizability, and etching resistance, and there is still room for improvement as a material. In addition, in a manufacturing step of a semiconductor device, when the amount of sublimate generated from a resist underlayer film is large, problems such as contamination of the top plate and inside of the pipes of the baker used at the time of baking occur.

The present invention has been made in view of the above circumstances, and an object thereof is to provide a resist underlayer film-forming composition that satisfies solvent resistance, etching resistance, coatability onto a stepped substrate, and planarizability in a well-balanced manner while suppressing the amount of sublimates generated, as well as a resist underlayer film, a method for forming a resist pattern, and a method for manufacturing a semiconductor device that use the resist underlayer film-forming composition.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition including:
   a resin (G) having a composite unit structure; and
   a solvent,
   wherein the composite unit structure has
   a unit structure (A) having an aromatic ring, and a unit structure (B) having one or more carbon atoms,
   the resin (G) is a resin obtained by a reaction of generating a covalent bond between a carbon atom constituting the aromatic ring of the unit structure (A) and a carbon atom in the unit structure (B),
   the unit structure (A) includes a unit structure (A-I) containing at least a biphenyl skeleton, and
   the unit structure (B) includes a unit structure (B-I) having a quaternary carbon atom bonded to a carbon atom constituting the aromatic ring of the unit structure (A).
[2] The resist underlayer film-forming composition according to [1], wherein the resin (G) includes, as the composite unit structure, any one or two of the composite unit structures represented by Formulae (1a) and (1b) below. 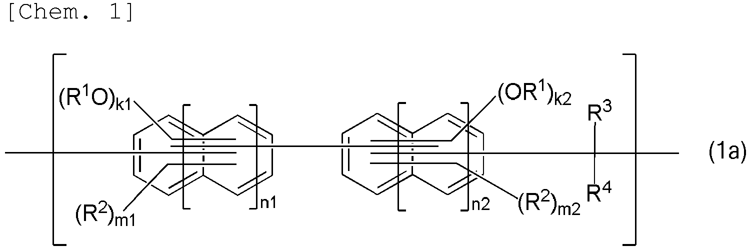 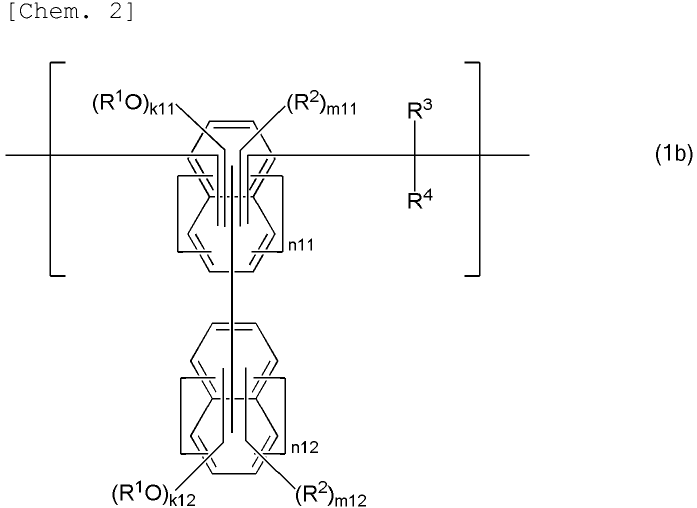 (in Formulae (1a) and (1b), each R¹ independently represents a hydrogen atom, an alkyl group having 1 to 10 carbon atoms, an alkenyl group having 2 to 6 carbon atoms, an alkynyl group having 2 to 6 carbon atoms, or an acyl group having 2 to 7 carbon atoms, each R² independently represents an alkyl group having 1 to 10 carbon atoms, an alkenyl group having 2 to 6 carbon atoms, or a halo group, R³ and R⁴ each independently represent an aromatic or aliphatic hydrocarbon group which may have a substituent, and when R³ and R⁴ bonded to the same carbon atom each represent an aromatic hydrocarbon group, R³ and R⁴ may be bonded to each other to form a fluorene ring, and when R³ and R⁴ bonded to the same carbon atom each represent an aliphatic hydrocarbon group, R³ and R⁴ may be bonded to each other to form an aliphatic hydrocarbon ring, k1, k2, m1, m2, n1, and n2 each independently represent 0 or 1, (k1+k2) is 1 or 2, k11, k12, m11, m12, n11, and n12 each independently represent 0 or 1, and (k11+k12) is 1 or 2).
[3] The resist underlayer film-forming composition according to [2], wherein, in Formulae (1a) and (1b), the substituent that the aromatic or aliphatic hydrocarbon group may have is one or more groups selected from a halo group, an alkyl group, an alkenyl group, an alkynyl group, an alkoxy group, an aryl group, an aryloxy group, an amino group, a hydroxy group, a hydroxyalkyl group, a carboxy group, a formyl group, a cyano group, a nitro group, an ester group, an amide group, a sulfonyl-containing group, a thiol group, a sulfide-containing group, and an ether bond-containing group.
[4] The resist underlayer film-forming composition according to [2] or [3], wherein, in Formulae (1a) and (1b), the aromatic hydrocarbon group is a phenyl group or a naphthyl group.
[5] The resist underlayer film-forming composition according to any one of [2] to [4], wherein, in Formulae (1a) and (1b), the aliphatic hydrocarbon group is an alkyl group having 1 to 10 carbon atoms.
[6] The resist underlayer film-forming composition according to any one of [1] to [5], wherein the resin (G) is a resin synthesized by a polymerization reaction of at least one compound having a biphenyl skeleton and at least one aromatic ketone or aliphatic ketone in the presence of an acid catalyst.
[7] The resist underlayer film-forming composition according to any one of [1] to [6], wherein the solvent includes a solvent having a boiling point of 160°C or higher.
[8] The resist underlayer film-forming composition according to any one of [1] to [7], further including at least one selected from the group consisting of an acid, a salt thereof, and an acid generator.
[9] The resist underlayer film-forming composition according to any one of [1] to [8], further including a crosslinking agent.
[10] The resist underlayer film-forming composition according to [9], wherein the crosslinking agent is at least one selected from the group consisting of an aminoplast crosslinking agent and a phenoplast crosslinking agent.
[11] The resist underlayer film-forming composition according to any one of [1] to [10], further including a surfactant.
[12] A resist underlayer film on a semiconductor substrate, which is a cured product of the resist underlayer film-forming composition according to any one of [1] to [11].
[13] A method for forming a resist pattern used for manufacturing a semiconductor, the method including: a step of applying the resist underlayer film-forming composition according to any one of [1] to [11] onto a semiconductor substrate and baking the composition to form a resist underlayer film.
[14] A method for manufacturing a semiconductor device, the method including:
   a step of forming a resist underlayer film on a semiconductor substrate using the resist underlayer film-forming composition according to any one of [1] to [11];
   a step of forming a resist film on the resist underlayer film;
   a step of forming a resist pattern by irradiating the resist film with light or an electron beam and developing the resist film;
   a step of etching the resist underlayer film through the resist pattern to form a patterned resist underlayer film; and
   a step of processing the semiconductor substrate through the patterned resist underlayer film.
[15] A method for manufacturing a semiconductor device, the method including:
   a step of forming a resist underlayer film on a semiconductor substrate using the resist underlayer film-forming composition according to any one of [1] to [11];
   a step of forming a hard mask on the resist underlayer film;
   a step of further forming a resist film on the hard mask;
   a step of forming a resist pattern by irradiating the resist film with light or an electron beam and developing the resist film;
   a step of etching the hard mask through the resist pattern to form a patterned hard mask;
   a step of etching the resist underlayer film through the patterned hard mask to form a patterned resist underlayer film; and
   a step of processing the semiconductor substrate through the patterned resist underlayer film.
[16] A method for manufacturing a semiconductor device, the method including:
   a step of forming a resist underlayer film on a semiconductor substrate using the resist underlayer film-forming composition according to any one of [1] to [11];
   a step of forming a hard mask on the resist underlayer film;
   a step of further forming a resist film on the hard mask;
   a step of forming a resist pattern by irradiating the resist film with light or an electron beam and developing the resist film;
   a step of etching the hard mask through the resist pattern to form a patterned hard mask;
   a step of etching the resist underlayer film through the patterned hard mask to form a patterned resist underlayer film;
   a step of removing the hard mask; and
   a step of processing the semiconductor substrate through the patterned resist underlayer film.
[17] A method for manufacturing a semiconductor device, the method including:
   a step of forming a resist underlayer film on a semiconductor substrate using the resist underlayer film-forming composition according to any one of [1] to [11];
   a step of forming a hard mask on the resist underlayer film;
   a step of further forming a resist film on the hard mask;
   a step of forming a resist pattern by irradiating the resist film with light or an electron beam and developing the resist film;
   a step of etching the hard mask through the resist pattern to form a patterned hard mask;
   a step of etching the resist underlayer film through the patterned hard mask to form a patterned resist underlayer film;
   a step of removing the hard mask;
   a step of forming a deposited film on the resist underlayer film after the removal of the hard mask;
   a step of processing the deposited film by etching;
   a step of removing the patterned resist underlayer film to leave a patterned deposited film; and
   a step of processing the semiconductor substrate through the patterned deposited film.
[18] The method for manufacturing a semiconductor device according to any one of [15] to [17], wherein the hard mask is formed by applying a composition containing an inorganic substance or by depositing an inorganic substance.
[19] The method for manufacturing a semiconductor device according to any one of [14] to [18], wherein the resist film is pattern-formed by a nanoimprint method or a self-assembled film.
[20] The method for manufacturing a semiconductor device according to [16] or [17], wherein the removal of the hard mask is performed either by etching or by using an alkaline chemical solution.

### Advantageous Effects of Invention

According to the present invention, it is possible to provide a resist underlayer film-forming composition that satisfies solvent resistance, etching resistance, coatability onto a stepped substrate, and planarizability in a well-balanced manner while suppressing the amount of sublimates generated, as well as a resist underlayer film, a method for forming a resist pattern, and a method for manufacturing a semiconductor device that use the resist underlayer film-forming composition.

### Description of Embodiments

### [Resist underlayer film-forming composition]

The resist underlayer film-forming composition of the present invention includes a resin (G) having a composite unit structure and a solvent.

The composite unit structure has a unit structure (A) having an aromatic ring and a unit structure (B) having one or more carbon atoms.

The resin (G) is a resin obtained through a reaction of generating a covalent bond between a carbon atom constituting the aromatic ring of the unit structure (A) and the carbon atom in the unit structure (B).

The unit structure (A) includes a unit structure (A-I) including at least a biphenyl skeleton.

The unit structure (B) includes a unit structure (B-I) having a quaternary carbon atom bonded to a carbon atom constituting the aromatic ring of the unit structure (A).

In the present specification, the resin (G) may be referred to as a "novolac resin".

Since the resin (G) includes the unit structure (A) and the unit structure (B) described above, it is possible to provide a resist underlayer film-forming composition that satisfies solvent resistance, etching resistance, coatability onto a stepped substrate, and planarizability in a well-balanced manner while suppressing the amount of sublimates generated.

The unit structure (A) has, for example, at least one of an oxygen atom constituting an aromatic ring, a sulfur atom constituting an aromatic ring, an oxygen atom bonded to an aromatic ring, a nitrogen atom constituting an aromatic ring, and a nitrogen atom bonded to an aromatic ring.

The unit structure (A) does not have, for example, a heteroatom as an atom constituting an aromatic ring and an atom bonded to the aromatic ring.

The unit structure (B) is, for example, a unit structure derived from an aldehyde compound or an aldehyde equivalent.

The aldehyde equivalent is an organic compound that allows a covalent bond to an aromatic ring, the organic compound having a ketone group, an acetal group, a ketal group, a hydroxy group or an alkoxy group bonded to a secondary or tertiary carbon atom, a hydroxy group, an alkoxy group, or a halo group bonded to the α-position carbon atom of an alkylaryl group, or a carbon-carbon unsaturated bond.

### [I. Definition of terms]

In the present specification, definitions of main terms related to a novolac resin which is one aspect of the present invention will be described below. Unless stated otherwise individually, the following definitions of terms apply for novolac resins.

### (I-1) "Novolac Resin"

The "novolac resin" is used in a broad sense to broadly include not only phenol-formaldehyde resins (so-called novolac type phenol resins) and aniline-formaldehyde resins (so-called novolac type aniline resins) in a narrow sense, but also resins formed by formation of a covalent bond (substitution reaction, addition reaction, condensation reaction, addition condensation reaction, and the like) between an organic compound having a functional group that enables a covalent bond with an aromatic ring [for example, an aldehyde group, a ketone group, an acetal group, a ketal group, a hydroxy group or an alkoxy group bonded to secondary or tertiary carbon atom, a hydroxy group, an alkoxy group, or a halo group bonded to an α-position carbon atom (benzyl position carbon atom or the like) of the alkylaryl group; carbon-carbon unsaturated bonds such as divinylbenzene and dicyclopentadiene, and the like], and an aromatic ring in a compound having an aromatic ring (which preferably has a heteroatom such as an oxygen atom, a nitrogen atom, or a sulfur atom as an atom constituting the aromatic ring or an atom bonded to the aromatic ring), generally, in the presence of an acid catalyst or under reaction conditions equivalent thereto.

Therefore, in the novolac resin described in the present specification, an organic compound including a carbon atom derived from the functional group (sometimes referred to as a "linking carbon atom") forms a covalent bond with an aromatic ring in a compound having an aromatic ring via the linking carbon atom, thereby linking a plurality of compounds having an aromatic ring to form a resin.

In the present specification, terms "unit structure (A)" and "unit structure (B)" are used as the unit structures constituting the "novolac resin". The unit structure (A) is a unit structure derived from a compound having an aromatic ring. The unit structure (B) is a unit structure derived from a compound having a functional group capable of covalent bonding with the aromatic ring of the unit structure (A).

### (I-2) "Residue"

The "residue" refers to an organic group in which a hydrogen atom bonded to a carbon atom or a heteroatom (nitrogen atoms, oxygen atoms, sulfur atoms, and the like) is replaced with a bonding site, and may be a monovalent group or a multivalent group. For example, when one hydrogen atom is replaced with one bonding site, a monovalent organic group is formed, and when two hydrogen atoms are replaced with bonding sites, a divalent organic group is formed.

### (I-3) "Aromatic ring" (Aromatic group, aryl group, arylene group)

The "aromatic ring" is a concept including an aromatic hydrocarbon ring, an aromatic heterocyclic ring, and residues thereof [it may also be referred to as an "aromatic group", an "aryl group" (in the case of a monovalent group), or an "arylene group" (in the case of a divalent group)], and includes not only a monocyclic ring (aromatic monocyclic ring) but also a polycyclic ring (aromatic polycyclic ring). In the case of polycyclic ring(s), at least one monocyclic ring is an aromatic monocyclic ring, but the remaining monocyclic ring forming a condensed ring with the aromatic monocyclic ring may be a monocyclic heterocyclic ring (heteromonocyclic ring) or a monocyclic alicyclic hydrocarbon (alicyclic monocyclic ring) .

In the present specification, a heteroaryl group is included in an aryl group. A heteroarylene group is included in an arylene group.

Examples of the aromatic rings include, but are not limited to, aromatic hydrocarbon rings such as benzene, indene, naphthalene, azulenes, styrene, toluene, xylene, mesitylene, cumene, anthracene, phenanthrene, triphenylene, benzoanthracene, pyrene, chrysene, fluorene, biphenyl, corannulene, perylene, fluoranthene, benzo[k]fluoranthene, benzo[b]fluoranthene, benzo[ghi]perylene, coronene, dibenzo[g,p]chrysene, acenaphthylene, acenaphthene, naphthacene, pentacene, cyclooctatetraene, more typically, aromatic hydrocarbon rings such as benzene, naphthalene, anthracene, pyrene, and aromatic heterocyclic rings such as furan, pyran, pyridine, pyrimidine, pyrazine, thiophene, pyrrole, N-alkylpyrrole, N-arylpyrrole, imidazole, pyridine, pyrimidine, pyrazine, triazine, thiazole, indole, phenylindole, bisindolefluorene, bisindolebenzofluorene, bisindoledibenzofluorene, purine, quinoline, isoquinoline, chromene, thianthrene, phenothiazine, phenoxazine, xanthene, acridine, phenazine, carbazole, indolocarbazole, and, more typically, furan, thiophene, pyrrole, indole, phenylindole, bisindolefluorene, phenothiazine, carbazole and indolocarbazole.

The aromatic ring (for example, benzene ring or naphthalene ring) may optionally have a substituent, and the substituent includes, for example, the following atoms and groups:
- Halogen atom,
- Saturated or unsaturated linear, branched or cyclic hydrocarbon group (-R^{a}) which may be interrupted one or more times by an oxygen atom in the middle of a hydrocarbon chain (alkyl, alkenyl, and alkynyl groups (for example, a propargyl group), aryl groups, and the like, which may be interrupted one or more times by an oxygen atom in the middle of the hydrocarbon chain),
- -OR (wherein R represents the hydrocarbon group -R^{a}),
- Aryloxy group,
- -NH₂, -NHR, or -NR₂ (the two Rs may be the same or different from each other), wherein R represents the hydrocarbon group -R^{a},
- Hydroxy group,
- Hydroxyalkyl group,
- Carboxy group,
- Formyl group,
- Cyano group,
- Nitro group,
- Ester group (for example, -CO₂R or -OCOR, wherein R represents the hydrocarbon group -R^{a}),
- Amide group [for example, -NHCOR, -CONHR, -NRCOR (the two Rs may be the same or different from each other), or - CONR₂ (the two Rs may be the same or different from each other), wherein R represents the hydrocarbon group -R^{a}],
- Sulfonyl-containing group (for example, -SO₂R, wherein R represents the hydrocarbon group -R^{a} or hydroxy group -OH),
- Thiol group (-SH),
- Sulfide-containing group (-SR, wherein R represents the hydrocarbon group -R^{a}),
- Organic group including ether bond [a residue of an ether compound represented by R¹¹-O-R¹¹ (each R¹¹ independently represents an alkyl group having 1 to 6 carbon atoms such as a methyl group or an ethyl group, or an aryl group such as a phenyl group, a naphthyl group, an anthranil group, or a pyrenyl group), for example, an organic group including an ether bond including a methoxy group, an ethoxy group, and a phenoxy group].

The "aromatic ring" further includes an organic group having a condensed ring of one or more aromatic rings (benzene, naphthalene, anthracene, pyrene, and the like) and one or more aliphatic rings or heterocyclic rings. Examples of the aliphatic ring herein can include cyclobutane, cyclobutene, cyclopentane, cyclopentene, cyclohexane, cyclohexene, methylcyclohexane, methylcyclohexene, cycloheptane, and cycloheptene, and examples of the heterocyclic ring can include furan, thiophene, pyrrole, imidazole, pyran, pyridine, pyrimidine, pyrazine, pyrrolidine, piperidine, piperazine, and morpholine.

The "aromatic ring" may be an organic group having a structure in which two or more aromatic rings are linked by a divalent linking group. Examples of the divalent linking group include an alkylene group, an arylene group, -NH-, - NHCO-, -O-, -COO-, -CO-, -S-, -SS-, and -SO₂-. In addition, the divalent linking group may be a divalent group obtained by removing one hydrogen atom from any substituent of the aromatic ring described above.

### (I-4) "Heterocyclic ring"

The "heterocyclic ring" is a concept that encompasses both an aliphatic heterocyclic ring and an aromatic heterocyclic ring, and encompasses not only a monocyclic (heteromonocyclic) ring but also a polycyclic (heteropolycyclic) ring. In the case of polycyclic rings, at least one monocyclic ring is a heteromonocyclic ring, but the remaining monocyclic rings may be aromatic hydrocarbon monocyclic rings or alicyclic monocyclic rings. As the aromatic heterocyclic ring, reference can be made to the example of (I-3) described above. As with the aromatic ring of (I-3), it may have a substituent.

### (I-5) "Non-aromatic ring" (aliphatic ring)

The "non-aromatic monocyclic ring" when the "non-aromatic ring" is a monocyclic ring refers to a monocyclic hydrocarbon not belonging to aromatics, and is typically a monocyclic ring of an alicyclic compound. It may also be referred to as an aliphatic monocyclic ring (an aliphatic heteromonocyclic ring may be included, or as long as the ring does not belong to an aromatic compound, an unsaturated bond may be included). As with the aromatic ring of (I-3), it may have a substituent.

Examples of the non-aromatic monocyclic ring (aliphatic ring, aliphatic monocyclic ring) include cyclopropane, cyclobutane, cyclobutene, cyclopentane, cyclopentene, cyclohexane, methylcyclohexane, cyclohexene, methylcyclohexene, cycloheptane, and cycloheptene.

The "non-aromatic polycyclic ring" when the "non-aromatic ring" is a polycyclic ring refers to a polycyclic hydrocarbon not belonging to aromatics, and is typically a polycyclic ring of an alicyclic compound. It may also be referred to as an aliphatic polycyclic ring [an aliphatic heteropolycyclic ring (at least one of monocyclic rings constituting polycyclic rings is an aliphatic heterocyclic ring) may be included, or an unsaturated bond may be included as long as the ring does not belong to an aromatic compound]. Non-aromatic bicyclic rings, non-aromatic tricyclic rings, and non-aromatic tetracyclic rings are included.

The "non-aromatic bicyclic ring" when the "non-aromatic ring" is bicyclic refers to a condensed ring composed of two monocyclic hydrocarbons that do not belong to aromatics, and is typically a condensed ring of two alicyclic compounds. In the present specification, it may be referred to as an aliphatic bicyclic ring (an aliphatic heterobicyclic ring may be included, or an unsaturated bond may be included as long as it does not belong to an aromatic compound). Examples of the non-aromatic bicyclic ring include bicyclopentane, bicyclooctane, and bicycloheptene.

When the "non-aromatic ring" is a tricyclic ring, the "non-aromatic tricyclic ring" refers to a condensed ring composed of three monocyclic hydrocarbons that do not belong to aromatics, and is typically a condensed ring of three alicyclic compounds (each may be a heterocyclic ring or may contain an unsaturated bond as long as it does not belong to an aromatic compound). Examples of the non-aromatic tricyclic ring include tricyclooctane, tricyclononane, and tricyclodecane.

When the "non-aromatic ring" is a tetracyclic ring, the "non-aromatic tetracyclic ring" refers to a condensed ring composed of four monocyclic hydrocarbons that do not belong to aromatics, and is typically a condensed ring of four alicyclic compounds (each may be a heterocyclic ring or may contain an unsaturated bond as long as it does not belong to an aromatic compound). Examples of the non-aromatic tetracyclic ring include hexadecahydropyrene.

### (I-6)

The "carbon atom constituting the ring (moiety)" means a carbon atom constituting a hydrocarbon ring in a state without a substituent (may be any of an aromatic ring, an aliphatic ring, and a heterocyclic ring).

### (I-7)

The "hydrocarbon group" refers to a group obtained by removing one or two or more hydrogen atoms from a hydrocarbon, and examples of such a hydrocarbon include a saturated or unsaturated aliphatic hydrocarbon, a saturated or unsaturated alicyclic hydrocarbon, and an aromatic hydrocarbon.

### (I-8)

In the chemical structural formula indicating the unit structure of the novolac resin of the present specification, a bonding site (denoted by *) may be described for convenience, but such a bonding site can adopt any bonding position wherein bonding can be achieved in the unit structure, and does not limit the bonding position in the unit structure at all, unless otherwise specified.

### <Resin (G)>

The resin (G) has a composite unit structure.

The composite unit structure has a unit structure (A) having an aromatic ring and a unit structure (B) having one or more carbon atoms.

The composite unit structure of the resin (G) is represented by, for example, Formula (AB) below. 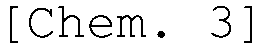 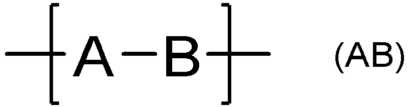 (In Formula (AB), A represents the unit structure (A), and B represents the unit structure (B).)

### <<A-1: Unit structure (A)>>

The unit structure (A) has an aromatic ring.

The unit structure (A) may have, for example, at least one of an oxygen atom constituting an aromatic ring, a sulfur atom constituting an aromatic ring, an oxygen atom bonded to an aromatic ring, a nitrogen atom constituting an aromatic ring, and a nitrogen atom directly bonded to an aromatic ring.

The number of carbon atoms of the unit structure (A) is not particularly limited, and is, for example, 4 to 100, and preferably 4 to 50.

Preferably, such an aromatic ring has a number of carbon atoms of 4 to 30, more preferably 4 to 24.

Preferably, the aromatic ring is one or more benzene rings, naphthalene rings, anthracene rings, and pyrene rings, or a condensed ring (a fluorene ring, a benzofluorene ring, a dibenzofluorene ring, an indole ring, a carbazole ring, an indolocarbazole ring, and the like) of a benzene ring, a naphthalene ring, an anthracene ring, or a pyrene ring with a heterocyclic ring or an aliphatic ring.

The aromatic ring may optionally have a substituent, but from the viewpoint of polymerization reactivity, the substituent may contain a minimum necessary amount of heteroatoms. In the aromatic ring, two or more aromatic rings may be linked by a linking group, and the linking group may contain the minimum necessary amount of heteroatoms. Examples of the heteroatom include an oxygen atom, a nitrogen atom, and a sulfur atom.

An "aromatic ring" may include at least one heteroatom selected from N, S, and O on, within, or between rings.

Examples of the heteroatom which may be contained on the ring include a nitrogen atom contained in an amino group (for example, a propargylamino group) or a cyano group; an oxygen atom contained in a formyl group, a hydroxy group, a carboxy group, an alkoxy group, an alkenyloxy group, an alkynyloxy group (for example, a propargyloxy group), or an aryloxy group, which are oxygen-containing substituents; and a nitrogen atom and an oxygen atom contained in a nitro group, which is an oxygen-containing substituent and a nitrogen-containing substituent.

Examples of the heteroatom which may be contained in the ring include an oxygen atom contained in furan or xanthene, a nitrogen atom contained in carbazole or pyrrole, and a sulfur atom contained in phenothiazine.

Examples of the heteroatom which may be contained in the linking group of two or more aromatic rings include a nitrogen atom, an oxygen atom, and a sulfur atom contained in -NH-, -NHCO-, -O-, -COO-, -CO-, -S-, -SS-, and -SO₂-.

In the present specification, "atoms constituting an aromatic ring" have the same meaning as "atoms contained in a ring". The "atom bonded to an aromatic ring" refers to, for example, "an atom directly bonded to a ring among atoms or groups contained on the ring" and "an atom directly bonded to a ring among atoms contained between rings".

For example, the atom constituting the benzene ring is a carbon atom.

For example, the atoms constituting the pyrrole ring are a carbon atom and a nitrogen atom.

For example, the oxygen atom of the hydroxy group of phenol is not an atom constituting an aromatic ring.

For example, the oxygen atom of the hydroxy group of phenol is an atom bonded to the benzene ring, and is an atom directly bonded to the benzene ring among the groups contained on the benzene ring.

### <<A-2: Example of skeleton constituting unit structure (A)>>

The unit structure (A) has, for example, a skeleton having an aromatic ring.

As the skeleton having an aromatic ring, an aromatic amine skeleton, a nitrogen-containing aromatic heterocyclic skeleton, and a phenol skeleton are preferred.

The unit structure (A) is, for example, a residue obtained by removing two hydrogen atoms from a skeleton having an aromatic ring.

The skeleton having an aromatic ring is derived from, for example, a compound having an aromatic ring when the resin (G) is synthesized. The skeleton having an aromatic ring is, for example, a residue derived from removing two hydrogen atoms from a compound having an aromatic ring when the resin (G) is synthesized.

The skeleton having an aromatic ring may have a substituent.

Here, examples of the substituent include a halo group (halogen atom), an alkyl group, an alkenyl group, an alkynyl group, an alkoxy group, an aryl group, an aryloxy group, an amino group, a hydroxy group, a hydroxyalkyl group, a carboxy group, a formyl group, a cyano group, a nitro group, an ester group, an amide group, a sulfonyl-containing group, a thiol group, a sulfide-containing group, and an ether bond-containing group.

Examples of the alkyl group include a linear, branched, or cyclic alkyl group having 1 to 20 carbon atoms.

Examples of the alkenyl group include a linear, branched, or cyclic alkenyl group having 2 to 10 carbon atoms.

Examples of the alkynyl group include a linear, branched, or cyclic alkynyl group having 2 to 10 carbon atoms.

Examples of the alkoxy group include a group represented by -OR. Here, R represents a saturated or unsaturated linear, branched or cyclic hydrocarbon group (-R^{a}) which may be interrupted one or more times by an oxygen atom in the middle of the hydrocarbon chain. The number of carbon atoms of the alkoxy group is, for example, 1 to 20.

Examples of the aryl group include aryl groups having 6 to 30 carbon atoms.

Examples of the aryloxy group include aryloxy groups having 6 to 30 carbon atoms.

Examples of the amino group include a group represented by -NH₂, -NHR, or -NR₂. Here, R represents the hydrocarbon group -R^{a}, and in -NR₂, two Rs may be the same or different.

Examples of the hydroxyalkyl group include a linear, branched, or cyclic hydroxyalkyl group having 1 to 20 carbon atoms.

Examples of the ester group include a group represented by -CO₂R or -OCOR. Here, R represents the hydrocarbon group -R^{a}.

Examples of the amide group include a group represented by -NHCOR, -CONHR, -NRCOR, or -CONR₂. Here, R represents the hydrocarbon group -R^{a}, and in a case where there are two Rs, the two Rs may be the same or different.

Examples of the sulfonyl-containing group include a group represented by -SO₂R. Here, R represents the hydrocarbon group -R^{a} or a hydroxy group -OH.

Examples of the sulfide-containing group include a group represented by -SR. Here, R represents the hydrocarbon group -R^{a}.

Examples of the ether bond-containing group include residues of an ether compound containing an ether bond represented by R¹¹-O-R¹¹. Here, each R¹¹ independently represents an alkyl group having 1 to 6 carbon atoms such as a methyl group or an ethyl group, or an aryl group such as a phenyl group, a naphthyl group, an anthranil group, or a pyrenyl group. The ether bond-containing group may be, for example, an organic group containing an ether bond including a methoxy group, an ethoxy group, and a phenoxy group.

### <<<A-3: Unit structure (A-I)>>>

The unit structure (A) includes a unit structure (A-I) including at least a biphenyl skeleton. The unit structure (A-I) has a skeleton having an aromatic ring. Here, the unit structure (A-I) is a subordinate concept of the unit structure (A) and does not refer to a partial structure of the unit structure (A).

Hereinafter, the skeleton having an aromatic ring in the unit structure (A-I) will be described.

The biphenyl skeleton refers to a skeleton including a biphenyl group. The two benzene rings in the biphenyl group may each independently have a substituent, may be linked to another aromatic hydrocarbon ring, or may be fused to another aromatic hydrocarbon ring.

Examples of the other aromatic hydrocarbon ring include a benzene ring, a naphthalene ring, an anthracene ring, a phenanthrene ring, a tetracene ring, a tetraphene ring, a chrysene ring, a triphenylene ring, a pyrene ring, a pentacene ring, and a hexacene ring.

Examples of the biphenyl skeleton include a skeleton represented by the following Formula (G0). These aromatic rings may have a substituent.

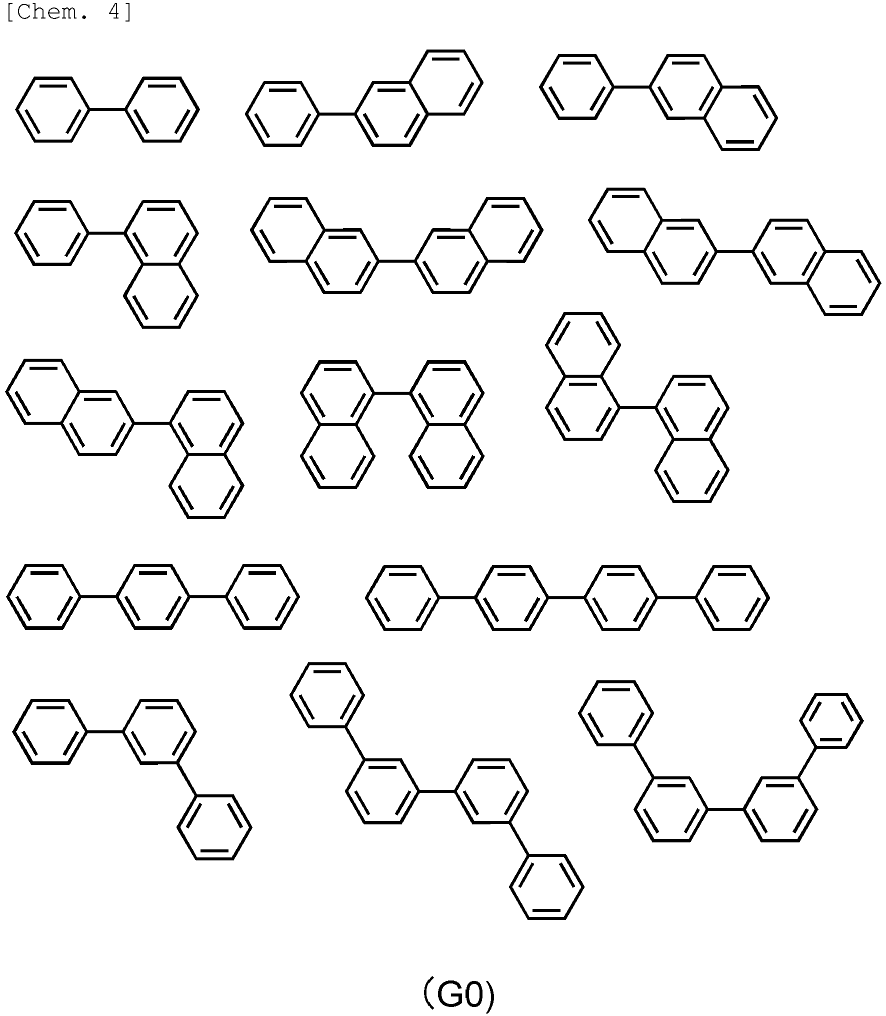

The resin (G) preferably includes, as the composite unit structure, any one or two of composite unit structures represented by the following Formulae (1a) and (1b). 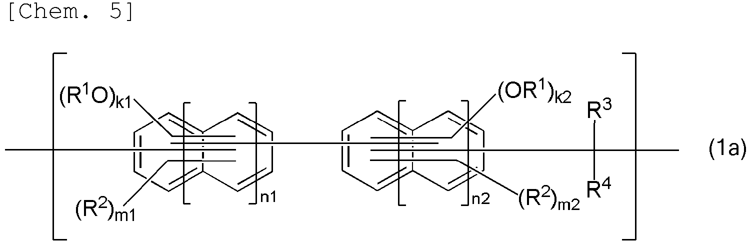 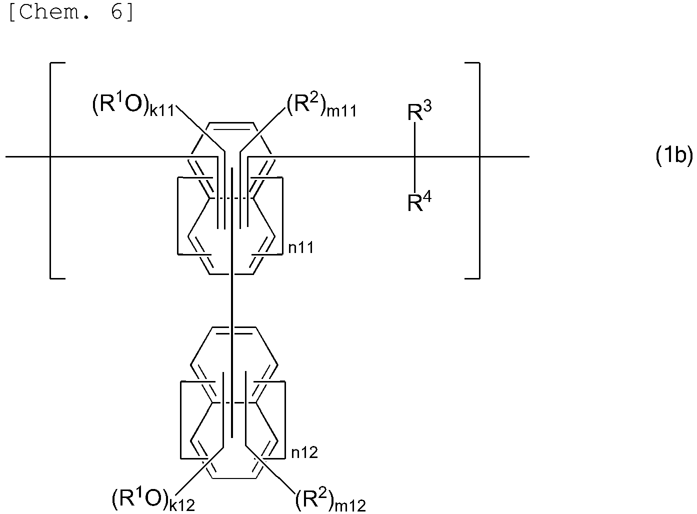 (in Formulae (1a) and (1b), each R¹ independently represents a hydrogen atom, an alkyl group having 1 to 10 carbon atoms, an alkenyl group having 2 to 6 carbon atoms, an alkynyl group having 2 to 6 carbon atoms, or an acyl group having 2 to 7 carbon atoms, each R² independently represents an alkyl group having 1 to 10 carbon atoms, an alkenyl group having 2 to 6 carbon atoms, or a halo group, R³ and R⁴ each independently represent an aromatic or aliphatic hydrocarbon group which may have a substituent, and when R³ and R⁴ bonded to the same carbon atom each represent an aromatic hydrocarbon group, R³ and R⁴ may be bonded to each other to form a fluorene ring, and when R³ and R⁴ bonded to the same carbon atom each represent an aliphatic hydrocarbon group, R³ and R⁴ may be bonded to each other to form an aliphatic hydrocarbon ring, k1, k2, m1, m2, n1, and n2 each independently represent 0 or 1, (k1+k2) is 1 or 2, k11, k12, m11, m12, n11, and n12 each independently represent 0 or 1, and (k11+k12) is 1 or 2).

In Formulae (1a) and (1b), the biphenyl skeleton including R¹ and R² corresponds to the unit structure (A-I), and R³, R⁴, and the carbon atom bonded to R³ and R⁴ correspond to the unit structure (B-I).

The carbon atom bonded to R³ and R⁴ is a quaternary carbon atom.

In addition, the carbon atom bonded to R³ and R⁴ is, for example, a quaternary carbon atom bonded to a carbon atom constituting the aromatic ring of the unit structure (A-1).

Examples of the alkyl group having 1 to 10 carbon atoms include a methyl group, an ethyl group, an n-propyl group, an i-propyl group, a cyclopropyl group, an n-butyl group, an i-butyl group, a s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, an n-heptyl group, an n-octyl group, an n-nonyl group, and an n-decyl group.

Examples of the alkenyl group having 2 to 6 carbon atoms include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, a 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl group, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 1-cyclohexenyl group, a 2-cyclohexenyl group, and a 3-cyclohexenyl group.

Examples of the alkynyl group having 2 to 6 carbon atoms include an ethynyl group, a 1-propynyl group, a propargyl group (2-propynyl group), a 1-butynyl group, a 2-butynyl group, a 3-butynyl group, a 1-pentynyl group, a 2-pentynyl group, a 3-pentynyl group, a 4-pentynyl group, a 1-hexynyl group, a 2-hexynyl group, a 3-hexynyl group, a 4-hexynyl group, and a 5-hexynyl group.

Examples of the acyl group having 2 to 7 carbon atoms include an ethanoyl group (acetyl group), a propanoyl group (propionyl group), a butanoyl group, a heptanoyl group, a hexanoyl group, a heptanoyl group, a propenoyl group (acrylyl group), and a benzoyl group.

In Formulae (1a) and (1b), the two benzene rings in the optionally formed fluorene ring may each independently have a substituent, may be linked to another aromatic hydrocarbon ring, or may be fused to another aromatic hydrocarbon ring.

Examples of the other aromatic hydrocarbon ring include a benzene ring, a naphthalene ring, an anthracene ring, a phenanthrene ring, a tetracene ring, a tetraphene ring, a chrysene ring, a triphenylene ring, a pyrene ring, a pentacene ring, and a hexacene ring.

Examples of the substituent include a halo group, an alkyl group, an alkenyl group, an alkynyl group, an alkoxy group, an aryl group, an aryloxy group, an amino group, a hydroxy group, a hydroxyalkyl group, a carboxy group, a formyl group, a cyano group, a nitro group, an ester group, an amide group, a sulfonyl-containing group, a thiol group, a sulfide-containing group, and an ether bond-containing group.

Examples of the halo group include a halogen atom such as a fluorine atom, a chlorine atom, a bromine atom, and an iodine atom.

Examples of the alkyl group include a linear, branched, or cyclic alkyl group having 1 to 20 carbon atoms.

Examples of the alkenyl group include a linear, branched, or cyclic alkenyl group having 2 to 10 carbon atoms.

Examples of the alkynyl group include a linear, branched, or cyclic alkynyl group having 2 to 10 carbon atoms.

Examples of the alkoxy group include a group represented by -OR. Here, R represents a saturated or unsaturated linear, branched or cyclic hydrocarbon group (-R^{a}) which may be interrupted one or more times by an oxygen atom in the middle of the hydrocarbon chain. The number of carbon atoms of the alkoxy group is, for example, 1 to 20.

Examples of the aryl group include aryl groups having 6 to 30 carbon atoms.

Examples of the aryloxy group include aryloxy groups having 6 to 30 carbon atoms.

Examples of the amino group include a group represented by -NH₂, -NHR, or -NR₂. Here, R represents the hydrocarbon group -R^{a}, and in -NR₂, two Rs may be the same or different.

Examples of the hydroxyalkyl group include a linear, branched, or cyclic hydroxyalkyl group having 1 to 20 carbon atoms.

Examples of the ester group include a group represented by -CO₂R or -OCOR. Here, R represents the hydrocarbon group -R^{a}.

Examples of the amide group include a group represented by -NHCOR, -CONHR, -NRCOR, or -CONR₂. Here, R represents the hydrocarbon group -R^{a}, and in a case where there are two Rs, the two Rs may be the same or different.

Examples of the sulfonyl-containing group include a group represented by -SO₂R. Here, R represents the hydrocarbon group -R^{a} or a hydroxy group -OH.

Examples of the sulfide-containing group include a group represented by -SR. Here, R represents the hydrocarbon group -R^{a}.

Examples of the ether bond-containing group include residues of an ether compound containing an ether bond represented by R¹¹-O-R¹¹. Here, each R¹¹ independently represents an alkyl group having 1 to 6 carbon atoms such as a methyl group or an ethyl group, or an aryl group such as a phenyl group, a naphthyl group, an anthranil group, or a pyrenyl group. The ether bond-containing group may be, for example, an organic group containing an ether bond including a methoxy group, an ethoxy group, and a phenoxy group.

In Formulae (1a) and (1b), examples of the aliphatic hydrocarbon ring which may be formed include a cyclopropane ring, a cyclobutane ring, a cycloheptane ring, a cyclohexane ring, a bicyclopentane ring, a bicyclooctane ring, and a tricyclodecane ring.

In Formulae (1a) and (1b), the aromatic hydrocarbon group is preferably a phenyl group or a naphthyl group (1-naphthyl group or 2-naphthyl group).

In Formulae (1a) and (1b), the aliphatic hydrocarbon group is preferably an alkyl group having 1 to 10 carbon atoms.

The unit structure (A) in the resin (G) may include a unit structure other than the unit structure (A-I).

Examples of the unit structure other than the unit structure (A-I) include a unit structure having an aromatic amine skeleton, a unit structure having a nitrogen-containing aromatic heterocyclic skeleton, and a unit structure having a phenol skeleton.

The unit structure having such a skeleton may include a unit structure (A-I).

### <<<A-4-1: Aromatic amine skeleton>>>

The aromatic amine skeleton refers to a skeleton having an aromatic ring and a nitrogen atom that is bonded to the aromatic ring and does not constitute a ring.

Examples of the aromatic amine skeleton include skeletons represented by Formulae (A-1a) to (A-1c) below.

As described later, in the unit structure (A), the hydrogen atom of the NH group may be replaced with a substituent. Examples of the substituent include the substituent described in (I-3) "Aromatic ring", the substituent described in (A-2) "Exemplary skeleton constituting unit structure (A)", and substituents (S) represented by Formulae (S1) to (S7) described later. 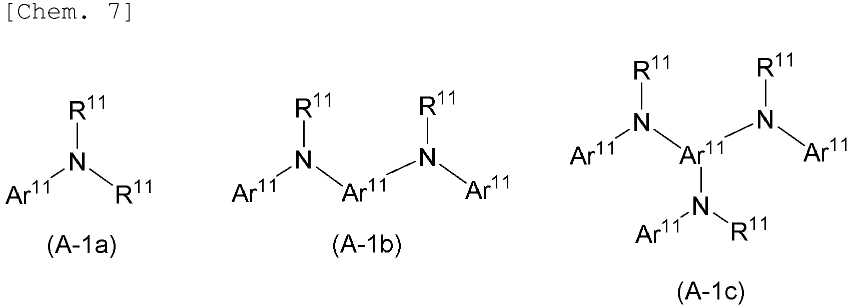 (In Formulae (A-1a) to (A-1c), each Ar¹¹ independently represents a residue of an aromatic ring. Each R¹¹ independently represents a hydrogen atom or a residue of an aromatic ring.

Examples of the aromatic ring in the residue of the aromatic ring of Ar¹¹ and R¹¹ include an aromatic ring represented by Formula (G1) below. These aromatic rings may have a substituent.

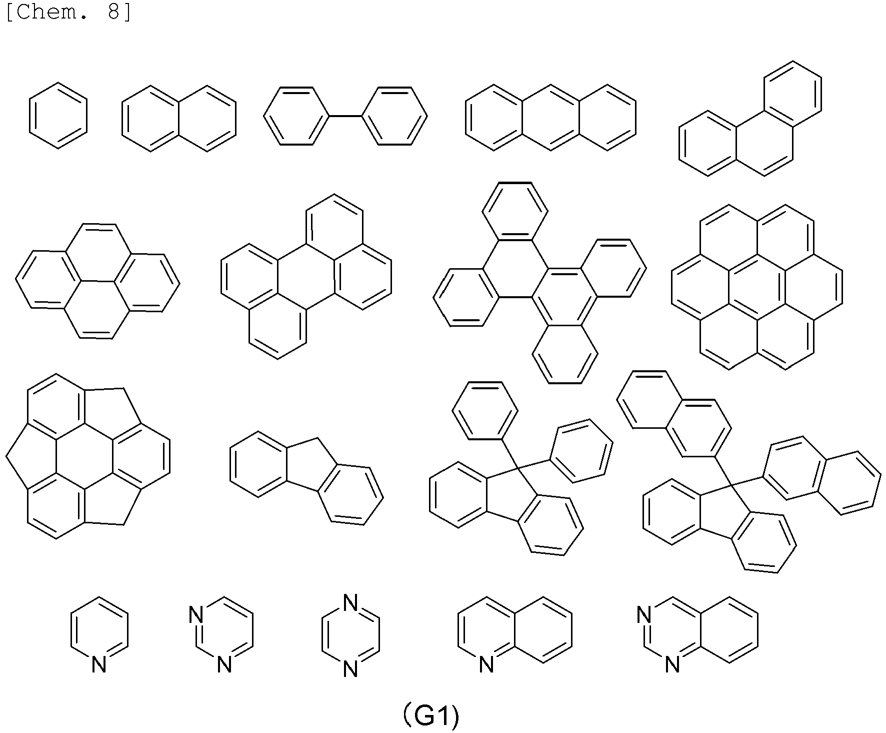

Examples of the skeleton represented by Formula (A-1a) include the following skeletons. The aromatic ring in these skeletons may have a substituent, and the hydrogen atom of the NH group may be substituted with a substituent. The same applies to the following skeletons.

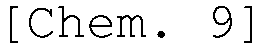

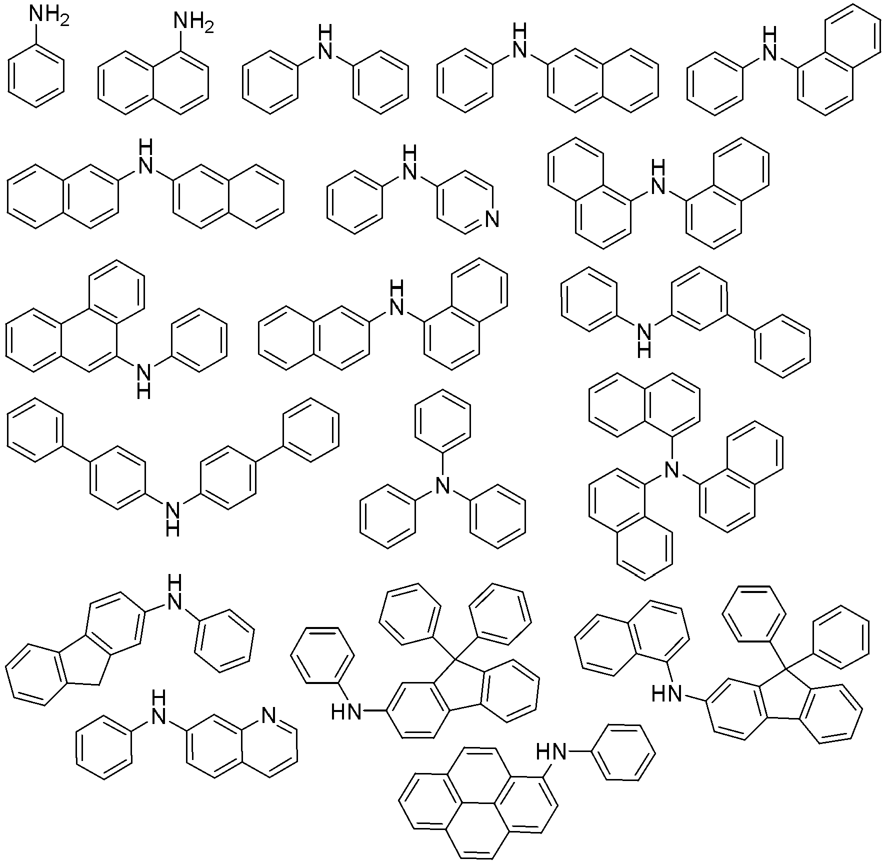

Examples of the skeleton represented by Formula (A-1b) include the following skeletons.

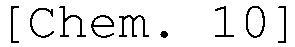

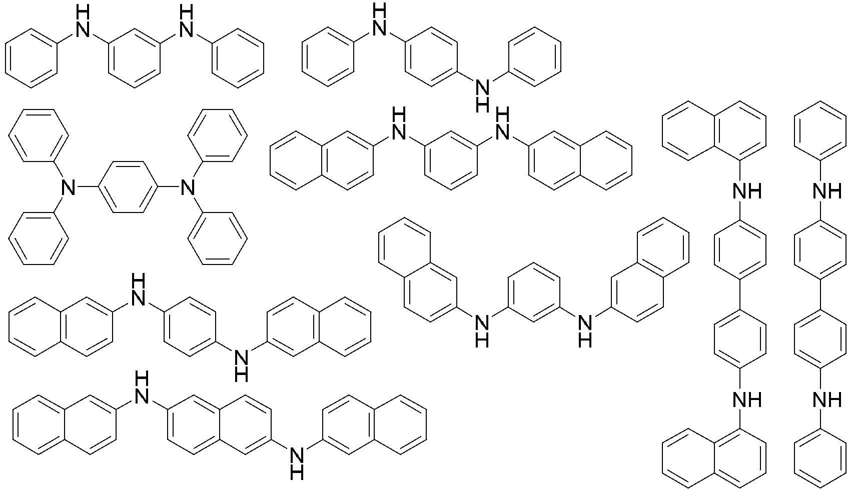

Examples of the skeleton represented by Formula (A-1c) include the following skeletons.

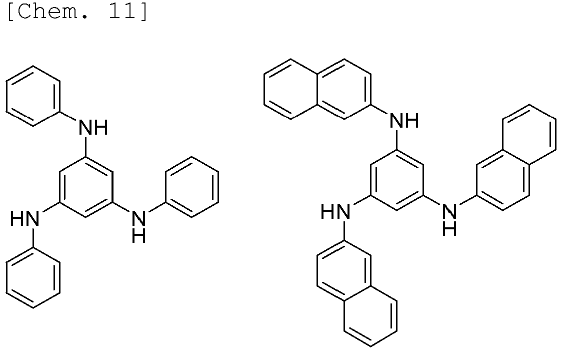

### <<<A-4-2: Nitrogen-containing aromatic heterocyclic skeleton>>>

The nitrogen-containing aromatic heterocyclic skeleton refers to a skeleton having an aromatic heterocyclic ring having a nitrogen atom among the atoms constituting the heterocyclic ring.

Examples of the nitrogen-containing aromatic heterocyclic ring include a pyrrole ring, an indole ring, a carbazole ring, a pyridine ring, an acridine ring, a phenoxazine ring, and a phenothiazine ring. These nitrogen-containing aromatic heterocyclic rings may have a substituent.

Examples of the nitrogen-containing aromatic heterocyclic skeleton include a skeleton represented by Formula (A-2a) below, Formula (A-2b-1) below, Formula (A-2b-2) below, Formula (A-2c-1) below, Formula (A-2c-2) below, Formula (A-2c-3) below, Formula (A-2c-4) below, Formula (A-2d) below, Formula (A-2e) below, Formula (A-3a) below, or Formula (A-3b) below.

As described later, in the unit structure (A), the hydrogen atom of the NH group may be replaced with a substituent. 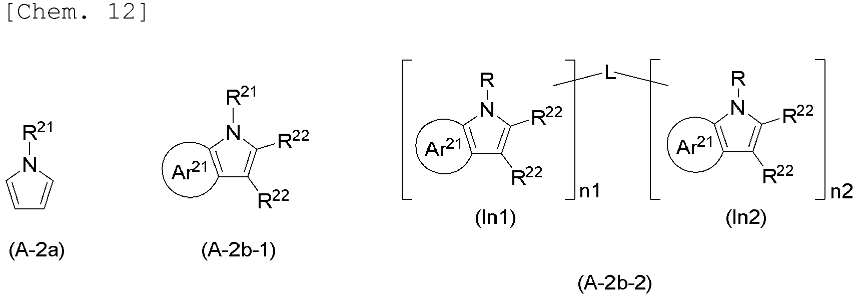 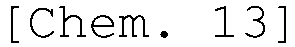 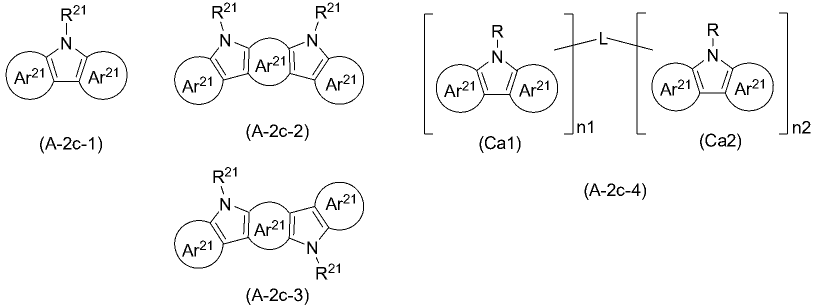 (In the formula, each Ar²¹ independently represents a residue of an aromatic ring.

Each R²¹ independently represents a hydrogen atom or a residue of an aromatic ring.

Each R²² independently represents a hydrogen atom, a hydrocarbon group having 1 to 5 carbon atoms, or a residue of an aromatic ring. Two adjacent R²²s may together form an unsaturated aliphatic ring. One of the unsaturated bonds in the unsaturated aliphatic ring refers to an unsaturated bond constituting a pyrrole ring.

Each R independently represents a hydrogen atom, a residue of an aromatic ring, or a bonding site to L. L represents a single bond or a linking group. n1 represents 1, and n2 represents 1 or 2. In Formulae (A-2b-2) and (A-2c-4), when L is a single bond, each of bonding between the partial structure (In1) and the partial structure (In2) and bonding between the partial structure (Ca1) and the partial structure (Ca2) is made by bonding two nitrogen atoms to each other, by bonding two Ar²¹ to each other, or by bonding a nitrogen atom to Ar²¹. In Formulae (A-2b-2) and (A-2c-4), when L is a linking group, L is bonded to N or Ar²¹.)

Examples of the aromatic ring in the residue of the aromatic rings of Ar²¹, R²¹, R²², and R include an aromatic ring represented by Formula (G2) below. These aromatic rings may have a substituent.

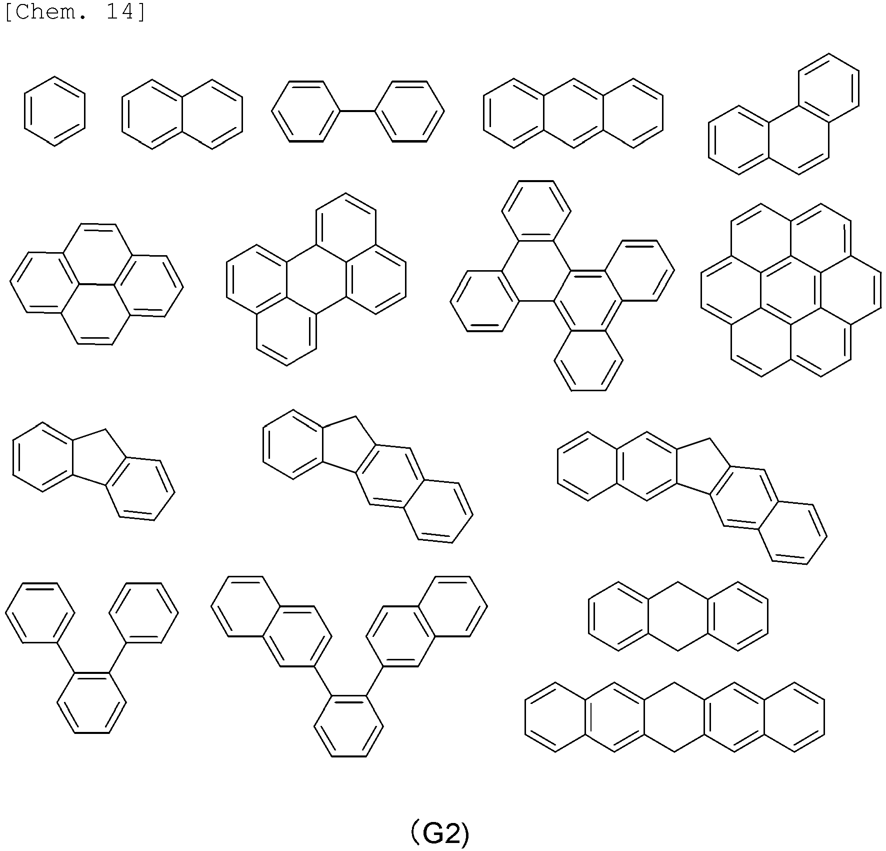

Examples of the unsaturated aliphatic ring formed by two adjacent R²²s together include the following rings. These aliphatic rings may have a substituent.

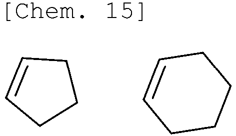

Examples of the linking group in L include a (n1 + n2)-valent saturated hydrocarbon group having 1 to 5 carbon atoms and a residue obtained by removing (n1 + n2) hydrogen atoms from an aromatic ring. 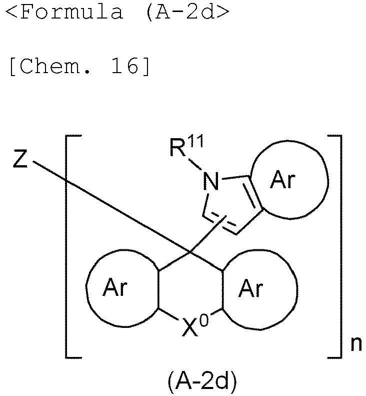 (In Formula (A-2d), each R¹¹ independently represents a hydrogen atom or an aromatic group, Ar represents an aromatic ring moiety, and each independently represents a benzene ring, a fused ring composed of 2 to 3 benzene rings, or a structure represented by Formula (Ar01) below, X⁰ represents a single bond, -O-, -S-, -NR¹²-, or -CR¹³R¹⁴-, R¹² is the same as or different from R¹¹ and is the same as the definition of R¹¹, and R¹³ and R¹⁴ each represent a hydrogen atom or a hydrocarbon group having 1 to 6 carbon atoms, n is 1 or 2, when n is 1, Z represents a monovalent organic group, and when n is 2, Z represents a divalent organic group.)

Note that in the unit structure (A), R¹¹ in Formula (A-2d) may be a substituent.

When R¹¹ is a substituent or an aromatic group, R¹¹ represents, for example: (i) a methylol group; (ii) an aryl group having 6 to 30 carbon atoms; or (iii) a linear, branched, or cyclic alkoxymethyl group having 2 to 20 carbon atoms, a linear, branched, or cyclic alkyl group having 1 to 20 carbon atoms, an alkenyl group having 2 to 10 carbon atoms, or an alkynyl group having 2 to 10 carbon atoms; provided that, in the cases of (ii) and (iii), the group may be further substituted with an oxygen atom-containing substituent, a sulfur atom-containing substituent, a nitrogen atom-containing substituent, an aryl group, or a halo group; or in the case of (iii), the hydrocarbon chain moiety may be further interrupted by an oxygen atom-containing substituent, a sulfur atom-containing substituent, a nitrogen atom-containing substituent, or an arylene group.

Examples of the skeleton represented by Formula (A-2d) include a skeleton represented by Formula (A-2d-1) below. 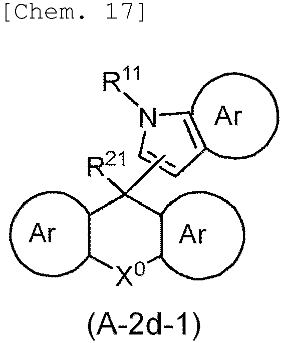 (In Formula (A-2d-1), R¹¹, Ar, and X⁰ have the same meanings as R¹¹, Ar, and X⁰ in Formula (A-2d), respectively. R²¹ is an aryl group having 6 to 30 carbon atoms, an alkenyl group having 2 to 10 carbon atoms, or an alkynyl group having 2 to 10 carbon atoms.)

Ar in Formulae (A-2d) and (A-2d-1) is, for example, a benzene ring or a naphthalene ring.

Ar in Formulae (A-2d) and (A-2d-1) may have a structure represented by Formula (Ar01) below. 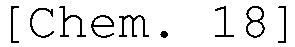 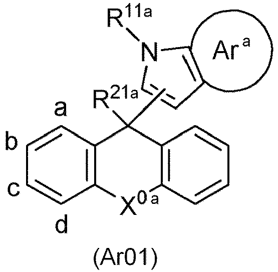 (where R^{11a} in Formula (Ar01) has the same meaning as R¹¹ in Formula (A-2d-1), R^{21a} has the same meaning as R²¹ in Formula (A-2d-1), Ar^{a} has the same meaning as Ar in Formula (A-2d-1), and X^{0a} has the same meaning as X⁰ in Formula (A-2d-1).

At the two carbon atoms a and b, b and c, or c and d in Formula (Ar01), a monocyclic moiety including X⁰ in Formula (A-2d) or (A-2d-1) forms a fused ring.)

Here, the monocyclic moiety containing X⁰ represents a monocyclic ring represented by Formula (AP011) below in Formula (A-2d).

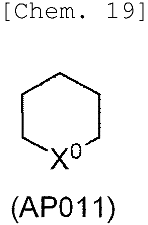

Preferable examples of the skeleton represented by Formula (A-2d) include a skeleton represented by Formula (A-2d-1) above, a skeleton represented by Formula (A-2d-2) below, and a skeleton represented by Formula (A-2d-3) below. 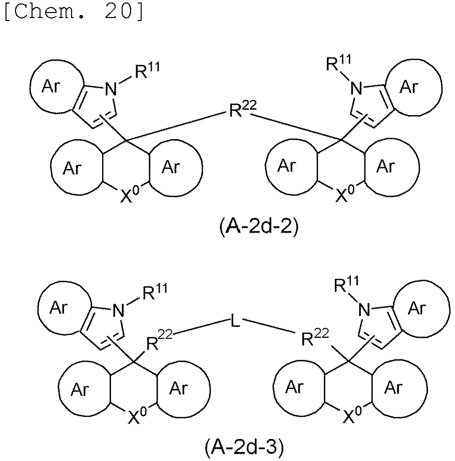 (In Formulae (A-2d-2) and (A-2d-3), R¹¹, Ar, and X⁰ have the same meanings as R¹¹, Ar, and X⁰ in Formula (A-2d), respectively.

L represents a single bond or a divalent linking group, and the divalent linking group represents, for example, - O-, -S-, -SO₂-, -CO-, -CONH-, -COO-, -NR¹⁰¹-, -(CR¹⁰²R¹⁰³)m¹-, -(Ar¹⁰¹)m²-, -CH₂-(Ar¹⁰¹)m²-CH₂-, or -(cyclo-R)-. R¹⁰¹, R¹⁰², and R¹⁰³ each independently represent a hydrogen atom, a hydrocarbon group having 1 to 5 carbon atoms, or an aryl group having 6 to 30 carbon atoms; and m¹ represents an integer of 1 to 10. Ar¹⁰¹ each independently represents an arylene group having 6 to 30 carbon atoms; and m² represents an integer of 1 to 3, which is the number of aromatic rings bonded to each other by a single bond. The term "cyclo-R" represents a divalent alicyclic hydrocarbon group having a 5 to 8 membered ring, preferably a 6 to 8 membered ring, which may form a fused ring with one or two benzene rings or naphthalene rings.

R²² each independently represents an optionally substituted arylene group having 6 to 30 carbon atoms, alkenylene group having 2 to 10 carbon atoms, or alkynylene group having 2 to 10 carbon atoms.) 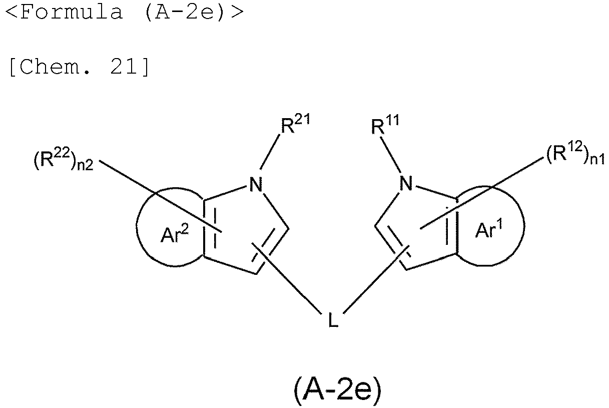 (In Formula (A-2e), L represents a single bond or a divalent linking group between any two carbon atoms constituting each azaaryl fused ring, R¹¹ and R²¹ each independently represent a hydrogen atom or a residue of an aromatic ring, R¹² and R²² each independently represent a substituent, n1 and n2 each independently represent the number of substituents of R¹² and R²² and may be 0, and Ar¹ and Ar² are each independently a benzene ring or a fused ring composed of 2 to 3 benzene rings that forms a fused ring with the pyrrole ring moiety in Formula (A-2e).)

Note that in the unit structure (A), R¹¹ and R²¹ in Formula (A-2e) may be a substituent.

When R¹¹ and R²¹ represent a substituent or a residue of an aromatic group, R¹¹ and R²¹ are, for example: (i) a methylol group; (ii) an aryl group having 6 to 30 carbon atoms; or (iii) a linear, branched, or cyclic alkoxymethyl group having 2 to 20 carbon atoms, a linear, branched, or cyclic alkyl group having 1 to 20 carbon atoms, an alkenyl group having 2 to 10 carbon atoms, or an alkynyl group having 2 to 10 carbon atoms; provided that, in the cases of (ii) and (iii), the group may be further substituted with an oxygen atom-containing substituent, a sulfur atom-containing substituent, a nitrogen atom-containing substituent, an aryl group, or a halo group; or in the case of (iii), the hydrocarbon chain moiety may be further interrupted by an oxygen atom-containing substituent, a sulfur atom-containing substituent, a nitrogen atom-containing substituent, or an arylene group.

In Formula (A-2e), L represents a single bond or a divalent linking group. L may be bonded to any carbon atom constituting each azaaryl fused ring, and may be bonded to Ar¹ or Ar², that is, an aromatic carbon atom constituting 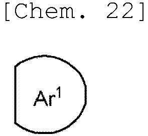 and 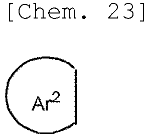 in the azaaryl fused ring, but is preferably bonded to a carbon atom constituting the pyrrole ring moiety in the azaaryl fused ring.

A preferable linking group (L) is selected from the group consisting of -O-, -S-, -SO₂-, -CO-, -CONH-, -COO-, - NH-, -(CR¹⁰²R¹⁰³)m¹-, -(Ar¹⁰¹)m²-, -CH₂-(Ar¹⁰¹)m²-CH₂-, and - (cyclo-R)-. R¹⁰² and R¹⁰³ each independently represent a hydrogen atom, a hydrocarbon group having 1 to 5 carbon atoms, or an aryl group having 6 to 30 carbon atoms; and m¹ represents an integer of 1 to 10. Ar¹⁰¹ represents an arylene group having 6 to 30 carbon atoms, m² represents an integer of 1 to 3, which is the number of aromatic rings bonded to each other by a single bond. The term "cyclo-R" represents a divalent alicyclic hydrocarbon group having a 5 to 8 membered ring, preferably a 6 to 8 membered ring, which may form a fused ring with one or two benzene rings or naphthalene rings. 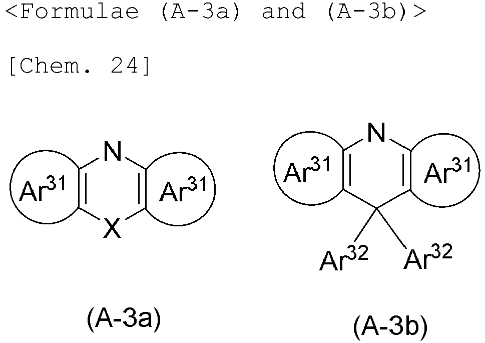 (In the formula, Ar³¹ and Ar³² each independently represent a residue of an aromatic ring, or represent a residue of an aromatic ring together with a carbon atom bonded thereto. X represents -O, -S-, -NH-, -CH₂-, -CH₂-CH₂-, or -CH=CH-.)

Examples of the aromatic ring in the residue of the aromatic ring of Ar³¹ and Ar³² include an aromatic ring represented by Formula (G1) described above.

Examples of the aromatic ring formed by Ar³¹ and Ar³² together with the carbon atom bonded thereto include a fluorene ring, a benzofluorene ring, and a dibenzofluorene ring.

Examples of the skeleton represented by Formula (A-2a) include the following skeletons. The aromatic ring in these skeletons may have a substituent, and the hydrogen atom of the NH group may be substituted with a substituent. The same applies to the following skeletons.

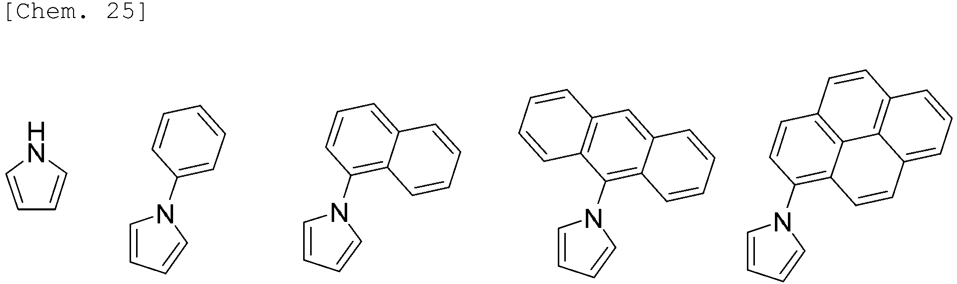

Examples of the skeleton represented by Formula (A-2b-1) include the following skeletons.

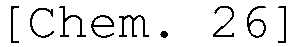

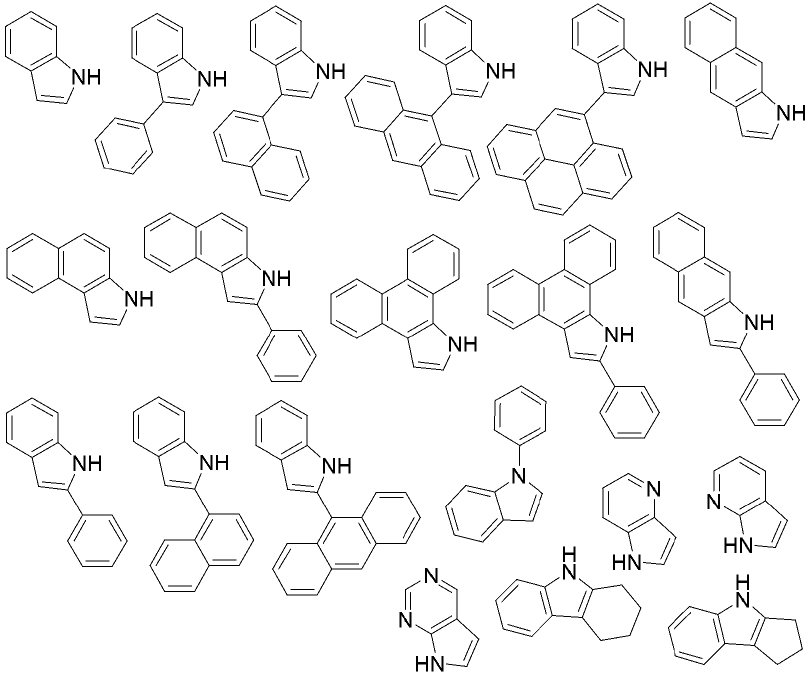

Examples of the skeleton represented by Formula (A-2b-2) include the following skeletons.

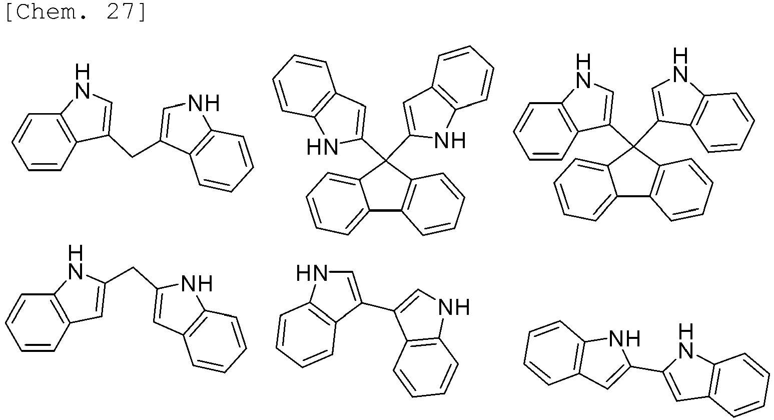

Examples of the skeleton represented by Formula (A-2c-1) include the following skeletons.

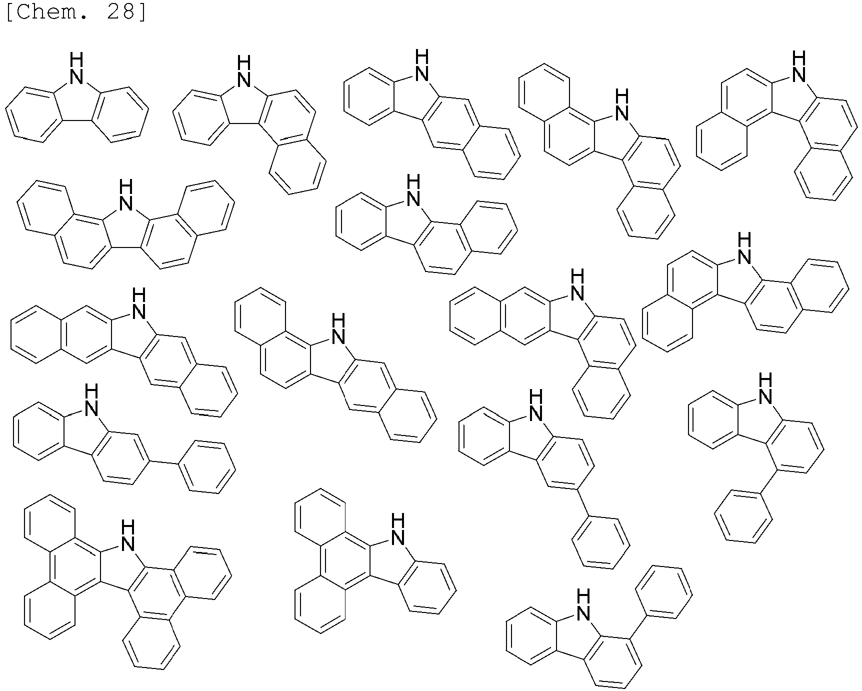

Examples of the skeleton represented by Formula (A-2c-2) or Formula (A-2c-3) include the following skeletons.

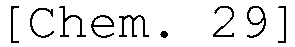

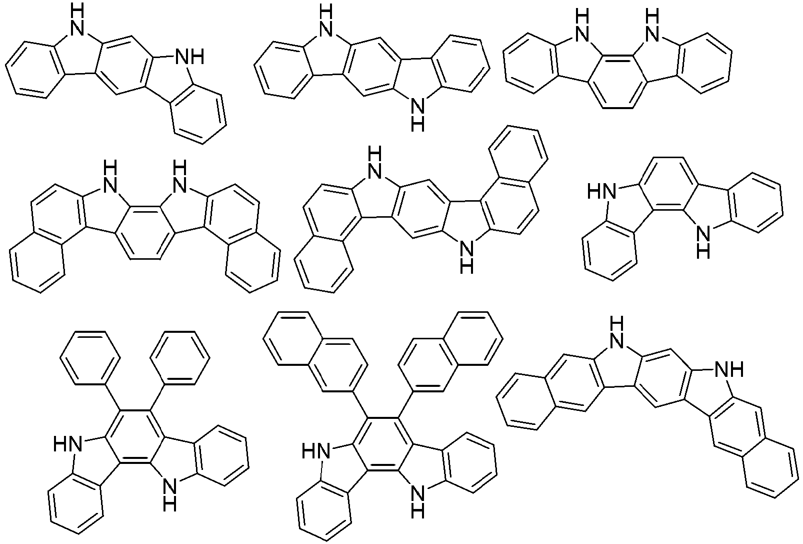

Examples of the skeleton represented by Formula (A-2c-4) include the following skeletons.

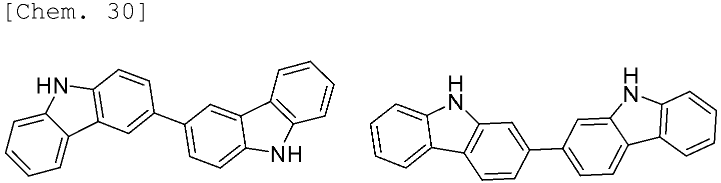

Examples of the skeleton represented by Formula (A-2d) include the following skeleton:

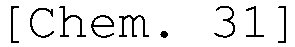

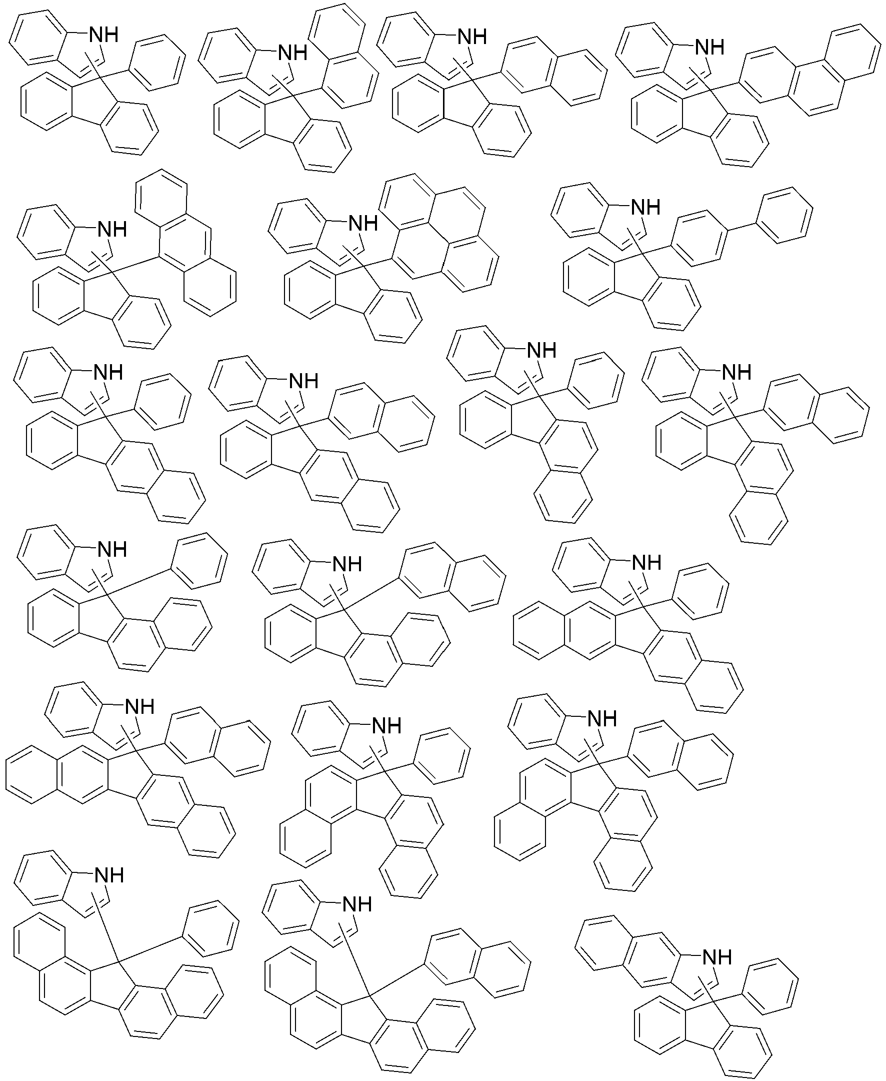

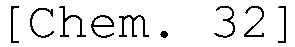

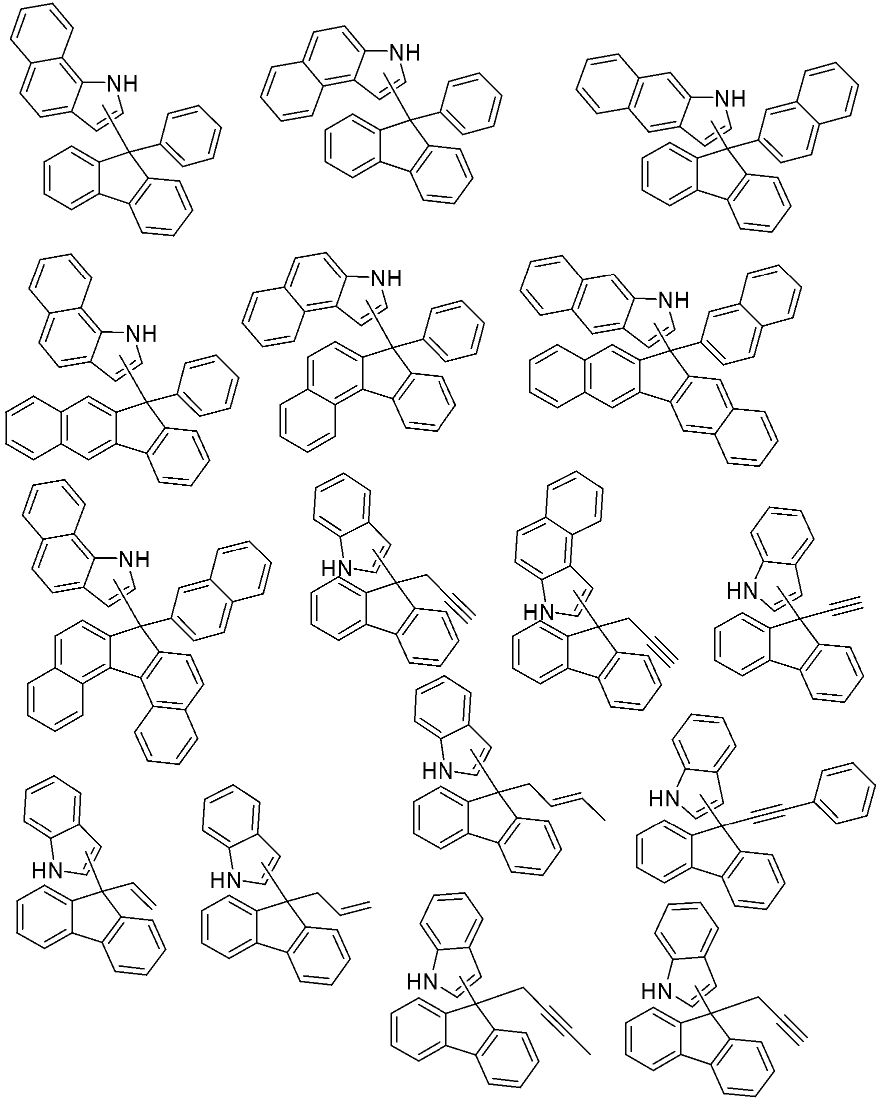

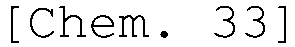

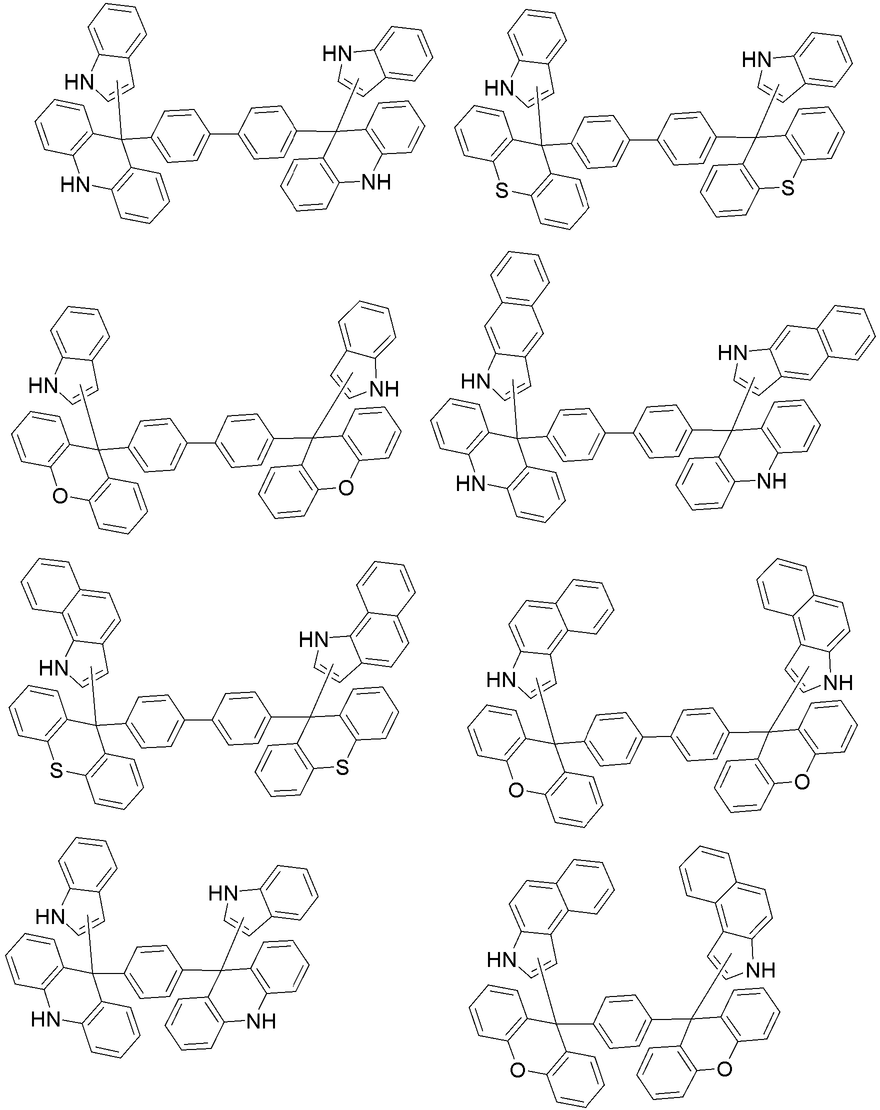

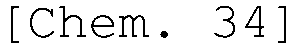

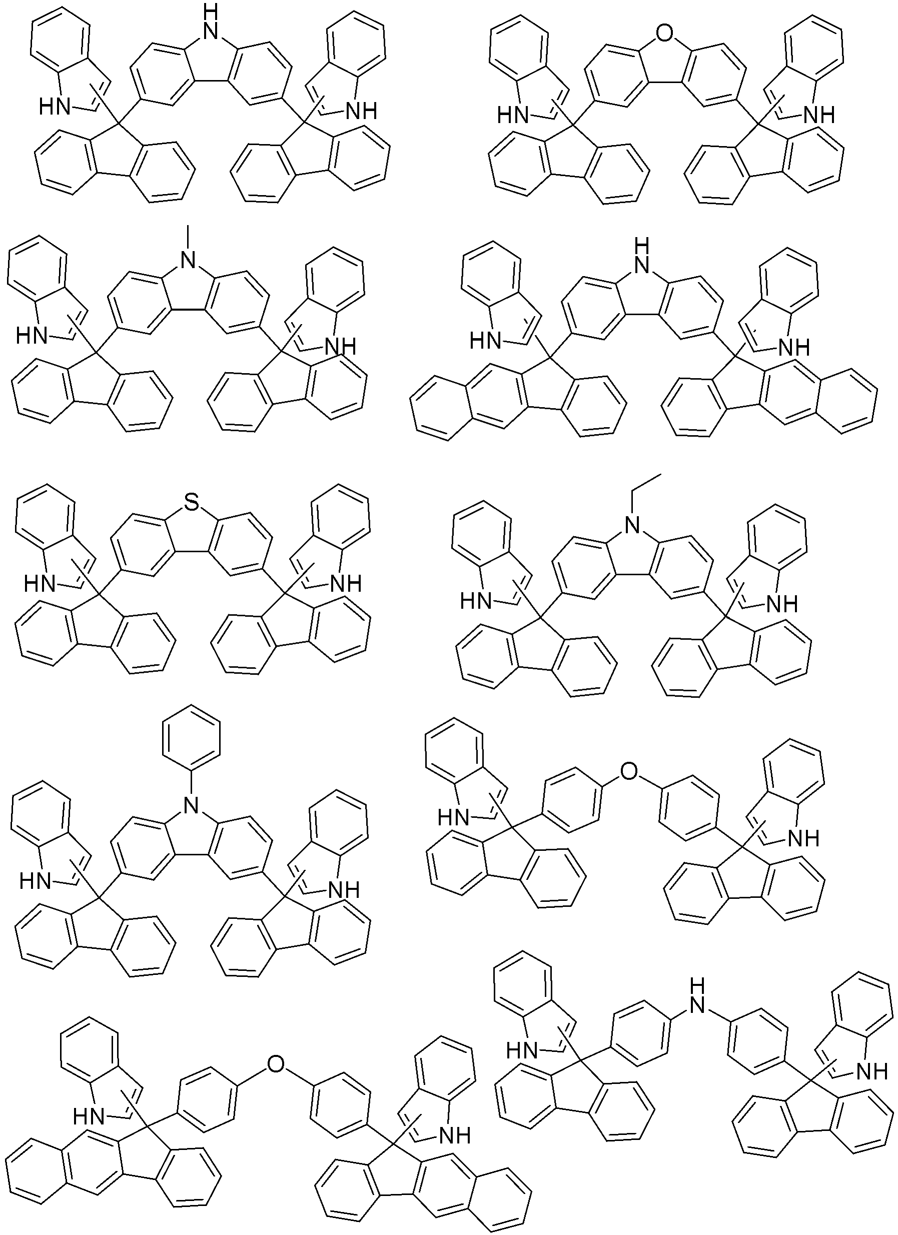

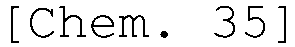

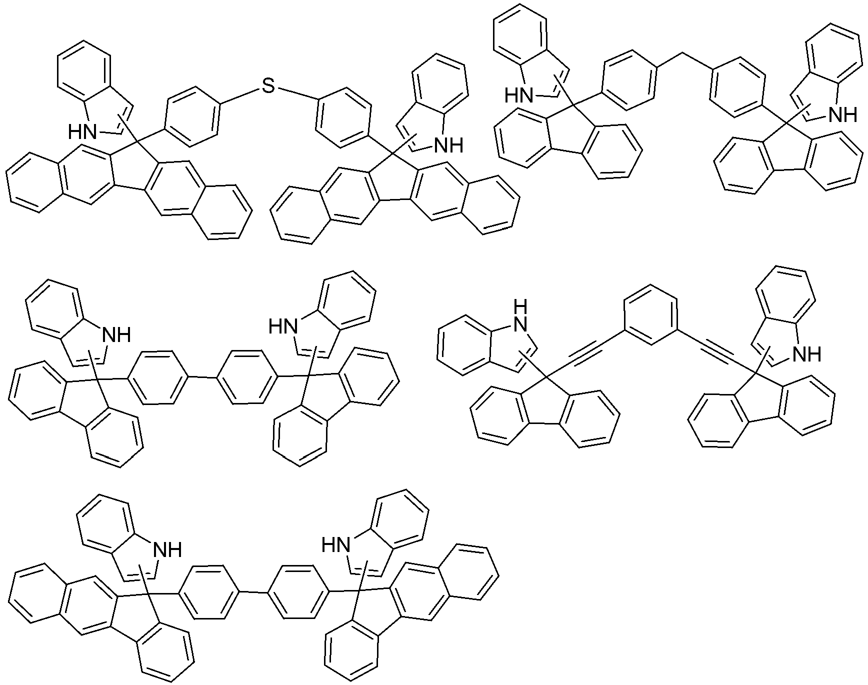

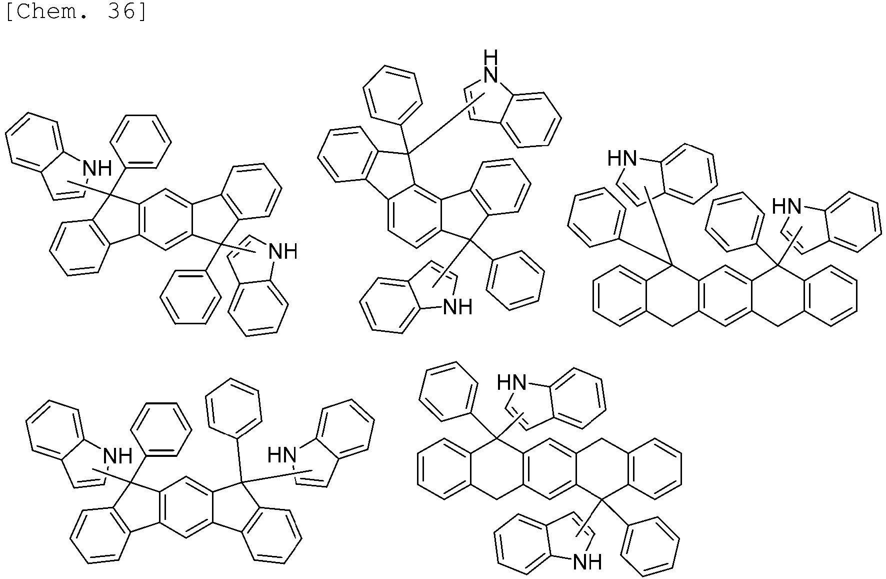

Examples of the skeleton represented by Formula (A-2e) include the following skeleton:
Note that specific examples of the skeleton represented by Formula (A-2d) and specific examples of the skeleton represented by Formula (A-2e) may overlap.

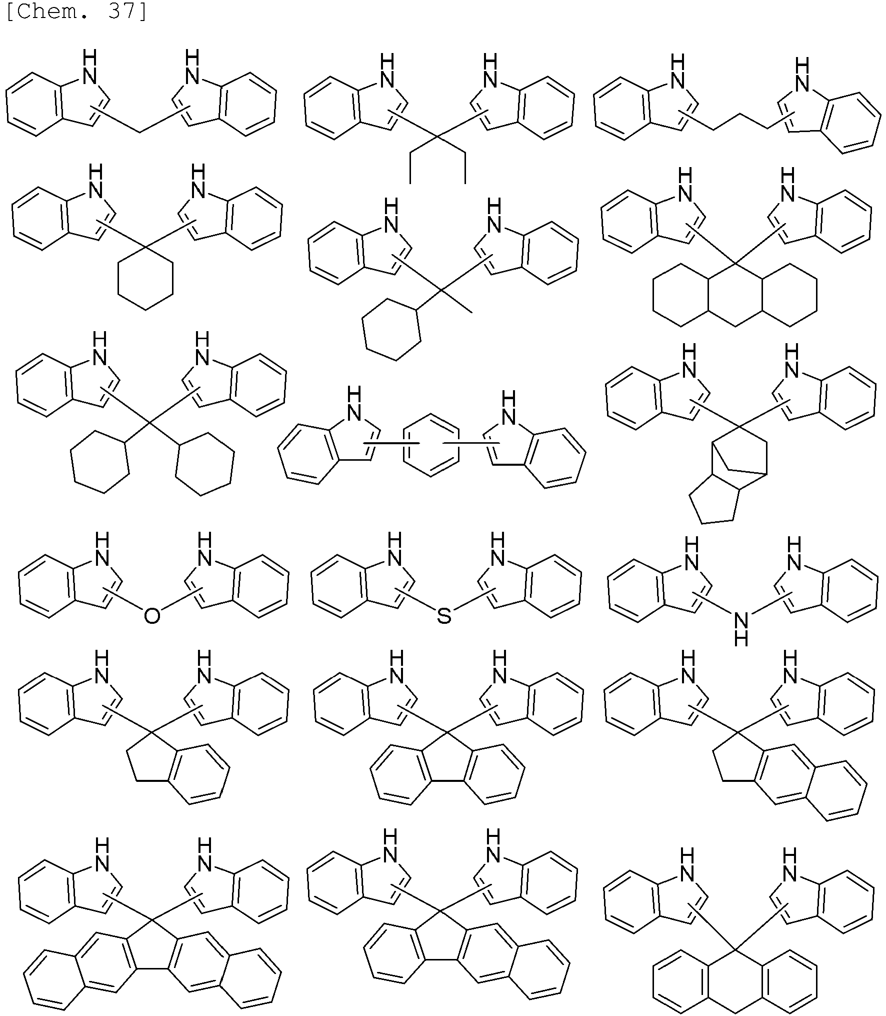

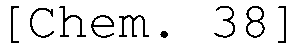

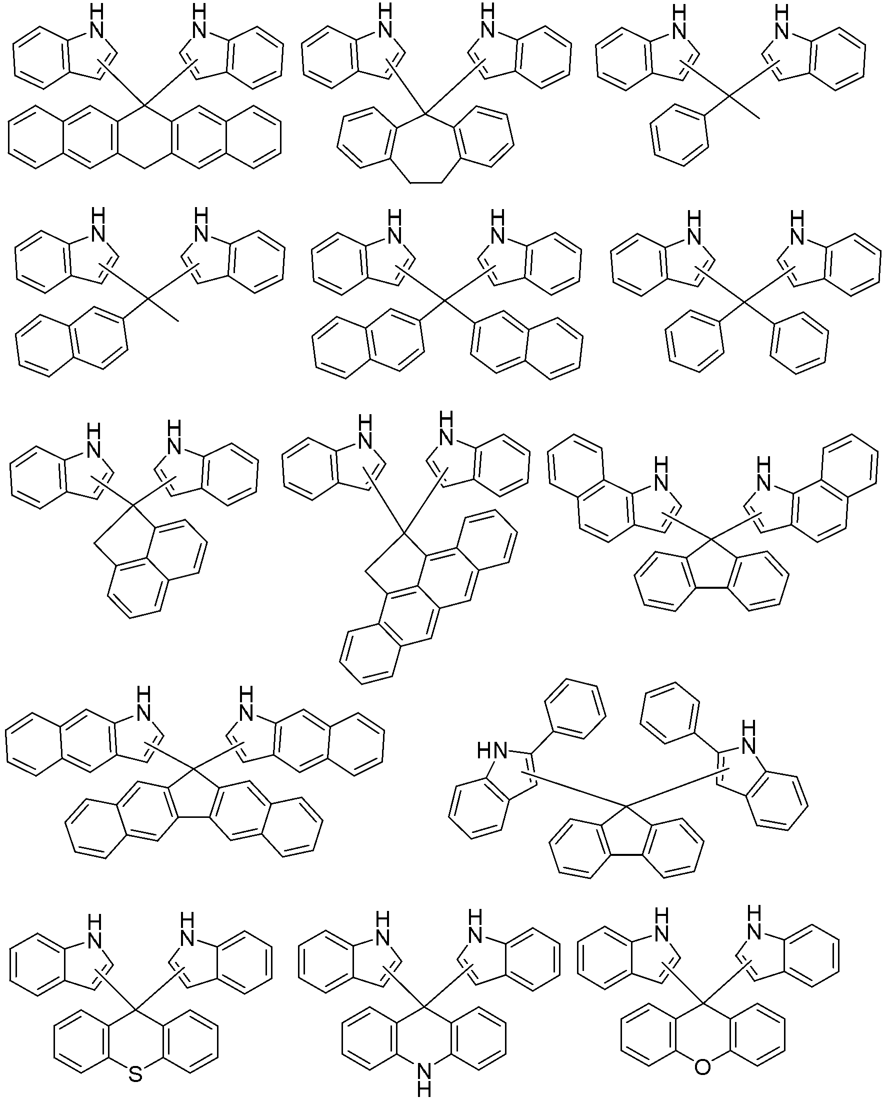

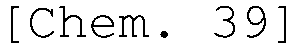

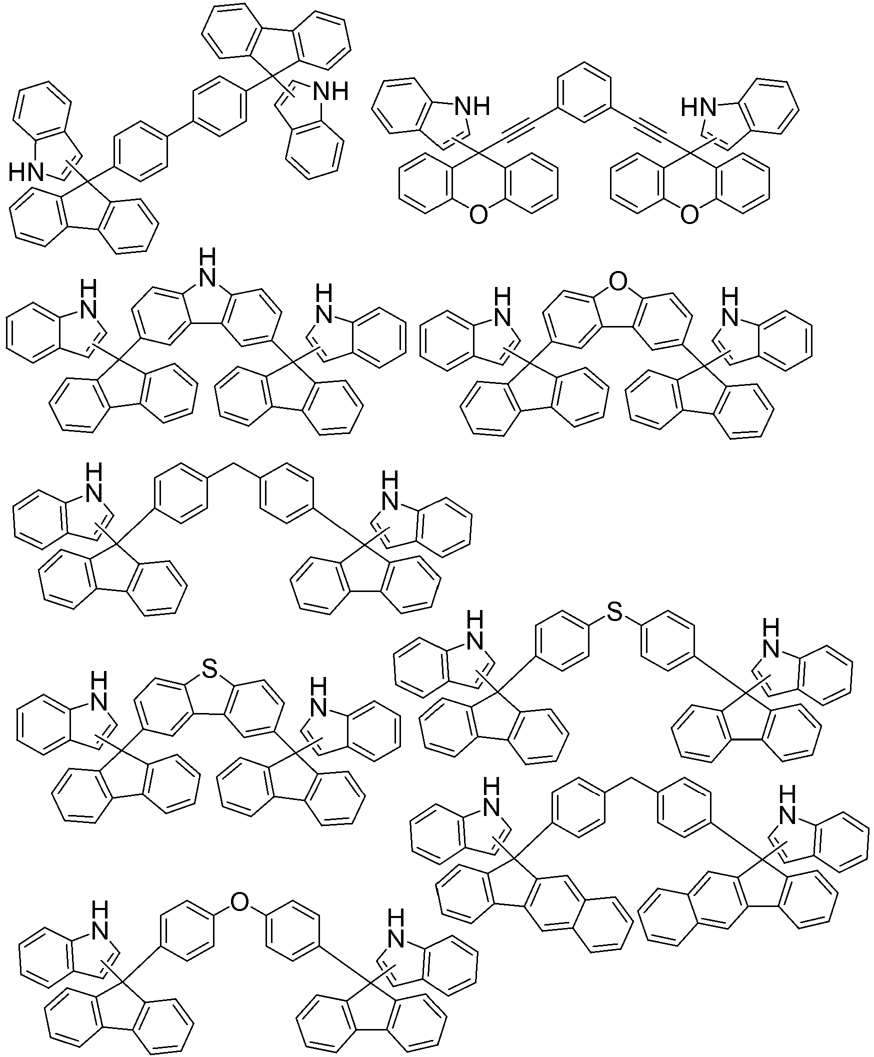

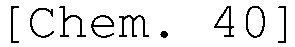

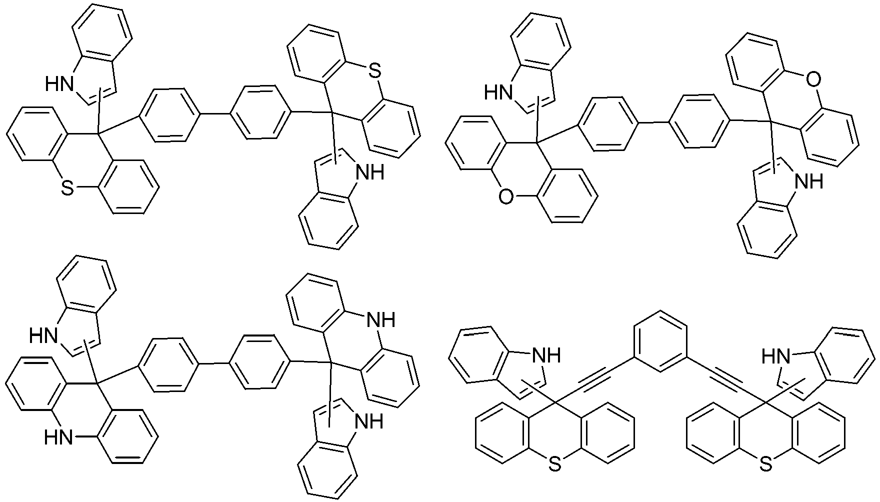

Examples of the skeleton represented by Formula (A-3a) include the following skeleton:

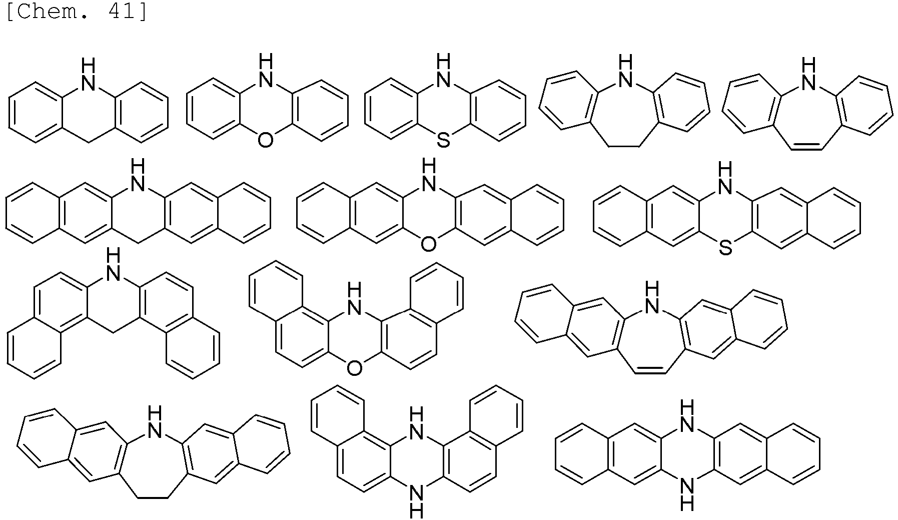

Examples of the skeleton represented by Formula (A-3b) include the following skeleton:

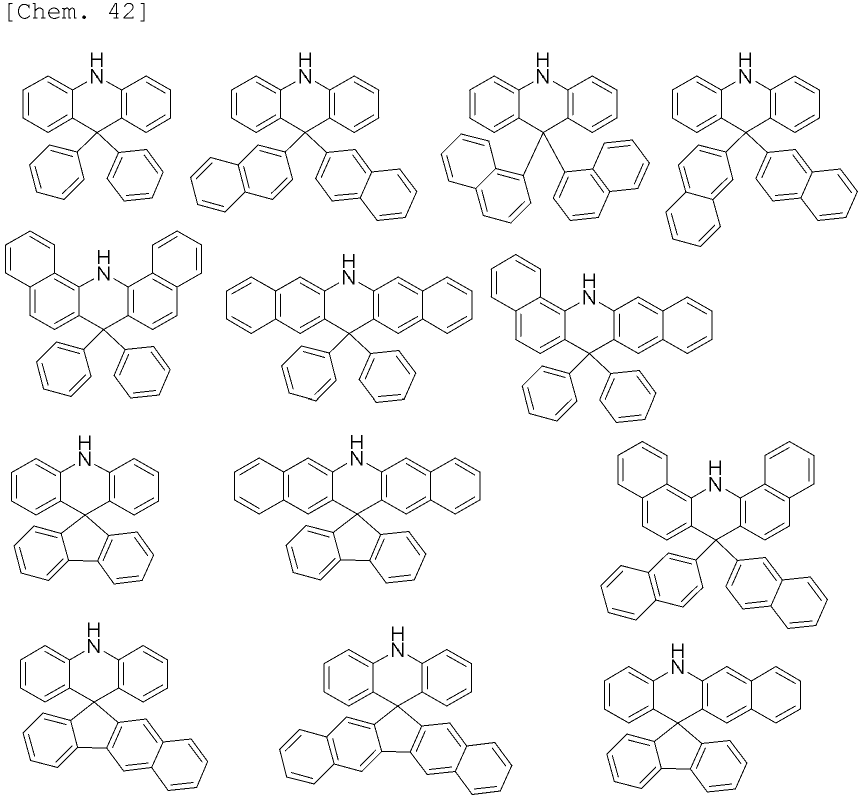

Examples of other skeletons of the nitrogen-containing aromatic heterocyclic ring skeleton include the following skeleton:

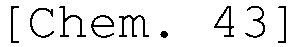

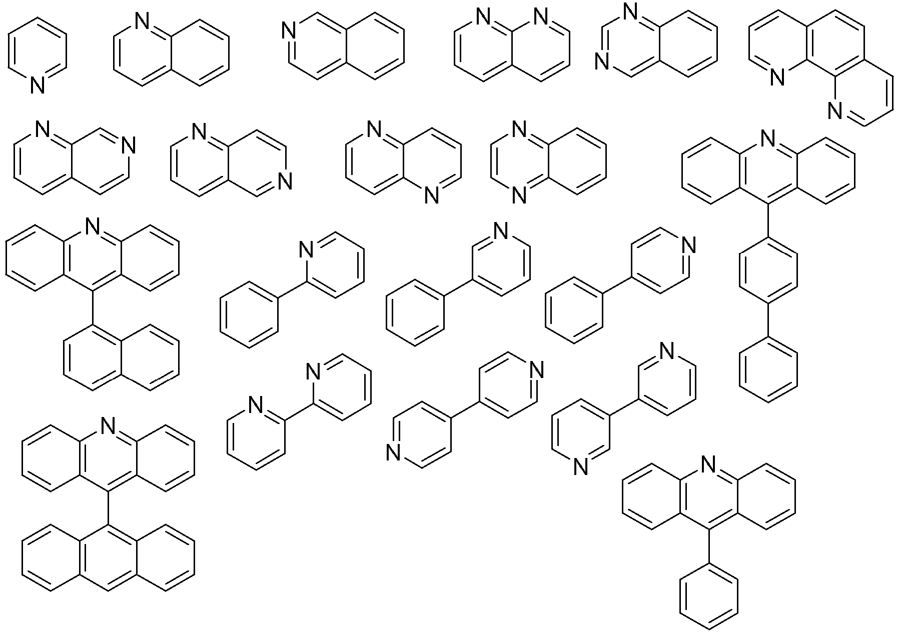

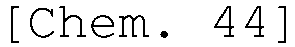

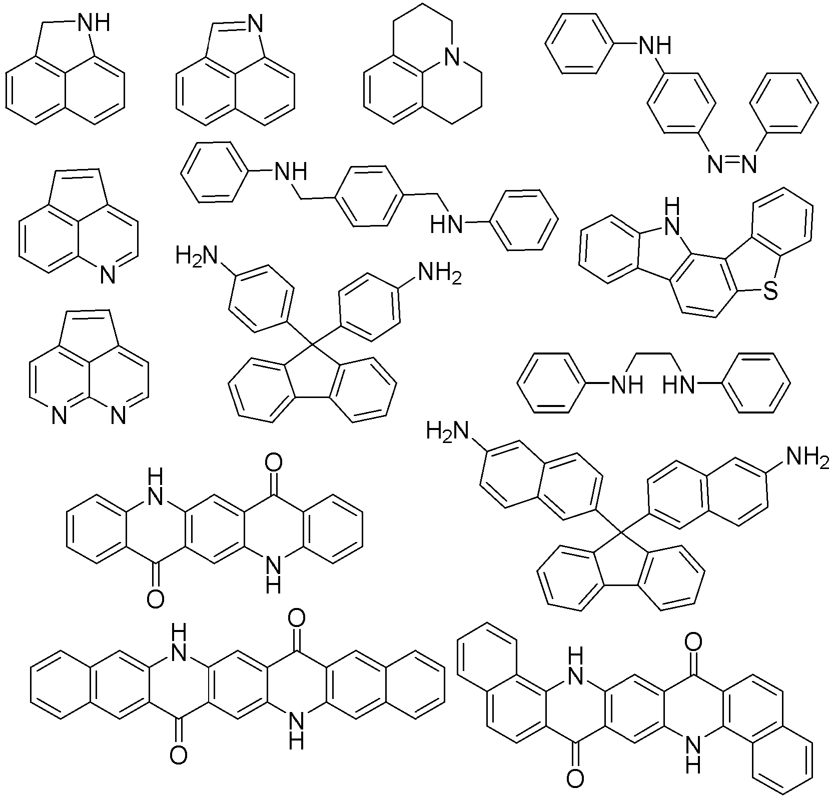

### <<<A-4-3: Phenolic skeleton>>>

The phenolic skeleton refers to a skeleton having an aromatic ring and a hydroxy group bonded to the aromatic ring.

The number of hydroxy groups bonded to the aromatic ring of the phenolic skeleton is not particularly limited, and may be one or more. In a case of plurality, the number may be 2 to 10 or 2 to 8. In a case of plurality, the hydroxy group may be bonded to the same aromatic ring (for example, a benzene ring) or to different aromatic rings.

In the unit structure (A), the hydrogen atom of the hydroxy group bonded to the aromatic ring may be replaced with a substituent. Examples of the substituent include the substituent described in (I-3) "Aromatic ring", the substituent described in (A-2) "Exemplary skeleton constituting unit structure (A)", and substituents (S) represented by Formulae (S1) to (S7) described later.

Examples of the phenolic skeleton include respective skeletons represented by Formula (A-4) shown below. The aromatic ring in these skeletons may have a substituent, and the hydrogen atom in the hydroxy group may be substituted with a substituent. The same applies to the following skeletons. 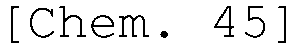 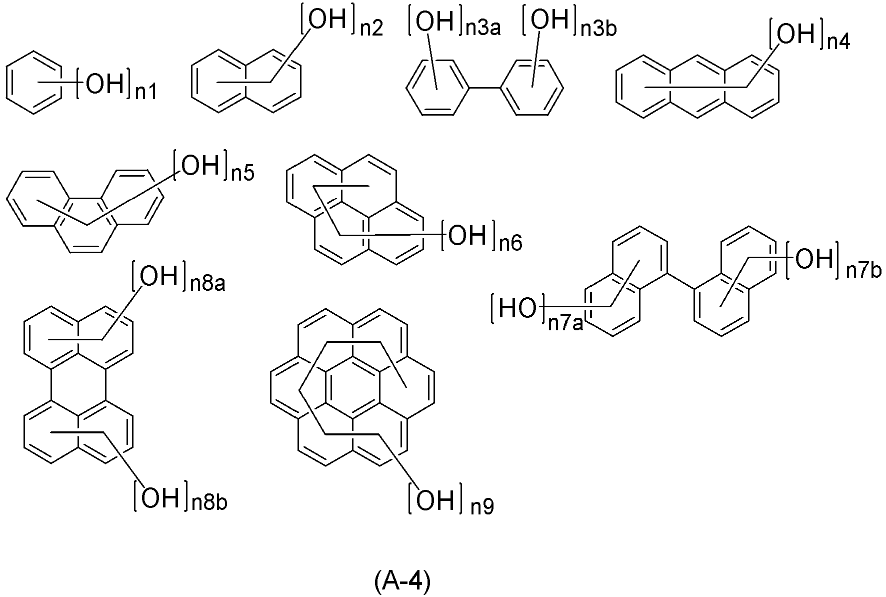 (wherein n1, n2, n4, n5, n6, and n9, each independently, represent an integer of 1 to 4, n3a, n3b, n7a, n7b, n8a, and n8b, each independently represent an integer of 0 to 4, with the proviso that the sum of n3a and n3b is 1 or more, the sum of n7a and n7b is 1 or more, and the sum of n8a and n8b is 1 or more.)

Examples of the phenolic skeleton include a skeleton represented by Formula (A-5a) below, Formula (A-5b) below, Formula (A-5c) below, or Formula (A-5d) below. 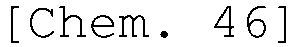 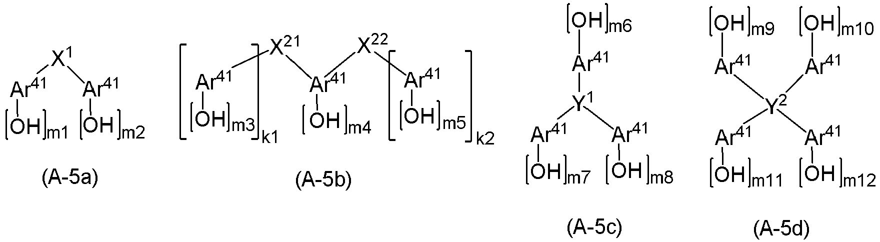
(wherein each Ar⁴¹ independently represents a residue of an aromatic ring,
k1 and k2 each independently represent an integer of 1 or 2.
X¹ represents -O-, -CO-, -S-, -SO₂-, or an alkylene group that may be substituted with a halogen atom.
When k1 is 1, X²¹ represents a single bond, -O-, -CO-, -S-, -SO₂-, or an alkylene group that may be substituted with a halogen atom.
When k2 is 1, X²² represents a single bond, -O-, -CO-, -S-, -SO₂-, or an alkylene group that may be substituted with a halogen atom.
When k1 is 2, X²¹ represents a trivalent saturated hydrocarbon group which may be substituted with a halogen atom.
When k2 is 2, X²² represents a trivalent saturated hydrocarbon group which may be substituted with a halogen atom.
Y¹ represents a trivalent saturated hydrocarbon group,
Y² represents a tetravalent saturated hydrocarbon group,
m1 and m2, each independently, represent an integer of 0 to 3, with the proviso that the sum of m1 and m2 is 1 or more,
m3 to m5, each independently, represent an integer of 0 to 3, with the proviso that the sum of m3 to m5 is 1 or more,
m6 to m8, each independently, represent an integer of 0 to 3, with the proviso that the sum of m6 to m8 is 1 or more,
m9 to m12, each independently, represent an integer of 0 to 3, with the proviso that the sum of m9 to m12 is 1 or more).

Examples of the aromatic ring in the residue of the aromatic ring of Ar⁴¹ include an aromatic ring represented by Formula (G3) below. These aromatic rings may have a substituent.

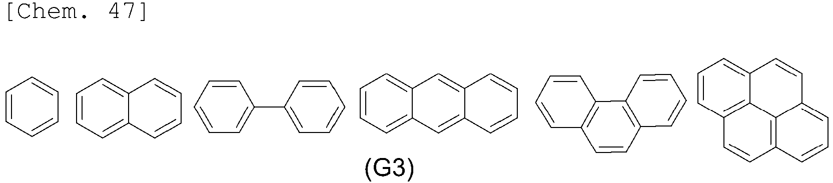

The number of carbon atoms of the alkylene group which may be substituted with a halogen atom in X¹ and X² is, for example, 1 to 20. Examples of the structure of the alkylene group include linear, branched, and cyclic structures, and combinations of two or more thereof. Examples of the halogen atom include a fluorine atom, a chlorine atom, a bromine atom, and an iodine atom.

The number of carbon atoms of the saturated hydrocarbon group in Y¹ and Y² is, for example, 1 to 20. Examples of the structure of the saturated hydrocarbon group include linear, branched, and cyclic structures, and combinations of two or more thereof.

Examples of the phenolic skeleton include a skeleton represented by Formula (A-6a), Formula (A-6b-1), Formula (A-6b-2), Formula (A-6c) or Formula (A-6d) shown below. 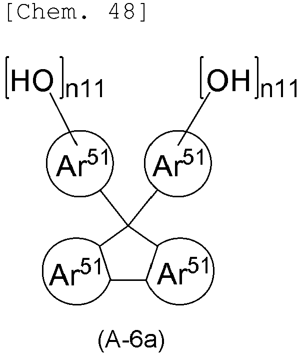 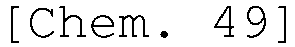 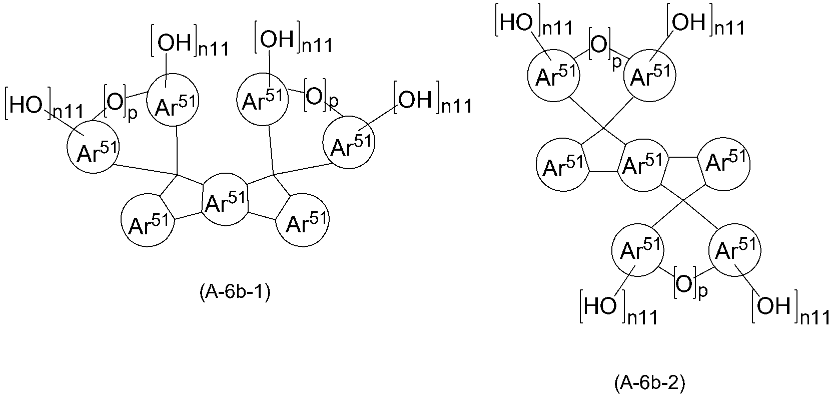 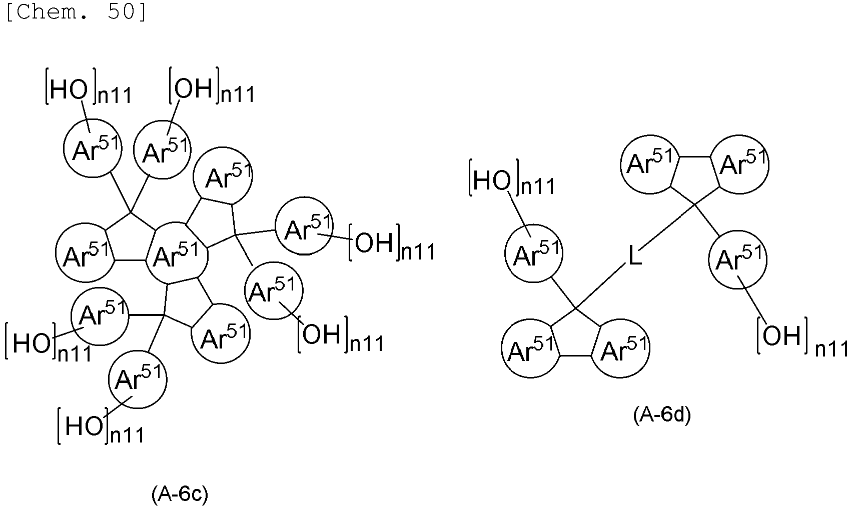 (In Formulae (A-6a), (A-6b-1), (A-6b-2), (A-6c), and (A-6d), Ar⁵¹, each independently, represents a residue of an aromatic ring, n11, each independently, represents an integer of 1 to 4, p, each independently, represents 0 or 1, When p is 1, an oxygen atom forms a cross-linked structure between aromatic rings as an ether bond, and when p is 0, there is no ether bond that forms a cross-linked structure between aromatic rings. L represents a single bond or a divalent linking group).

Examples of the aromatic ring in Ar⁵¹ include an aromatic ring represented by Formula (G1) above, and a benzene ring or a naphthalene ring is preferable.

Examples of L include a divalent group obtained by removing two hydrogen atoms from the following structure.

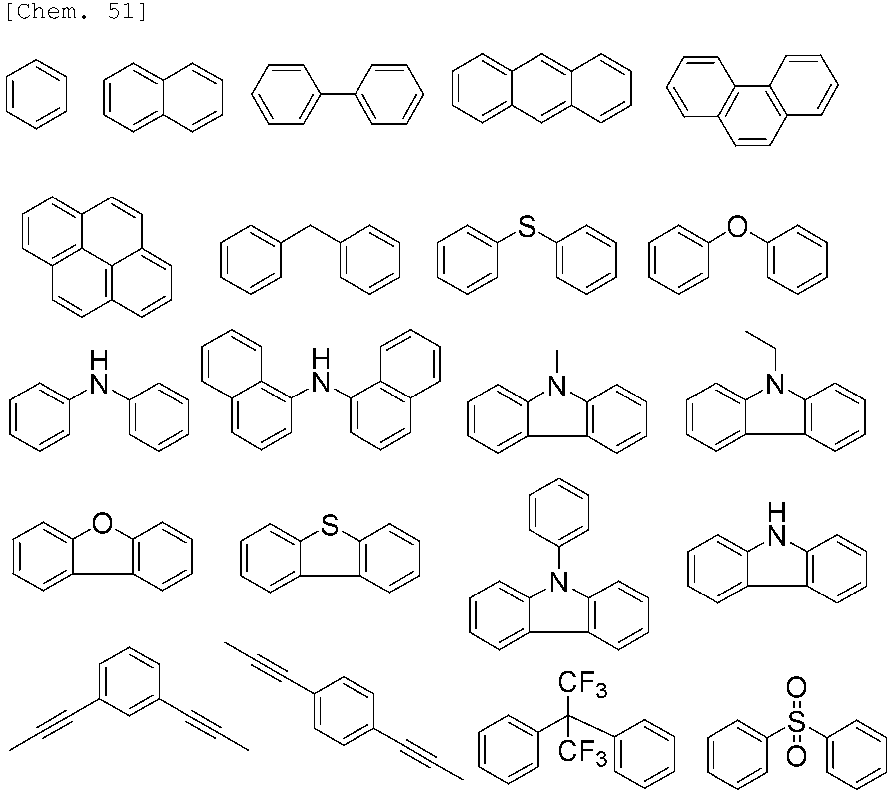

n11, for example, each independently, represents 1 or 2.

Examples of the phenolic skeleton include a skeleton represented by Formula (A-7a), Formula (A-7b), or Formula (A-7c) shown below. 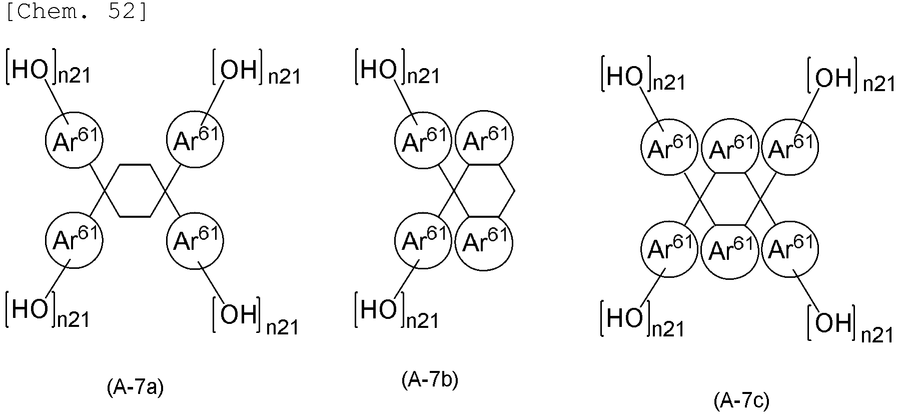 (In Formulae (A-7a), (A-7b), and (A-7c), each Ar⁶¹ independently represents a residue of an aromatic ring. n21, each independently, represents an integer of 1 to 4).

Examples of the aromatic ring in Ar⁶¹ include an aromatic ring represented by Formula (G1) above, and a benzene ring or a naphthalene ring is preferable.

n21, for example, each independently, represents 1 or 2.

Examples of the phenolic skeleton include a skeleton represented by Formula (A-8a-1), Formula (A-8a-2), Formula (A-8b), Formula (A-8c), Formula (A-8d), Formula (A-8e), Formula (A-8f), Formula (A-8g-1), or Formula (A-8g-2) shown below: 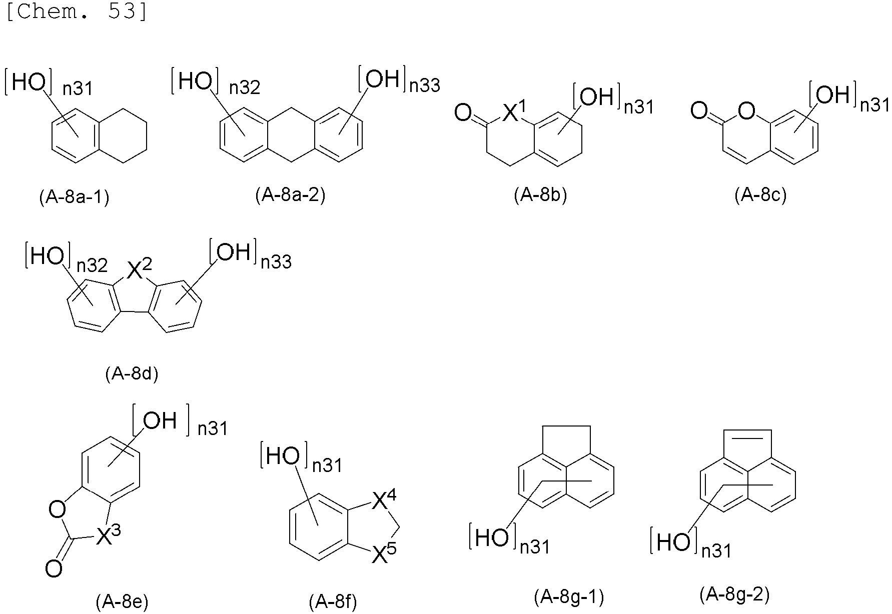 (In Formulae (A-8a-1), (A-8b), (A-8c), (A-8e), (A-8f), (A-8g-1), and (A-8g-2), n31, each independently, represents an integer of 1 to 4,
in Formula (A-8a-2), n32 and n33, each independently, represent an integer of 0 to 4, with the proviso that the sum of n32 and n33 is 1 or more,
in Formula (A-8d), n32 and n33, each independently, represent an integer of 0 to 4, with the proviso that the sum of n32 and n33 is 1 or more,
in Formula (A-8b), X¹ represents -O- or -NH-,
in Formula (A-8d), X² represents -O-, -S-, or -CH₂-,
in Formula (A-8e), X³ represents -S-, -CH₂- or -NH-,
in Formula (A-8f), X⁴ represents -CO- or -O-, and X⁵ represents -CH₂- or -O-).

n31, for example, each independently, represents 1 or 2.

n32 and n33, for example, each independently, represent 0, 1 or 2.

Examples of the skeleton represented by Formula (A-4) include the following skeletons: The aromatic ring in these skeletons may have a substituent, and the hydrogen atom in the hydroxy group may be substituted with a substituent. The same applies to the following skeletons.

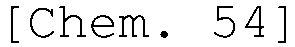

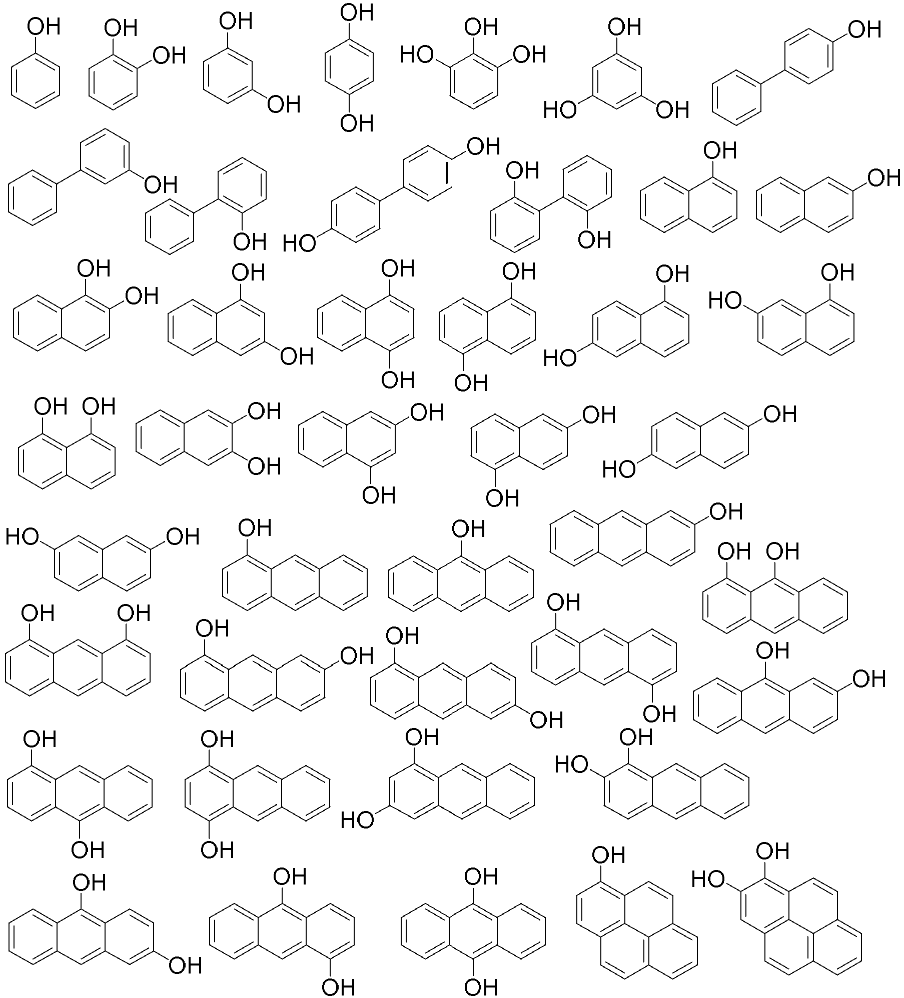

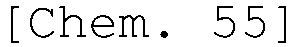

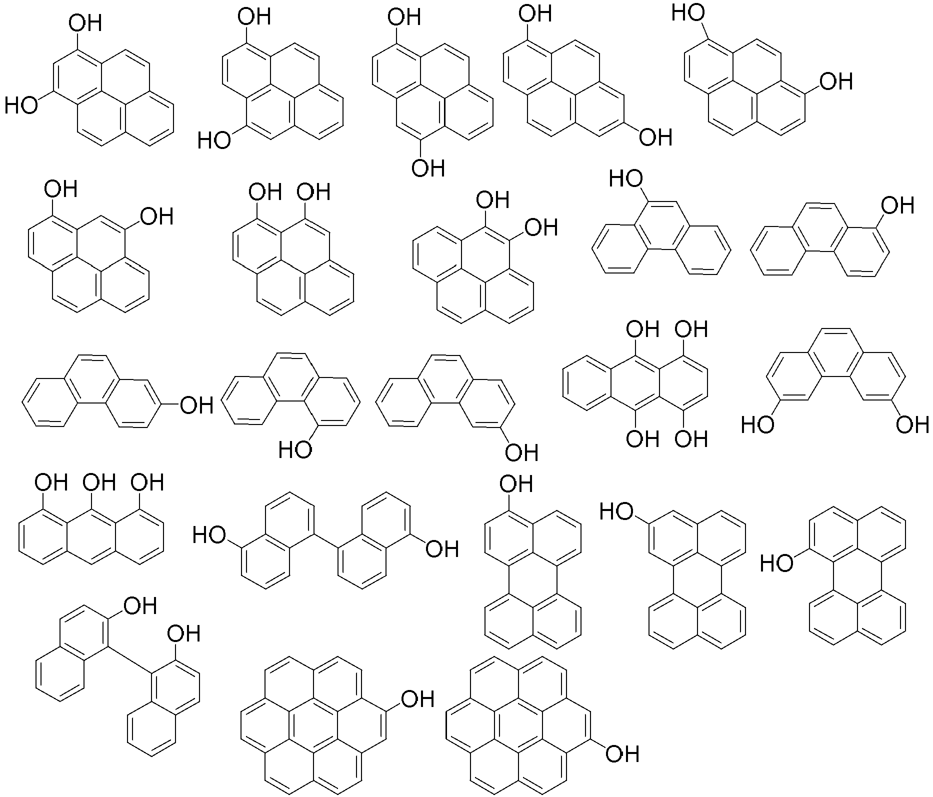

Examples of the skeleton represented by Formula (A-5a) include the following skeleton:

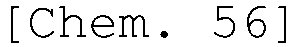

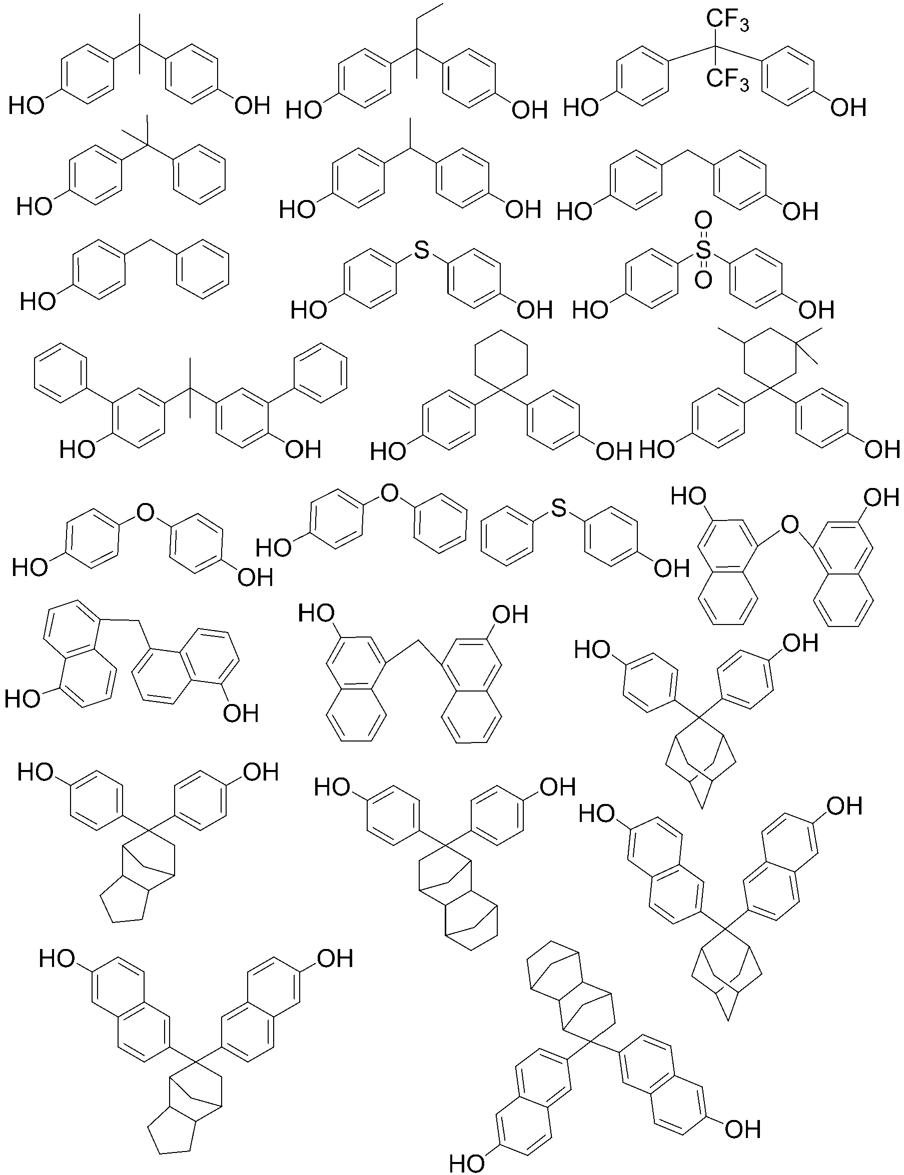

Examples of the skeleton represented by Formula (A-5b) include the following skeleton:

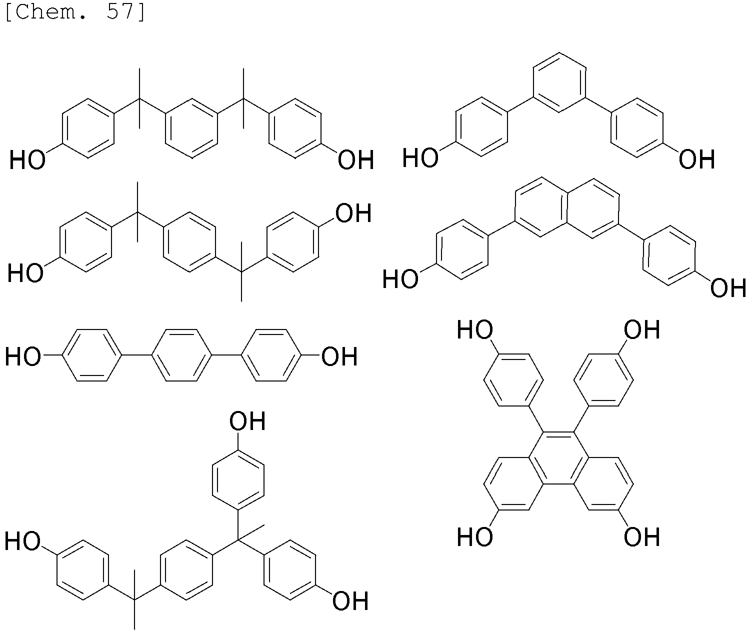

Examples of the skeleton represented by Formula (A-5c) include the following skeleton:

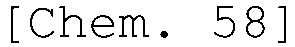

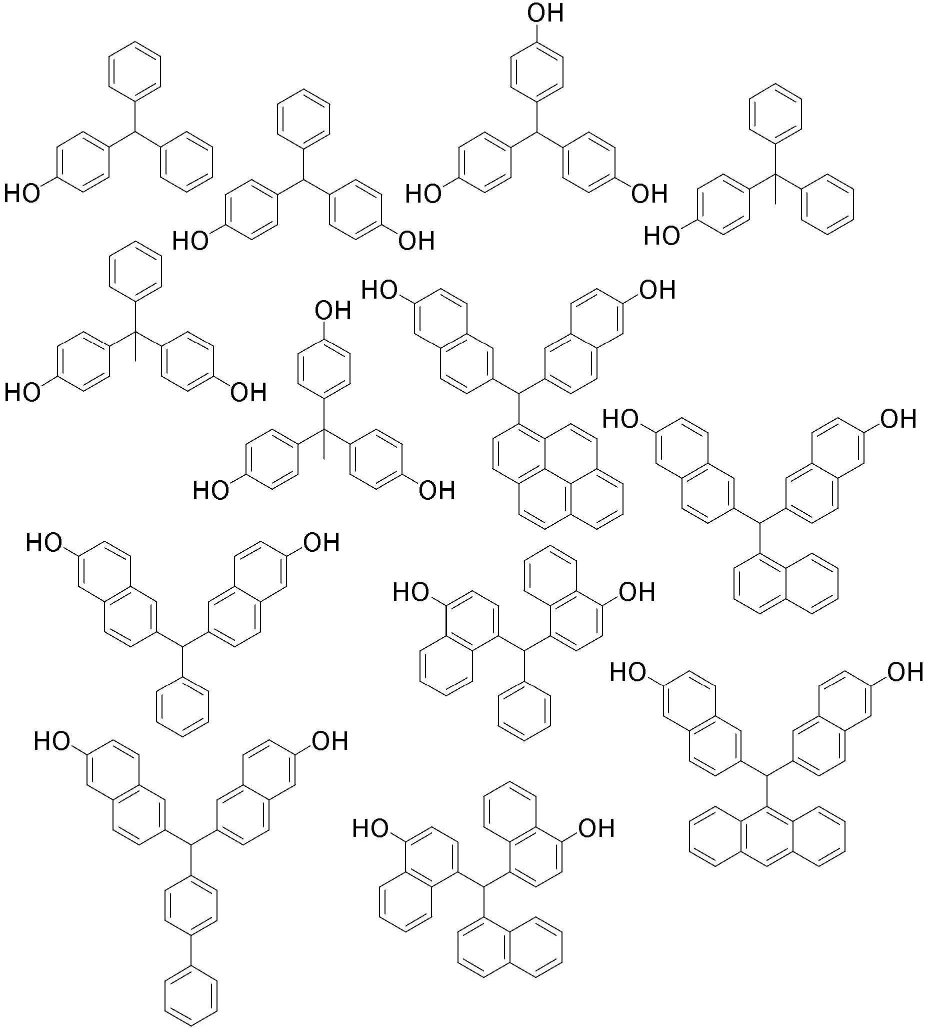

Examples of the skeleton represented by Formula (A-5d) include the following skeleton:

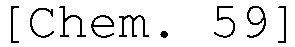

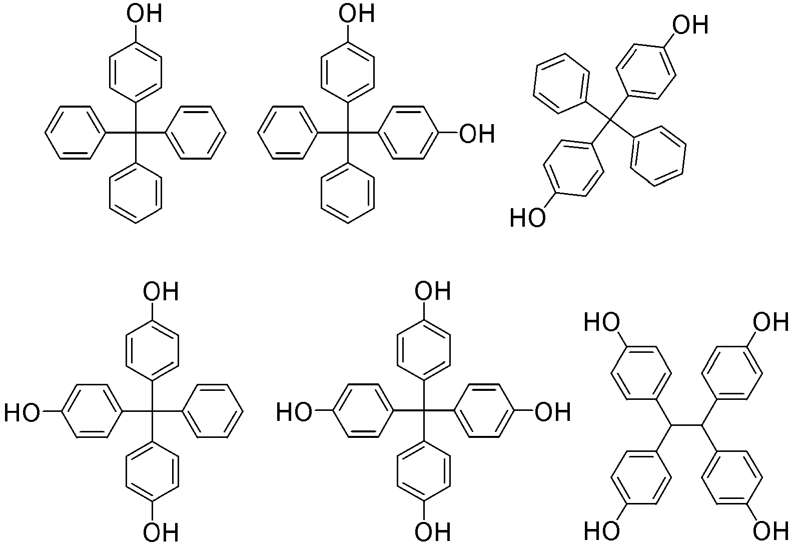

Examples of the skeleton represented by Formula (A-6a) include the following skeleton:

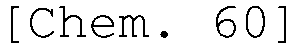

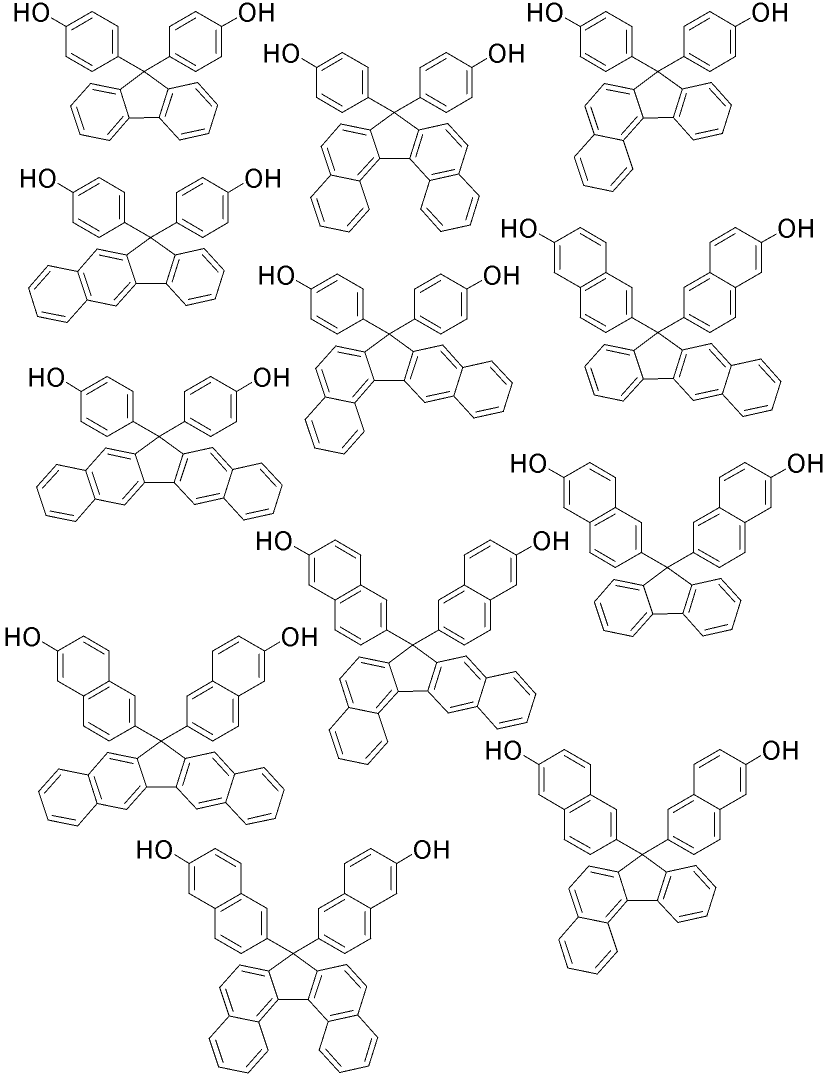

Examples of the skeleton represented by Formula (A-6b-1) or Formula (A-6b-2) include the following skeleton:

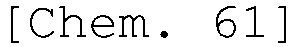

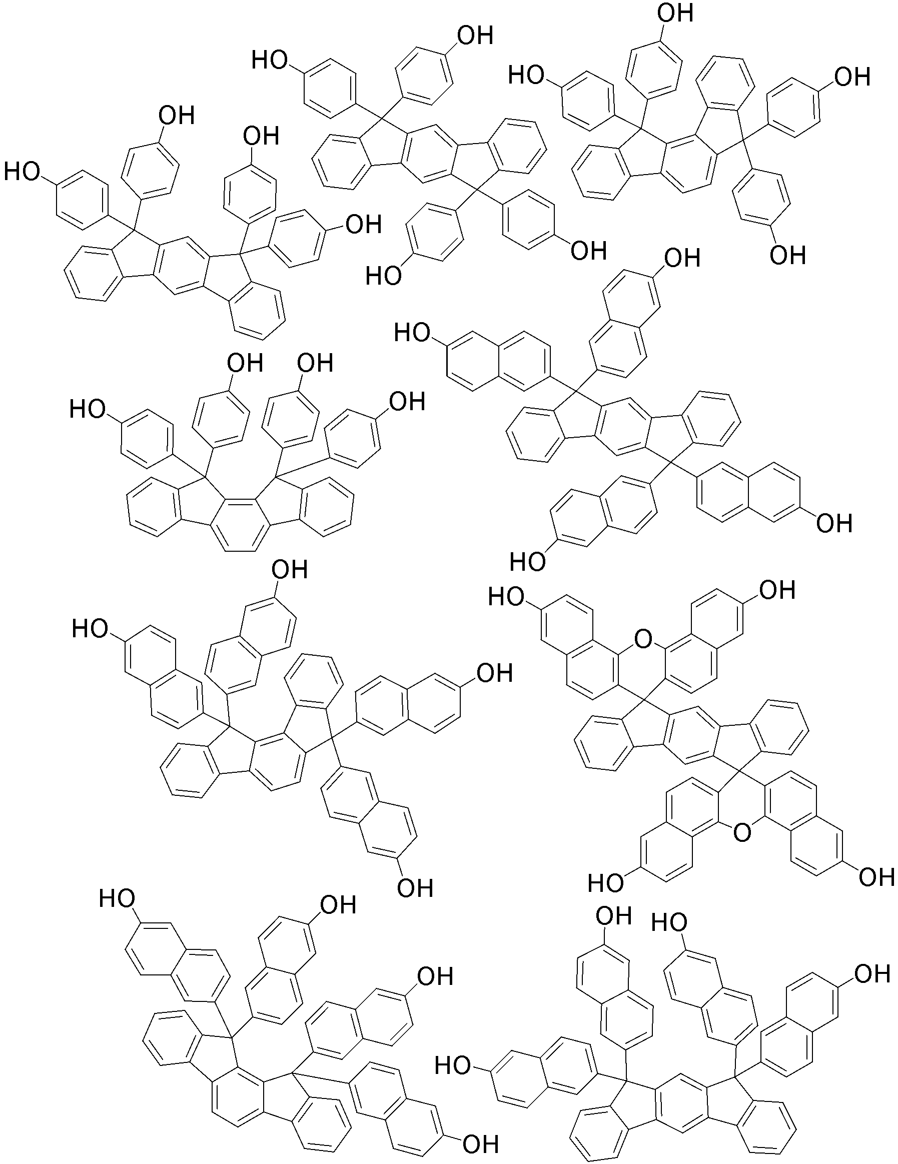

Examples of the skeleton represented by Formula (A-6c) include the following skeleton:

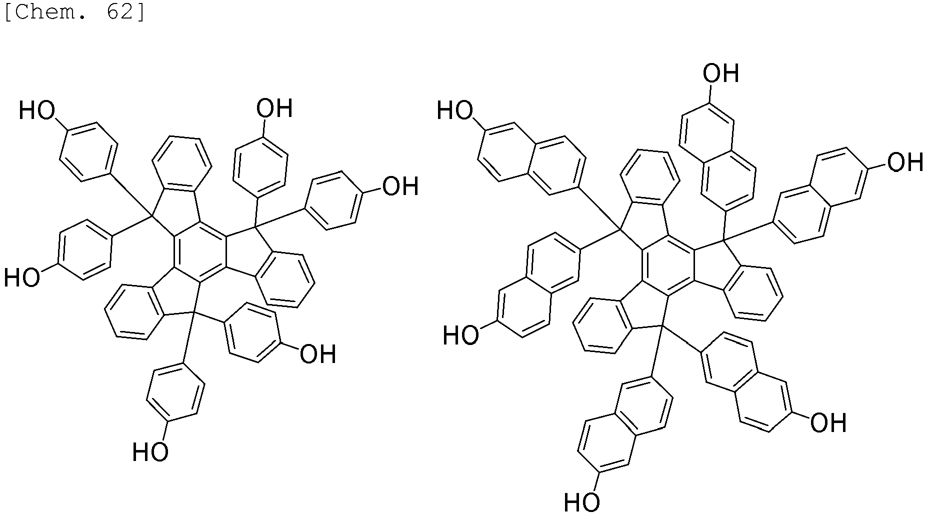

Examples of the skeleton represented by Formula (A-6d) include the following skeletons:

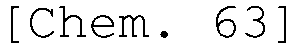

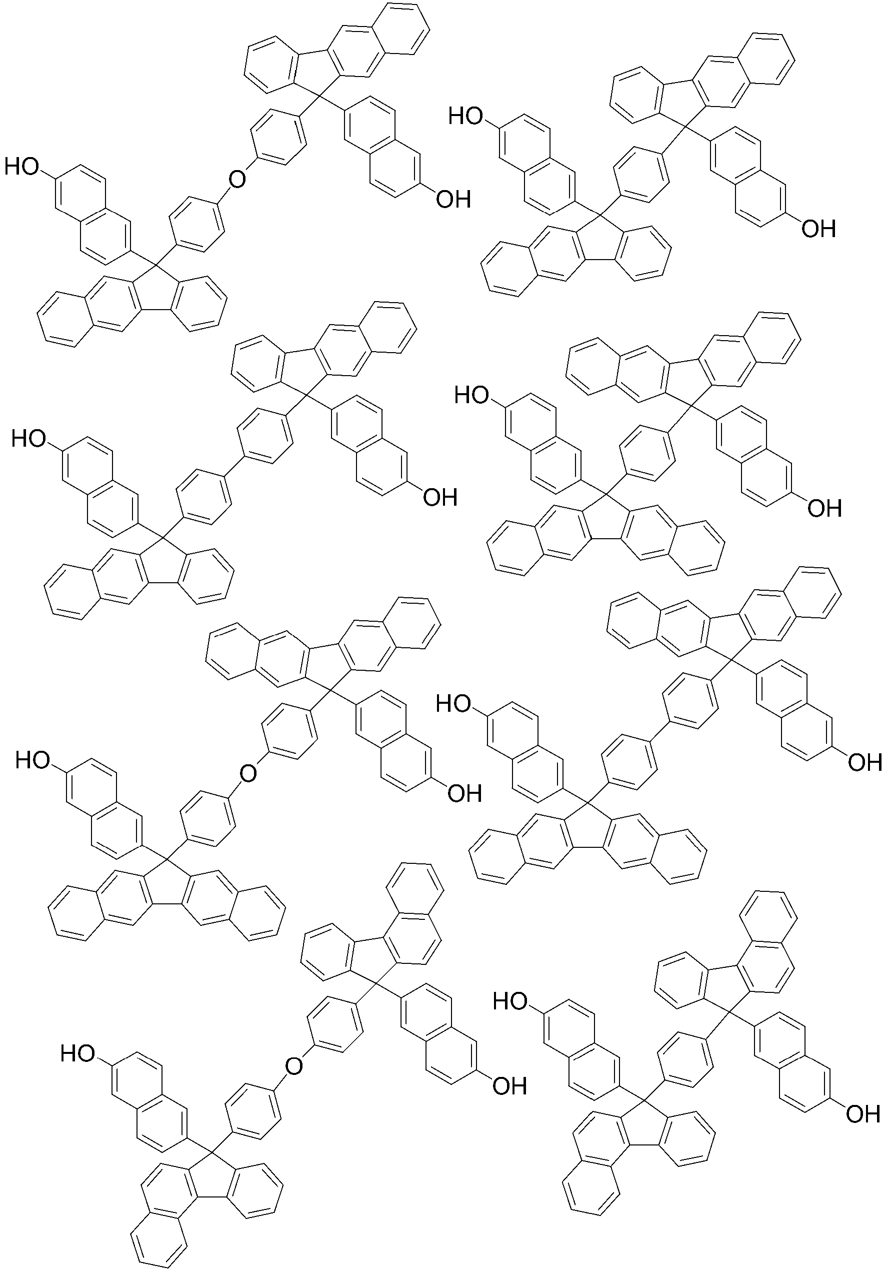

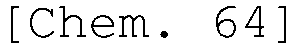

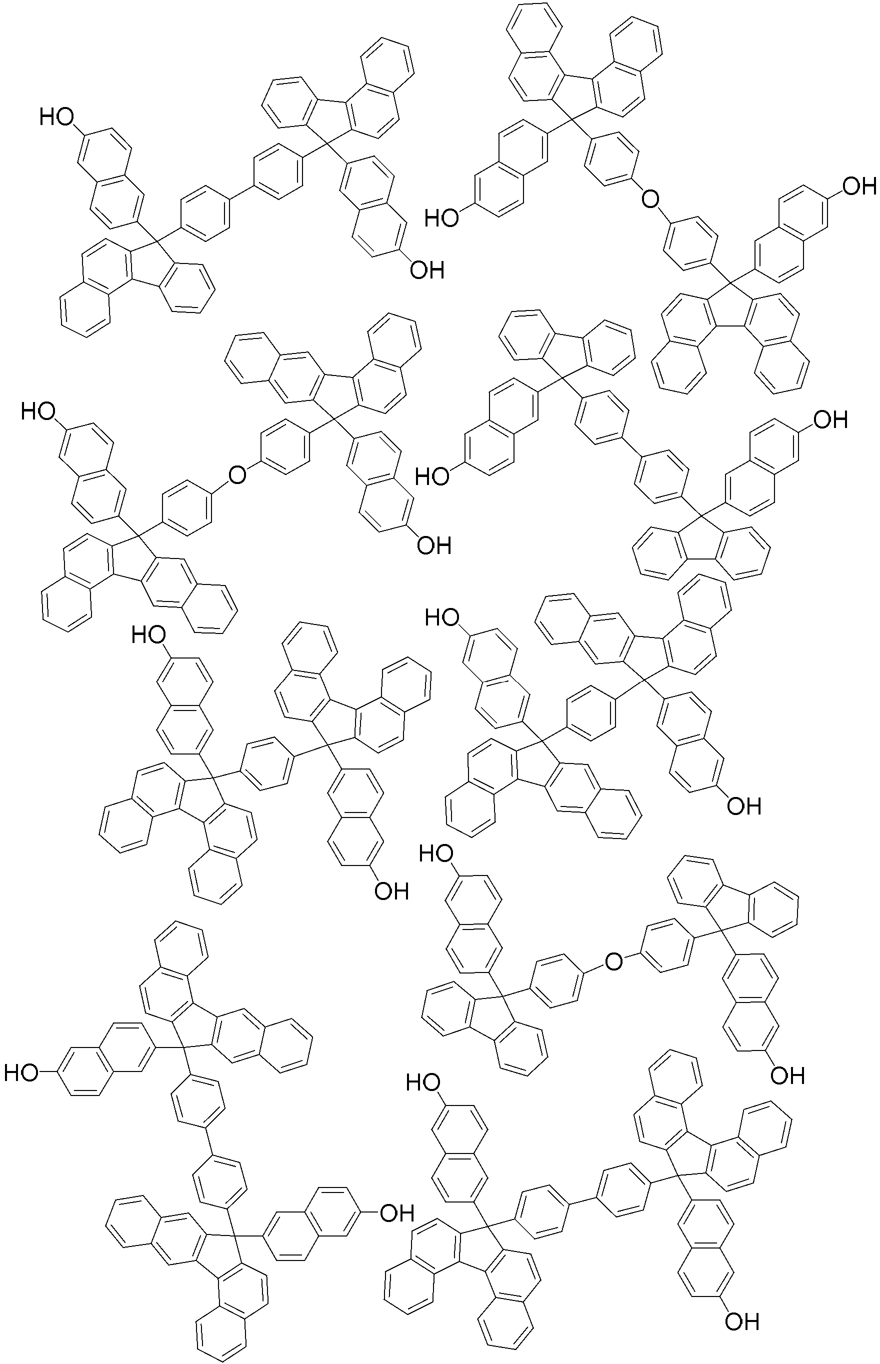

Examples of the skeleton represented by Formula (A-7a), Formula (A-7b), or Formula (A-7c) include the following skeleton:

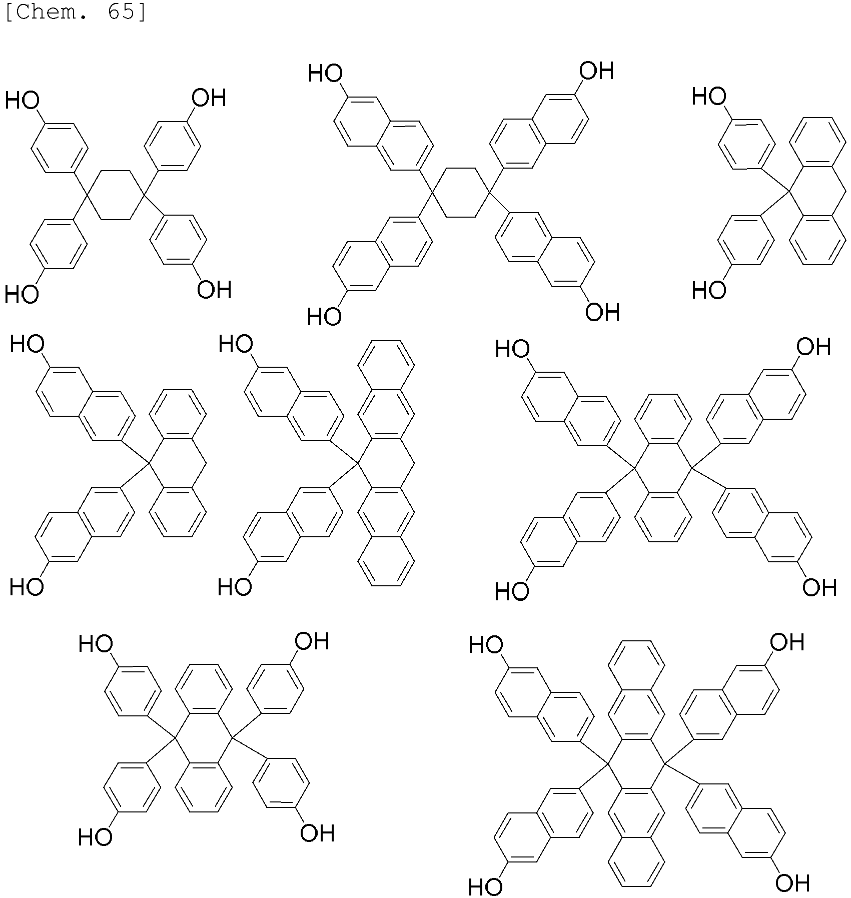

Examples of the skeleton represented by Formula (A-8a-1), or Formula (A-8a-2) include the following skeleton:

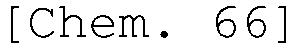

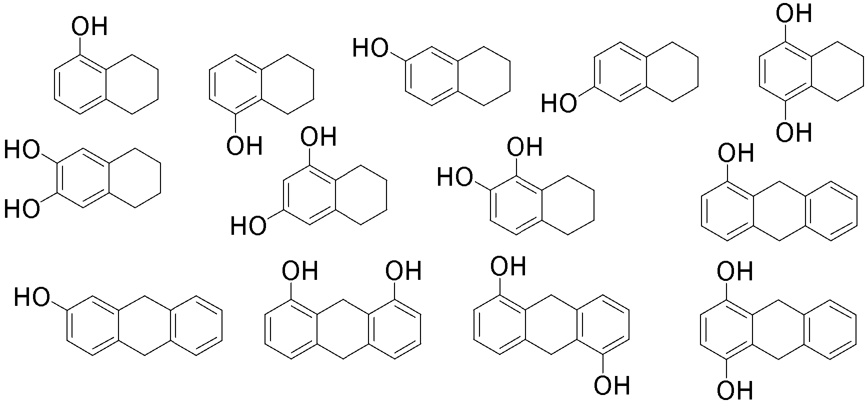

Examples of the skeleton represented by Formula (A-8b) include the following skeleton:

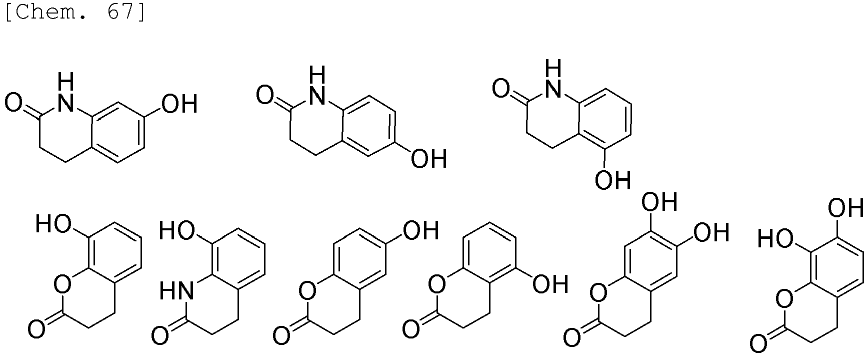

Examples of the skeleton represented by Formula (A-8c) include the following skeleton:

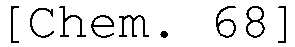

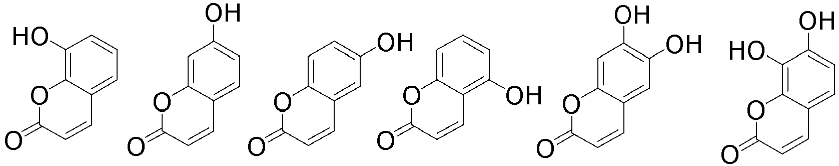

Examples of the skeleton represented by Formula (A-8d) include the following skeleton:

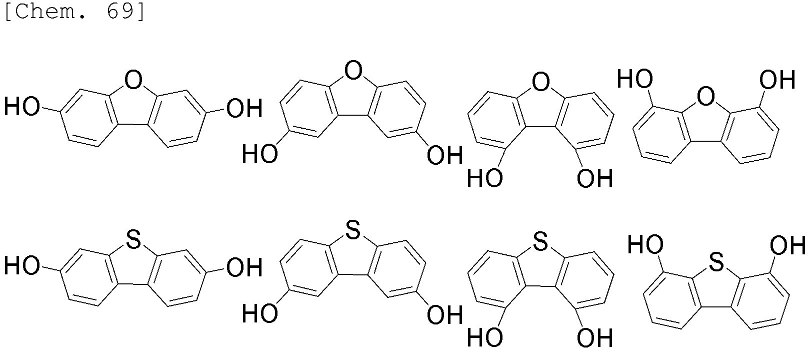

Examples of the skeleton represented by Formula (A-8e) include the following skeleton:

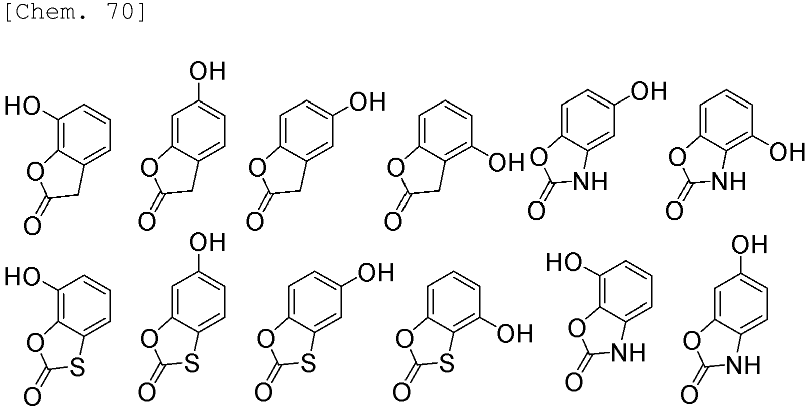

Examples of the skeleton represented by Formula (A-8f) include the following skeleton:

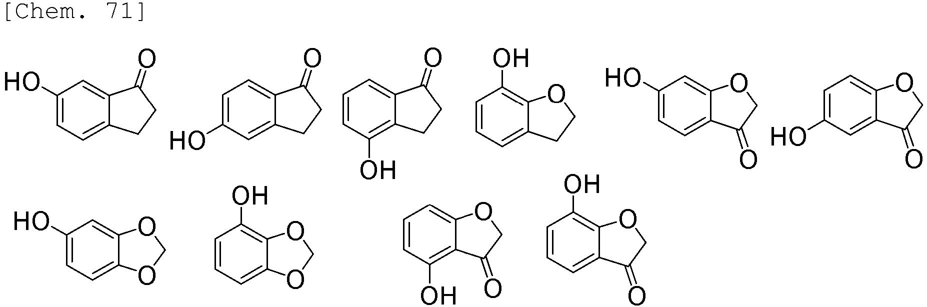

Examples of the skeleton represented by Formula (A-8g-1) or Formula (A-8g-2) include the following skeleton:

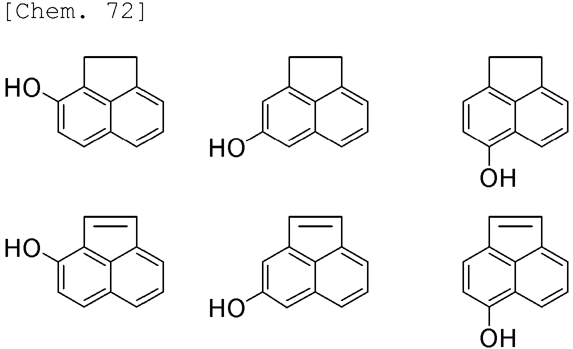

Examples of other skeletons of the phenolic skeleton include the following skeleton:

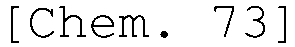

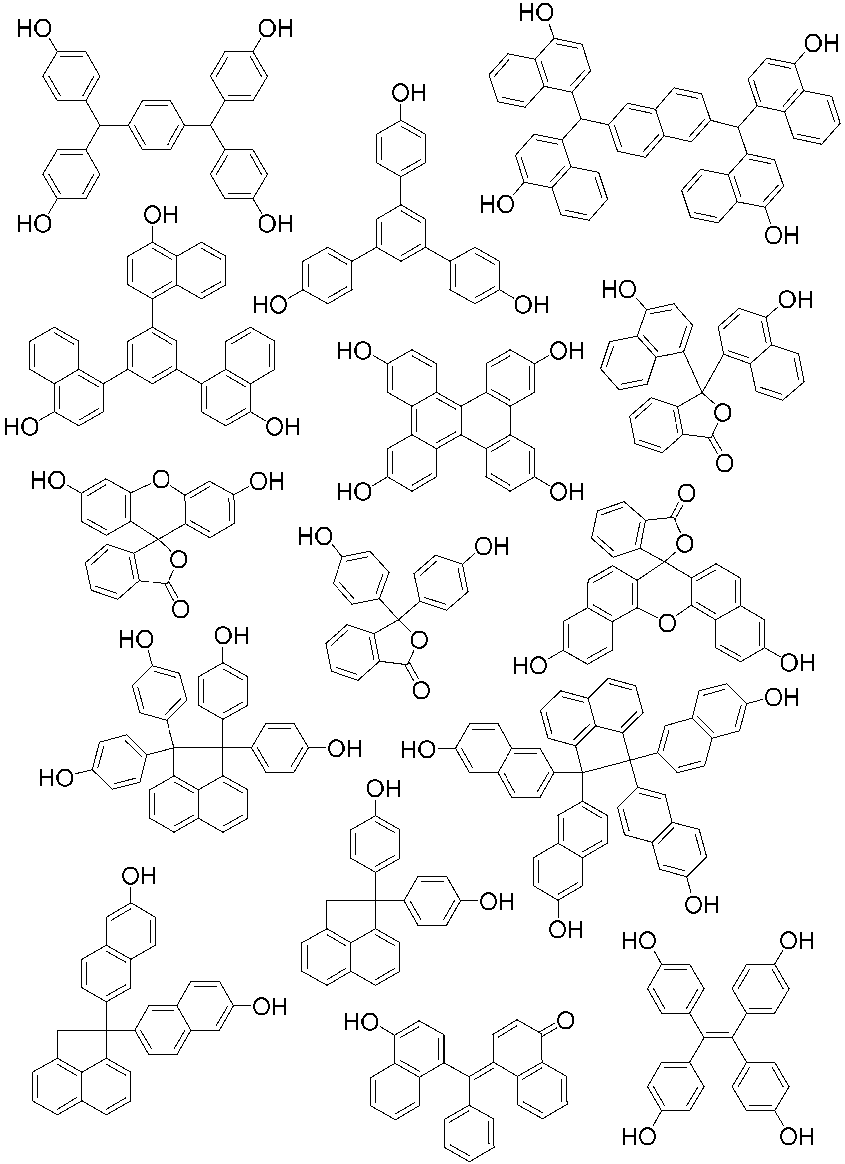

In addition, H of NH in the skeleton having the above aromatic ring, H of a hydroxy group bonded to an aromatic ring in the skeleton having an aromatic ring, and a hydrogen atom bonded to an aromatic ring in the skeleton having an aromatic ring may be replaced with a substituent.

Examples of the substituent include the substituent (S) represented by Formulae (S1) to (S7) below. 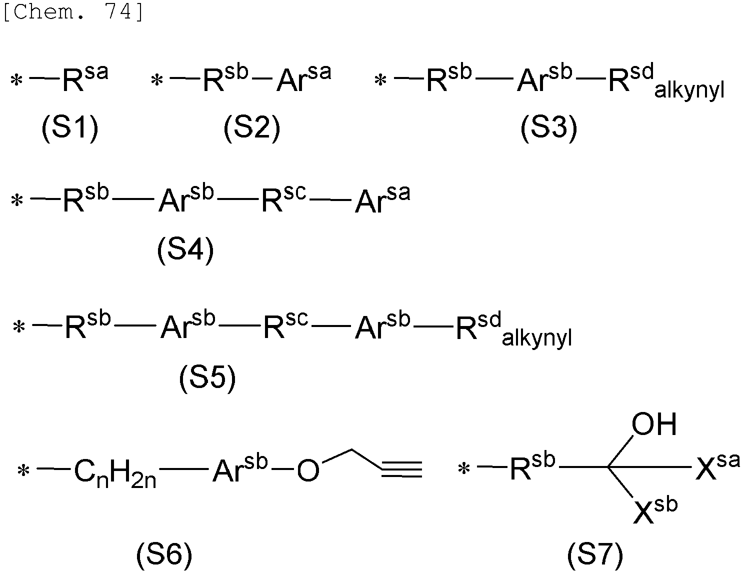 (In Formulae (S1) to (S7), R^{sa} represents a monovalent nonaromatic hydrocarbon group having 1 to 10 carbon atoms.
R^{sb} represents, each independently, a single bond or a divalent nonaromatic hydrocarbon group having 1 to 10 carbon atoms.
R^{sc} represents, each independently, a divalent nonaromatic hydrocarbon group having 1 to 10 carbon atoms.
R^{sd}_{alkynyl} represents, each independently, an alkynyl group having 2 to 4 carbon atoms.
Ar^{sa} represents, each independently, a monovalent aromatic hydrocarbon group having 6 to 20 carbon atoms.
Ar^{sb} represents, each independently, a divalent aromatic hydrocarbon group having 6 to 20 carbon atoms.
X^{sa} and X^{sb} represent, each independently, a hydrogen atom or a monovalent hydrocarbon group having 1 to 20 carbon atoms, or X^{sa} and X^{sb} constitute a carbonyl group together with a carbon atom bonded to a hydroxy group.
n represents an integer of 0 to 5.
* represents a bonding site.)

### <R^{sa}>

Examples of the monovalent nonaromatic hydrocarbon group having 1 to 10 carbon atoms in R^{sa} include an alkyl group having 1 to 10 carbon atoms and a monovalent unsaturated hydrocarbon group having 2 to 10 carbon atoms.

The monovalent unsaturated hydrocarbon group having 2 to 10 carbon atoms has one or two or more carbon-carbon multiple bonds. When the monovalent unsaturated hydrocarbon group having 2 to 10 carbon atoms has two or more carbon-carbon multiple bonds, all of the two or more carbon-carbon multiple bonds may be carbon-carbon double bonds, all of the two or more carbon-carbon multiple bonds may be carbon-carbon triple bonds, or a mixture of a carbon-carbon double bond and a carbon-carbon triple bond may be used. Two or more carbon-carbon multiple bonds may or may not be conjugated.

### <R^{sb} and R^{sc}>

Examples of the divalent nonaromatic hydrocarbon group having 1 to 10 carbon atoms in R^{sb} and R^{sc} include an alkylene group having 1 to 10 carbon atoms and a divalent unsaturated hydrocarbon group having 2 to 10 carbon atoms.

The divalent unsaturated hydrocarbon group having 2 to 10 carbon atoms has one or two or more carbon-carbon multiple bonds. When the divalent unsaturated hydrocarbon group having 2 to 10 carbon atoms has two or more carbon-carbon multiple bonds, all of the two or more carbon-carbon multiple bonds may be carbon-carbon double bonds, all of the two or more carbon-carbon multiple bonds may be carbon-carbon triple bonds, or a mixture of a carbon-carbon double bond and a carbon-carbon triple bond may be used. Two or more carbon-carbon multiple bonds may or may not be conjugated.

Examples of R^{sb} and R^{sc} include the following groups: 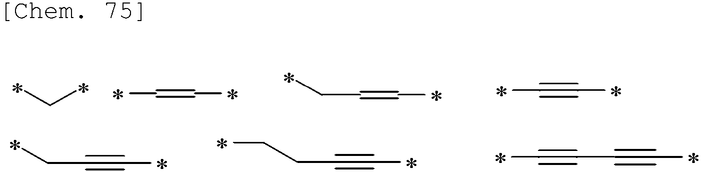 (* represents a bonding site.)

### <R^{sd}_{alkynyl}>

R^{sd}_{alkynyl} represents an alkynyl group having 2 to 4 carbon atoms. Examples of the alkynyl group having 2 to 4 carbon atoms include an ethynyl group, a 1-propynyl group, and a propargyl group (2-propynyl group).

### <Ar^{sa}>

The monovalent aromatic hydrocarbon group having 6 to 20 carbon atoms in Ar^{sa} is a residue obtained by removing one hydrogen atom from an aromatic hydrocarbon having 6 to 20 carbon atoms. Examples of the aromatic hydrocarbon having 6 to 20 carbon atoms include benzene, naphthalene, anthracene, phenanthrene, perinaphthane, pyrene, fluorene and biphenyl.

### <Ar^{sb}>

The divalent aromatic hydrocarbon group having 6 to 20 carbon atoms in Ar^{sb} is a residue obtained by removing two hydrogen atoms from an aromatic hydrocarbon having 6 to 20 carbon atoms. Examples of the aromatic hydrocarbon having 6 to 20 carbon atoms include benzene, naphthalene, anthracene, phenanthrene, pyrene, fluorene and biphenyl.

### <X^{sa} and X^{sb}>

Examples of the monovalent hydrocarbon groups having 1 to 20 carbon atoms in X^{sa} and X^{sb} include a monovalent nonaromatic hydrocarbon group having 1 to 10 carbon atoms and a monovalent aromatic hydrocarbon group having 6 to 20 carbon atoms.

Examples of the monovalent nonaromatic hydrocarbon group having 1 to 10 carbon atoms include an alkyl group having 1 to 10 carbon atoms.

The monovalent aromatic hydrocarbon group having 6 to 20 carbon atoms is a residue obtained by removing one hydrogen atom from an aromatic hydrocarbon having 6 to 20 carbon atoms. Examples of the aromatic hydrocarbon having 6 to 20 carbon atoms include benzene, naphthalene, anthracene, phenanthrene, perinaphthane, pyrene, fluorene and biphenyl.

Examples of the substituent represented by Formula (S1) include the following groups: 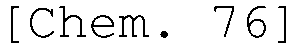 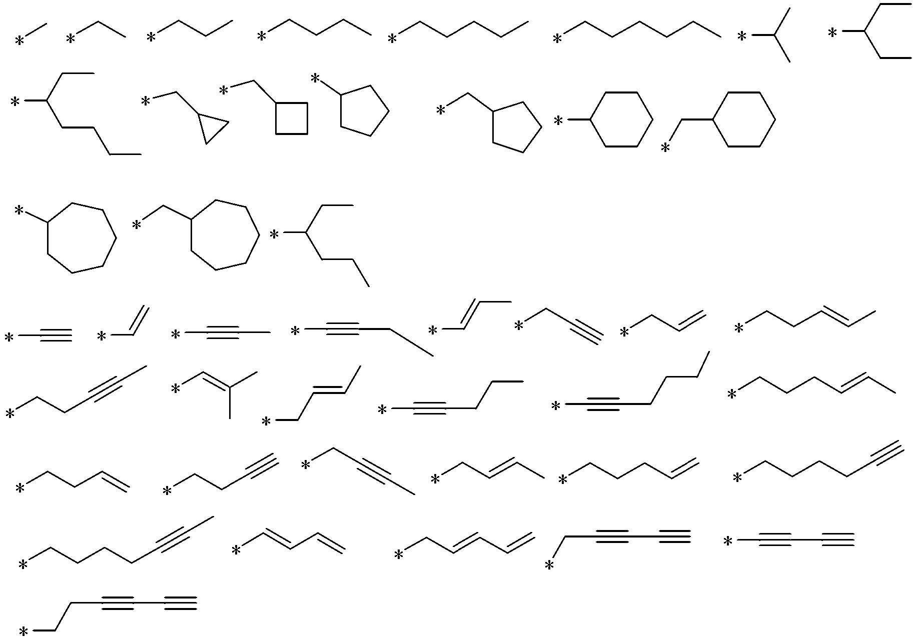 (* represents a bonding site.)

Examples of the substituent represented by Formula (S2) include the following groups: 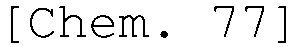 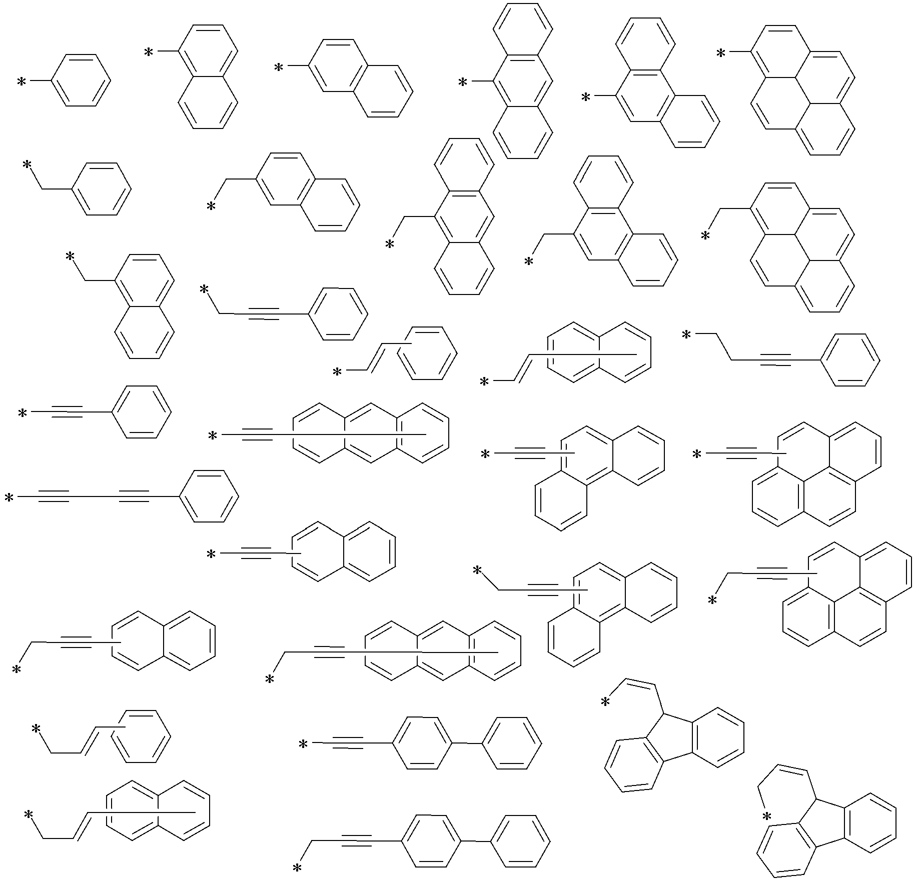 (* represents a bonding site.)

Examples of the substituent represented by Formula (S3) include the following groups: 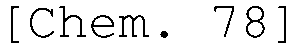 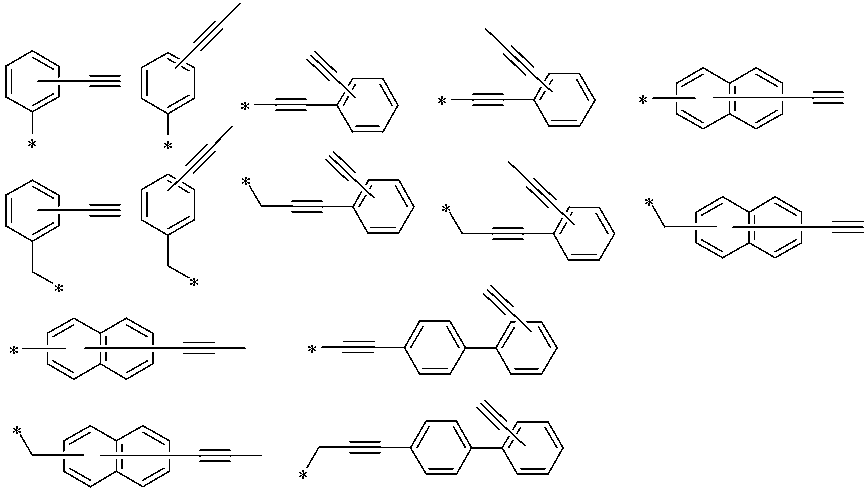 (* represents a bonding site.)

Examples of the substituent represented by Formula (S4) include the following groups: 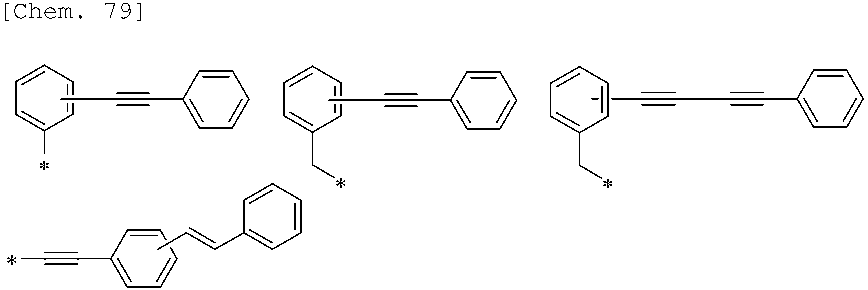 (* represents a bonding site.)

Examples of the substituent represented by Formula (S5) include the following groups: 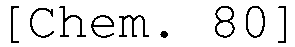 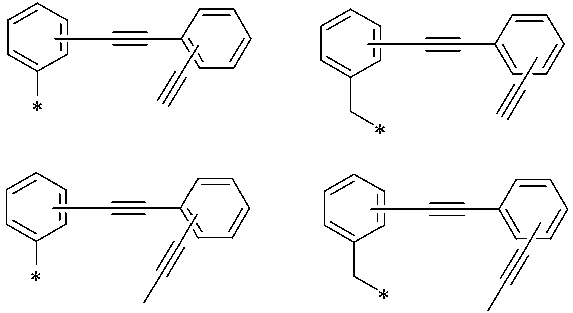 (* represents a bonding site.)

Examples of the substituent represented by Formula (S6) include the following groups:

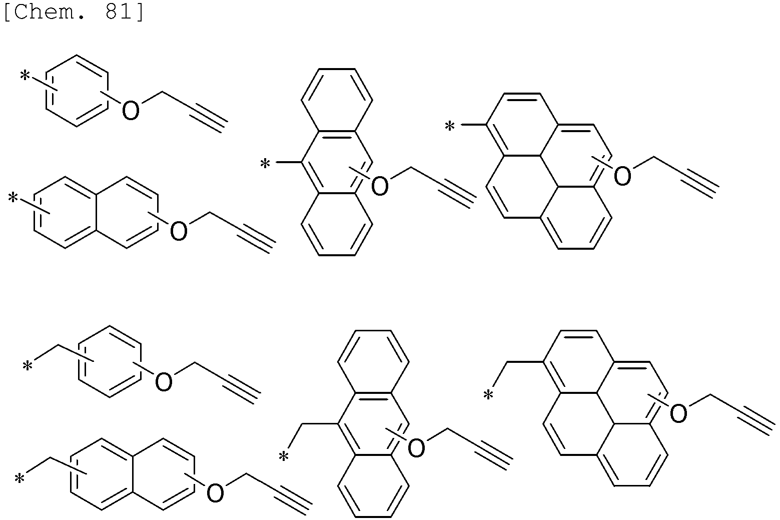

### (* represents a bonding site.)

Examples of the substituent represented by Formula (S7) include the following groups: 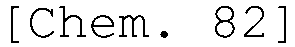 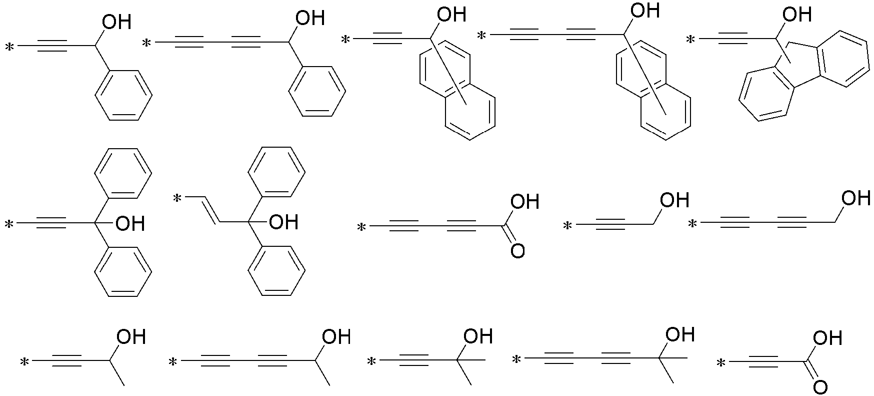 (* represents a bonding site.)

Examples of other substituents include the following groups: 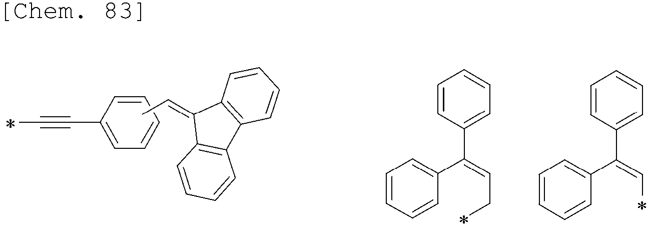 (* represents a bonding site.)

The unit structure (A) is preferably at least one selected from the following: Note that the positions of the two bonding sites indicated in each unit structure described below are merely indicated for convenience, and can extend from any possible carbon atom, respectively, and do not limit the positions.

### (Example of unit structure composed of aromatic amine skeleton)

-NH- may have a structure in which a hydrogen atom on N is substituted.

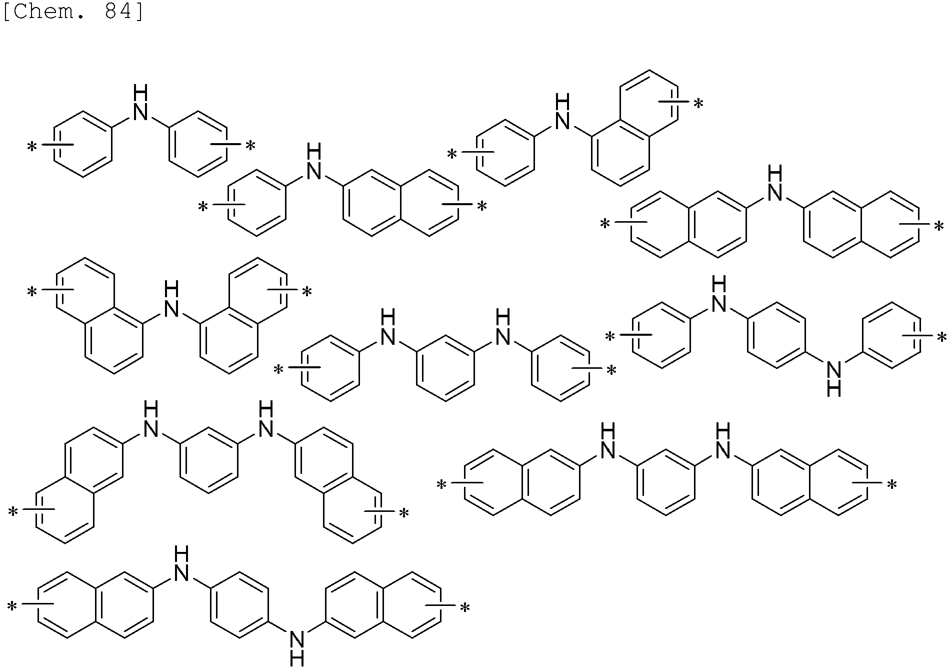

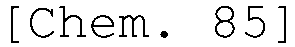

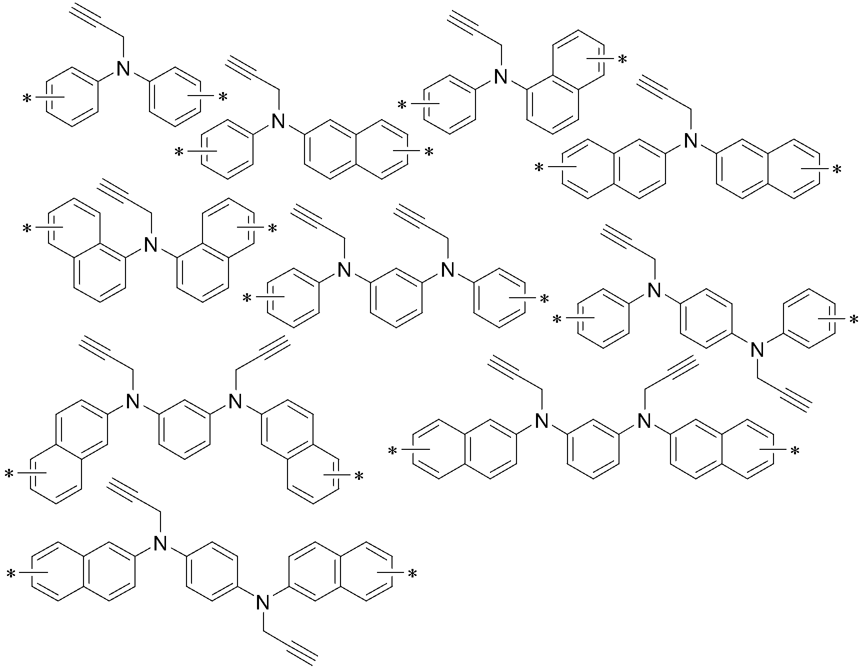

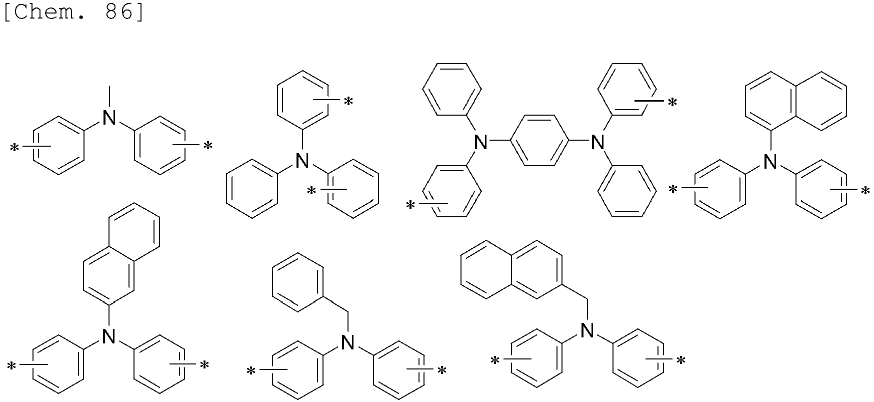

### (Example of unit structure composed of nitrogen-containing aromatic heterocyclic skeleton)

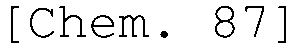

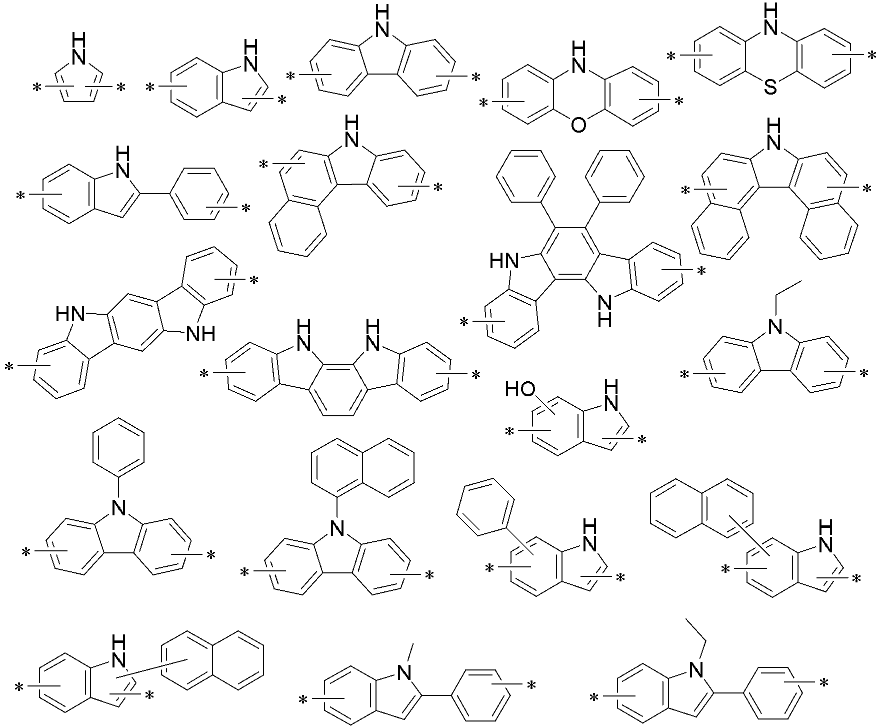

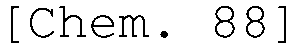

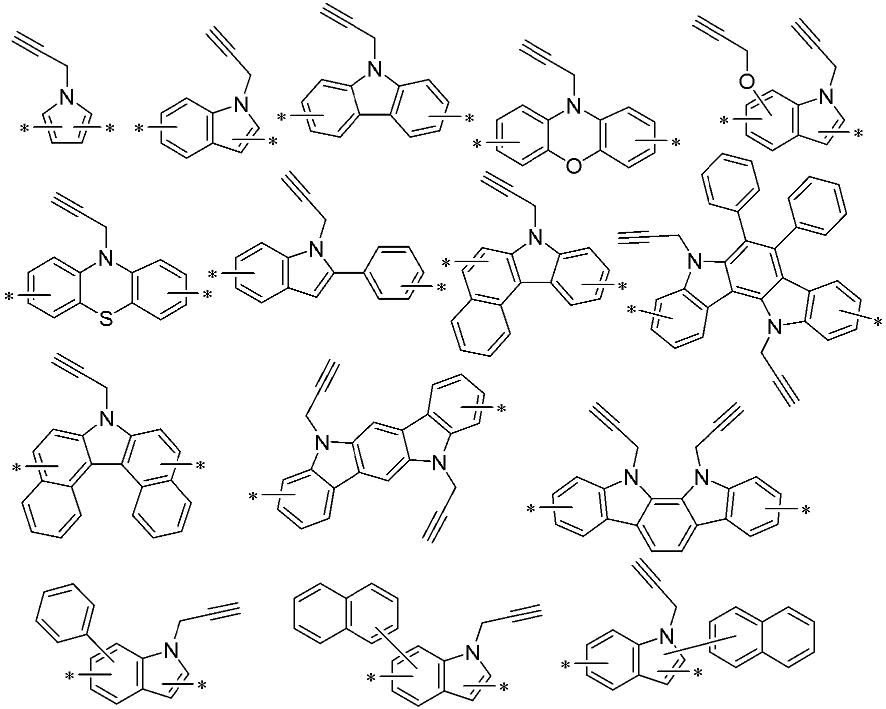

### (Examples of unit structures composed of phenolic skeleton)

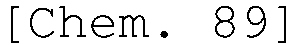

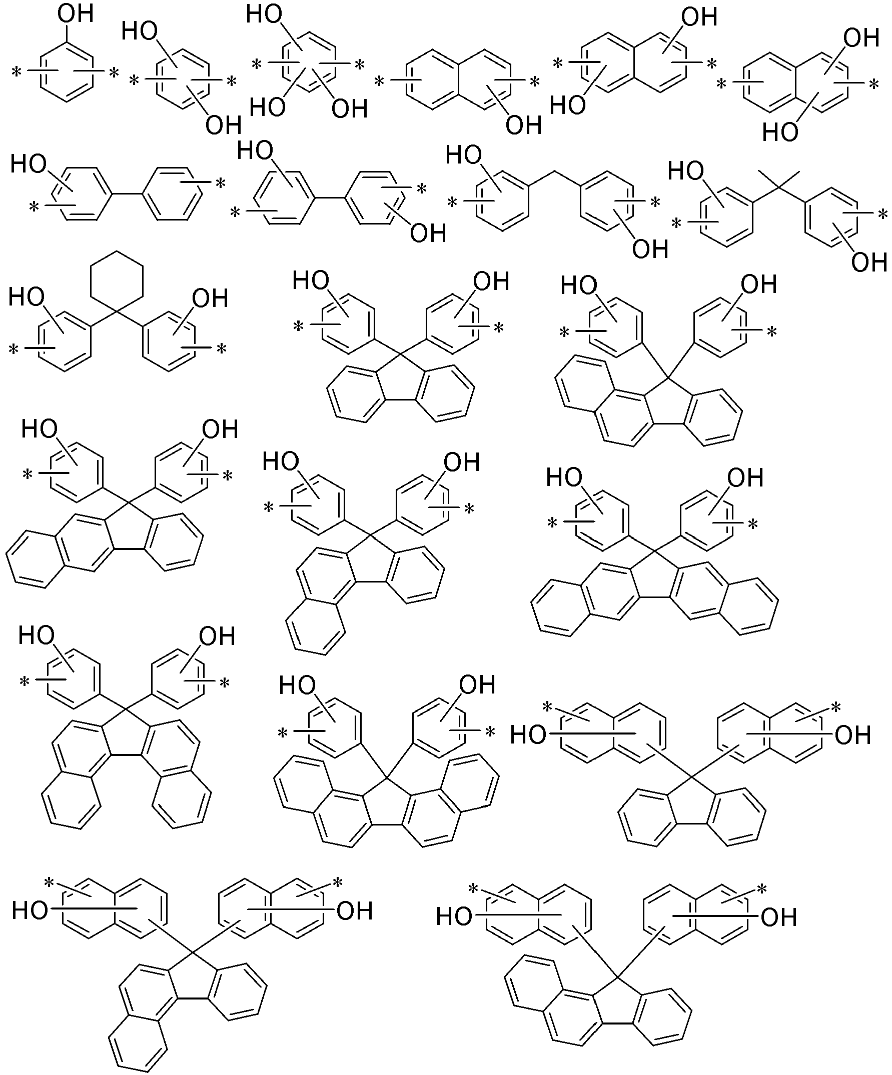

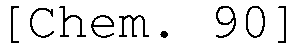

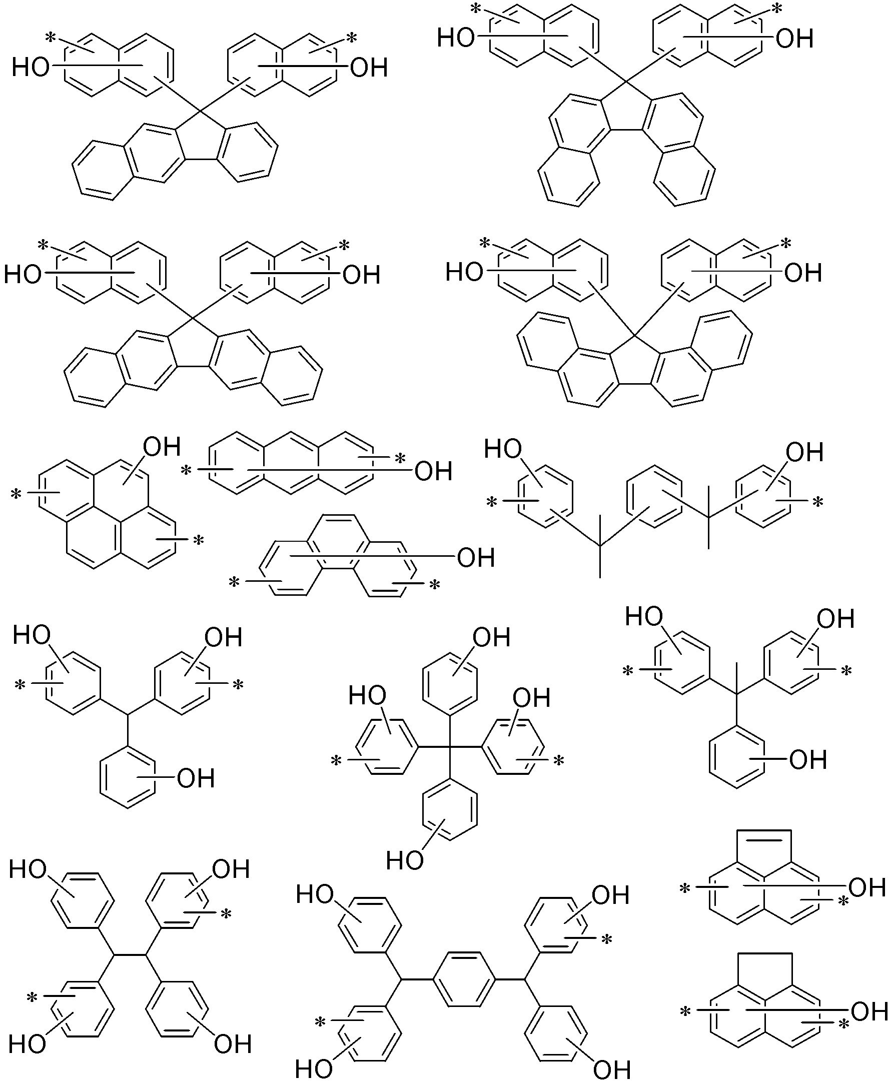

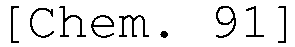

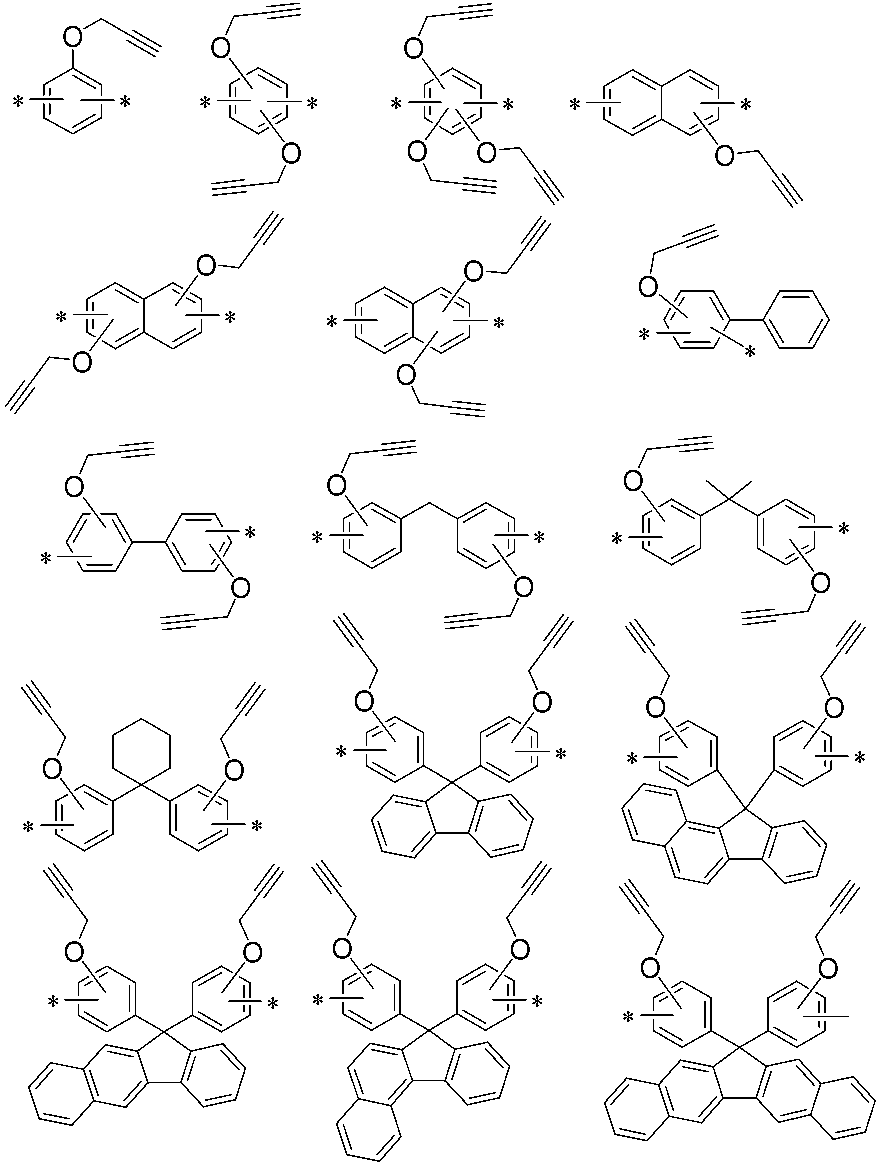

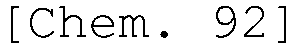

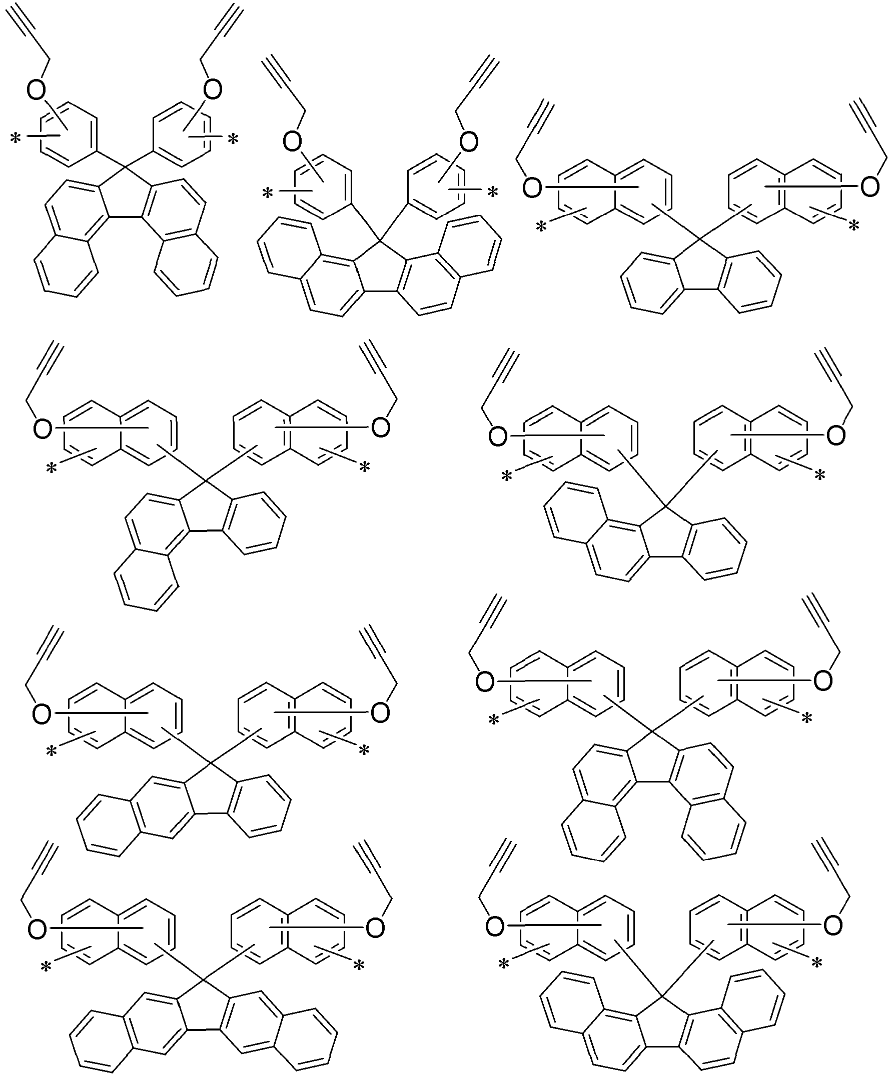

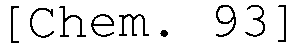

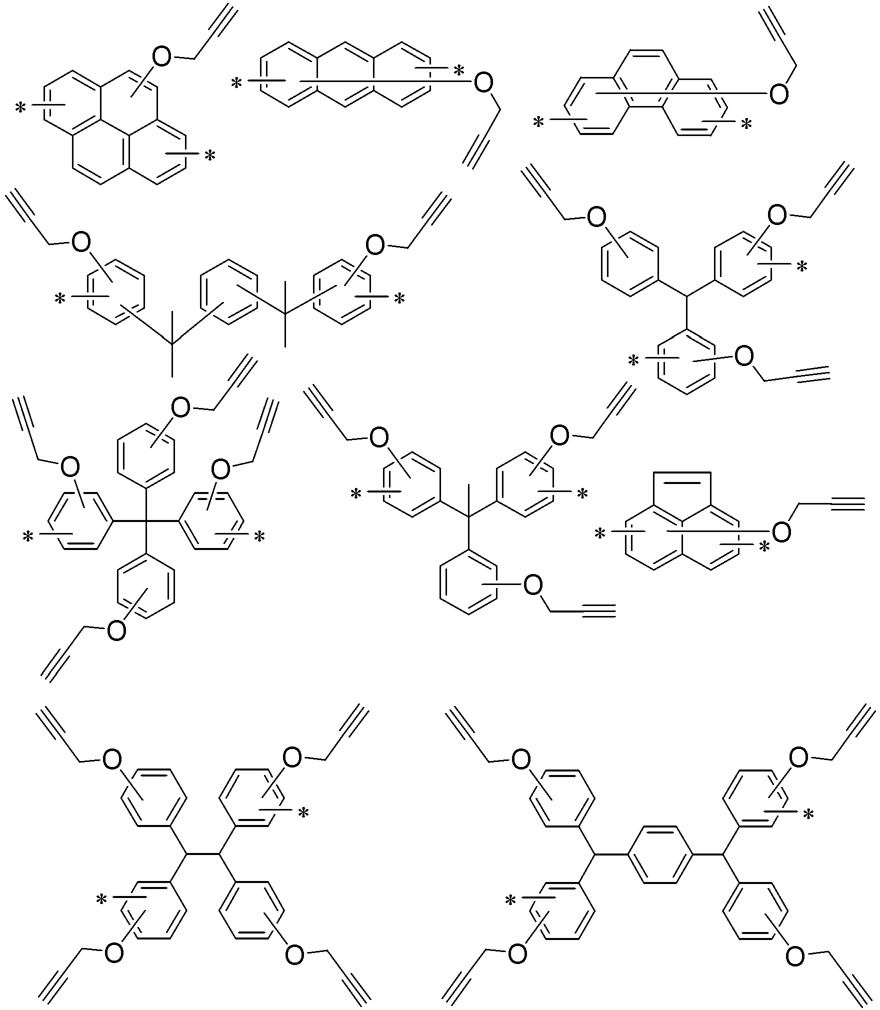

### <<B-1: Unit structure (B)>>

The unit structure (B) has one or more carbon atoms.

The unit structure (B) is, for example, a unit structure derived from an aldehyde compound or an aldehyde equivalent.

The unit structure (B) is one type or two or more types of unit structures containing a linking carbon atom [see (I-1) above] bonded to an aromatic ring in the unit structure (A), and includes, for example, a structure represented by Formula (B1), (B2), or (B3) below. The unit structure (B) can connect the two unit structures (A) by being covalently bonded to the unit structure (A).

### <<<B-2: Unit structure (B-I)>>>

The unit structure (B) includes the unit structure (BI). The unit structure (B-I) has a quaternary carbon atom bonded to a carbon atom constituting the aromatic ring of the unit structure (A).

Here, the unit structure (B-I) is a subordinate concept of the unit structure (B) and does not refer to a partial structure of the unit structure (B).

Hereinafter, the unit structure (B-I) will be described.

### <<<B-3: Formula (B1)>>>

The unit structure (B-I) includes, for example, a structure represented by the following Formula (B1). The unit structure (B-I) may be a structure represented by the following Formula (B1).

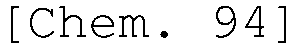

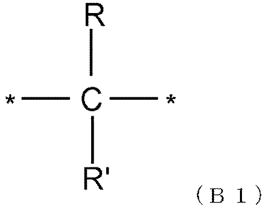

In Formula (B1), R and R' each independently represent an aromatic ring having 6 to 30 carbon atoms which may have a substituent, a heterocyclic ring having 3 to 30 carbon atoms which may have a substituent, or a linear, branched, or cyclic alkyl group having 10 or less carbon atoms which may have a substituent. R and R' may form a structure having a ring structure together with a carbon atom to which they are bonded. * represents a bonding site.

The central carbon atom in Formula (B1) is a quaternary carbon atom bonded to a carbon atom constituting the aromatic ring of the unit structure (A).

Examples of the substituent include a hydroxy group, a carboxy group, a formyl group, a nitro group, an alkyl group, an alkoxy group, an aryl group, an aryloxy group, a cyano group, a group in which H of a hydroxy group is substituted with the substituent (S) above, and a halo group.

In addition, each of the two bonding sites of Formula (B1) can be covalently bonded to each aromatic ring in the two unit structures (A).

In the definitions of R and R' in Formula (B1), the above (I-3) and (I-4) can be referred to for "aromatic ring" and "heterocyclic ring".

In the definitions of R and R' in Formula (B1), examples of the "alkyl group" include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, an n-heptyl group, an n-octyl group, an n-nonyl group, and an n-decyl group.

Preferably, R and R' are each independently phenyl, naphthalenyl, anthracenyl, phenanthrenyl, naphthacenyl, or pyrenyl.

Examples of the structures having a ring structure formed by R and R' together with a carbon atom bonded thereto include the structures represented by the following formula: 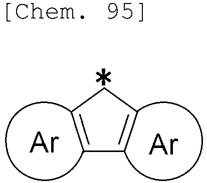 (where each Ar independently represents a residue of an aromatic ring, the carbon atom represented by * is a carbon atom bonded to R and R' in Formula (B1)).

Examples of the aromatic ring of Ar include an aromatic ring represented by Formula (G1).

The unit structure (B) including the structure represented by Formula (B1) is derived from, for example, a ketone compound.

Examples of the ketone compounds include a compound represented by Formula (B-1b) below. 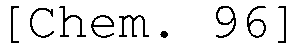 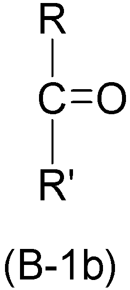 (In Formula (B-1b), R and R' have the same meanings as R and R' in Formula (B1), respectively.
In Formula (B-1b), R and R' may form a structure having a ring structure together with a carbon atom to which they are bonded.)

For example, when obtaining the resin (G), the carbonyl group in Formula (B-1b) is converted into *-C-* in Formula (B1).

Some specific examples of the unit structure (B) including the structure represented by Formula (B1) are as follows. * basically indicates a binding site with the unit structure (A). Needless to say, the structure may include the exemplary structure as a part of the whole.

Although an example in which the number of bonding sites (*) exceeds 2 is also included, these surplus bonding sites can be used for bonding to an aromatic ring in another polymer chain, crosslinking, or the like, or may be a bonding site to a hydrogen bond.

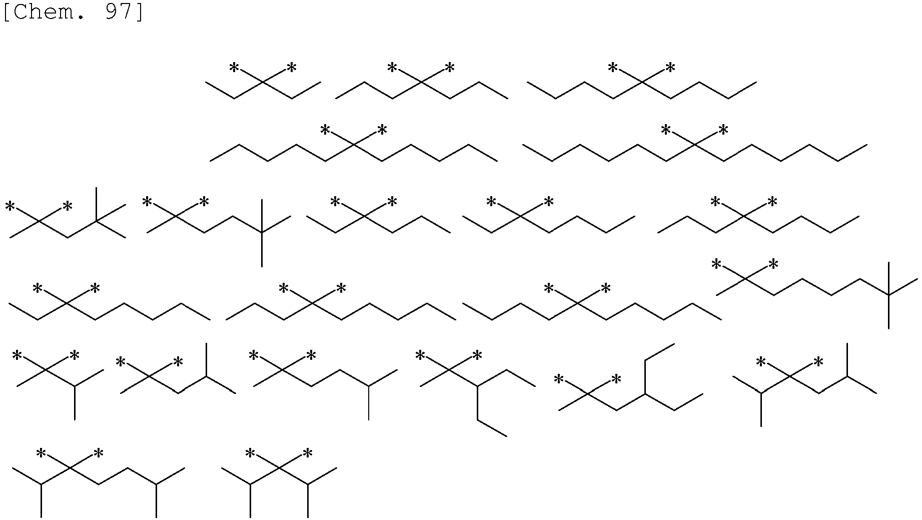

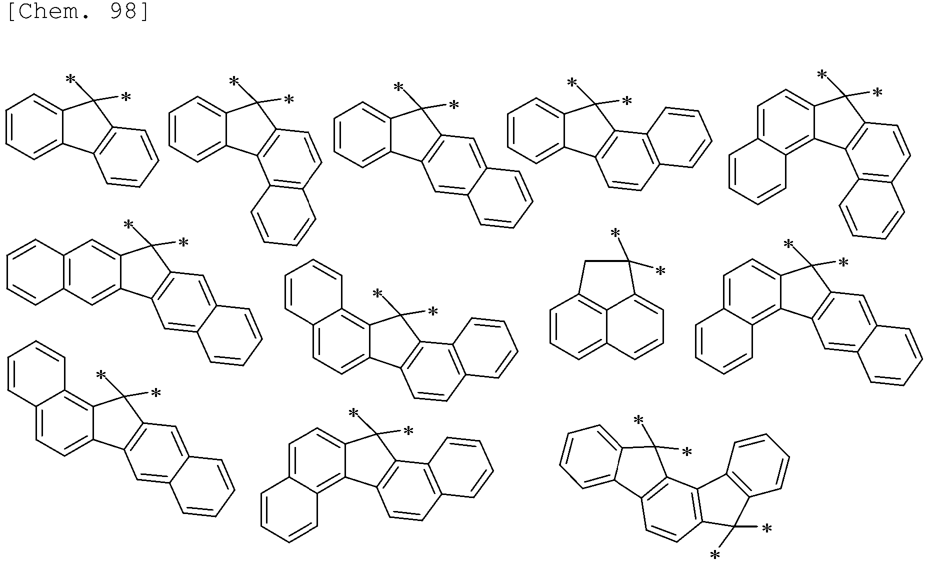

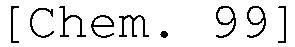

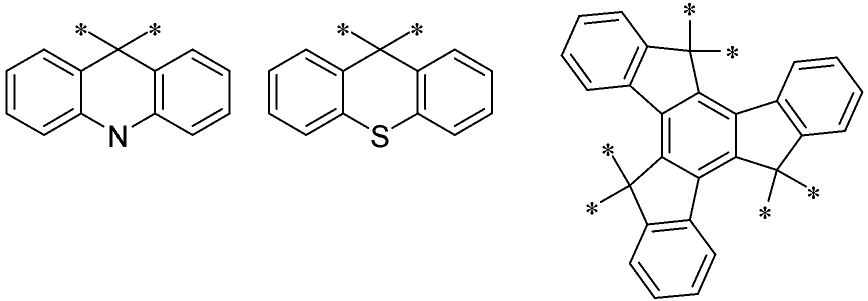

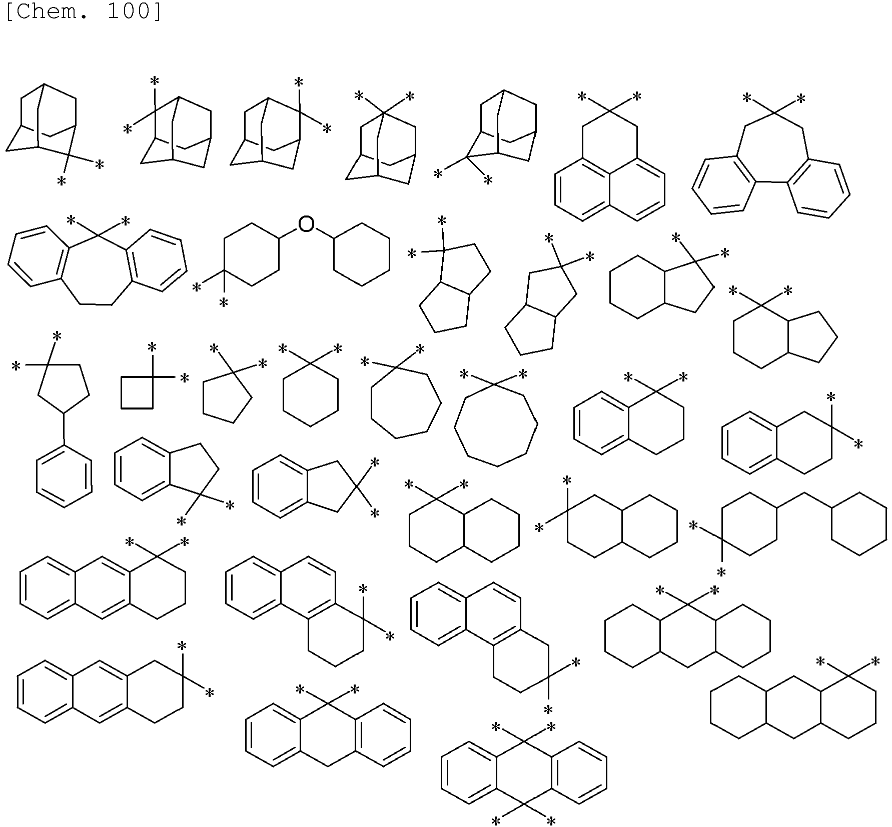

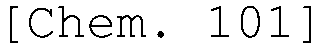

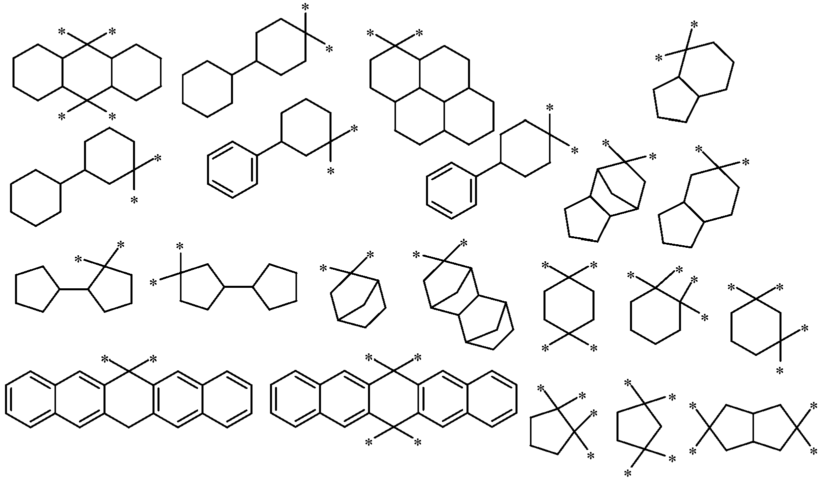

### <<<B-4: Formula (B2)>>>

The unit structure (B) in the resin (G) may include a unit structure other than the unit structure (B-I) (hereinafter also referred to as a "unit structure (B-II)").

The unit structure (B-II) includes, for example, a structure represented by the following Formula (B2). The unit structure (B-II) may be a structure represented by the following Formula (B2).

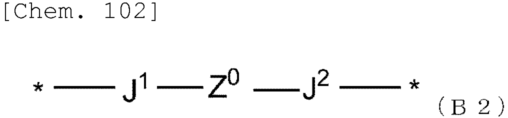

In Formula (B2), Z⁰ represents an aromatic ring residue or aliphatic ring residue having 6 to 30 carbon atoms which may have a substituent, or an organic group in which two or more aromatic or aliphatic rings are linked by a single bond. Examples of the organic group in which two or more aromatic or aliphatic rings are linked by a single bond include divalent residues such as biphenyl, cyclohexylphenyl, and bicyclohexyl.

Examples of the substituent include a hydroxy group, a carboxy group, a formyl group, a nitro group, an alkyl group, an alkoxy group, an aryl group, an aryloxy group, a cyano group, a group in which H of a hydroxy group is substituted with the substituent (S) above, and a halo group.

J¹ and J² represent, each independently, a direct bond or a divalent organic group which may have a substituent. The divalent organic group is preferably a linear or branched alkylene group having 1 to 6 carbon atoms which may be substituted with a hydroxy group, an aryl group (such as phenyl group, substituted phenyl group), or a halo group (such as fluorine) as a substituent. Examples of the linear alkylene groups include a methylene group, an ethylene group, a propylene group, a butylene group, a pentylene group, and a hexylene group.

The unit structure (B) including the structure represented by Formula (B2) is derived from, for example, a compound having a hydroxy group or an alkoxy group bonded to a secondary or tertiary carbon atom, a compound having a hydroxy group, an alkoxy group or a halo group bonded to an α-position carbon atom (such as a benzyl position carbon atom) of an alkylaryl group, or a compound having two carbon-carbon double bonds. These compounds are aldehyde equivalents.

Examples of the compound having a hydroxy group or an alkoxy group bonded to a secondary or tertiary carbon atom include a compound represented by Formula (B-2a) below.

Examples of the compound having a hydroxy group, an alkoxy group, or a halo group bonded to an α-position carbon atom (such as a benzyl position carbon atom) of the alkylaryl group include a compound represented by Formula (B-2b) below.

Examples of the compounds having two carbon-carbon double bonds include a compound represented by Formula (B-2c) below or Formula (B-2d) below. 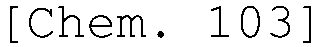 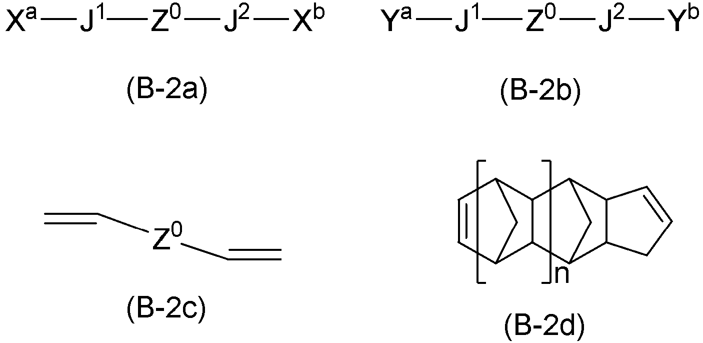 (In Formulae (B-2a), (B-2b), and (B-2b), J¹, J², and Z⁰ have the same meanings as J¹, J², and Z⁰ in Formula (B2), respectively.
In Formula (B-2a), X^{a} and X^{b} represent, each independently, a hydroxy group or an alkoxy group bonded to a secondary or tertiary carbon atom.
In Formula (B-2b), Y^{a} and Y^{b} represent, each independently, a hydroxy group, an alkoxy group or a halo group bonded to an α-position carbon atom (such as a benzyl position carbon atom) of an alkylaryl group.
In Formula (B-2d), n represents an integer of 0 to 4).

For example, in obtaining the resin (G), X^{a}-J¹ in Formula (B-2a) is converted to *-J¹ in Formula (B2). J²-X^{b} is converted to J²-* in Formula (B2).

For example, in obtaining the resin (G), Y^{a}-J¹ in Formula (B-2b) is converted to *-J¹ in Formula (B2). J²-Y^{b} is converted to J²-* in Formula (B2).

An example of Formula (B-2a) is the following compound:

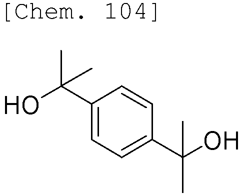

An example of Formula (B-2b) is the following compound:

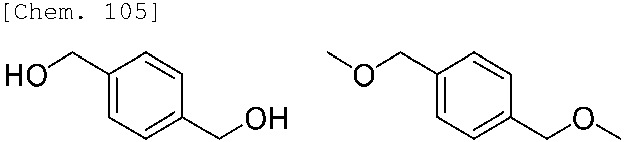

An example of Formula (B-2c) is the following compound:

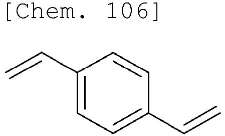

Some specific examples of the unit structures including the structure represented by Formula (B2) are as follows: * represents a binding site with the unit structure (A). Needless to say, the structure may be a unit structure including the exemplary structure as a part of the whole.

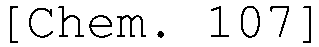

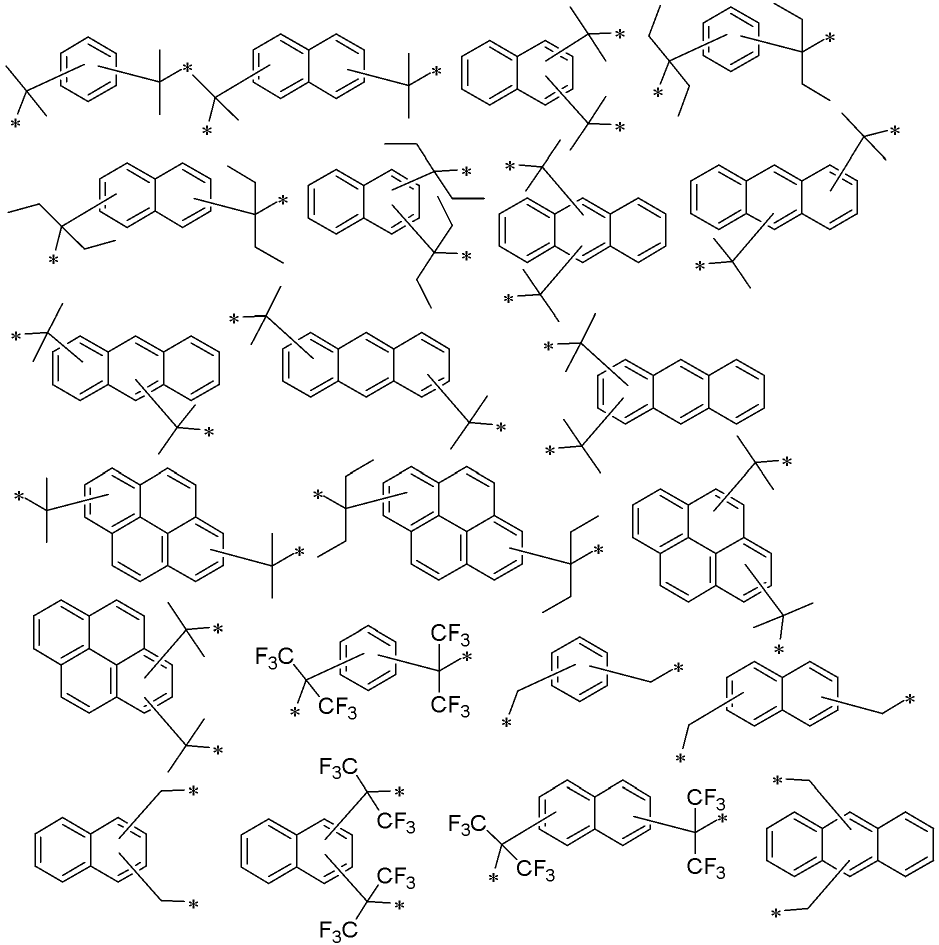

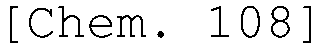

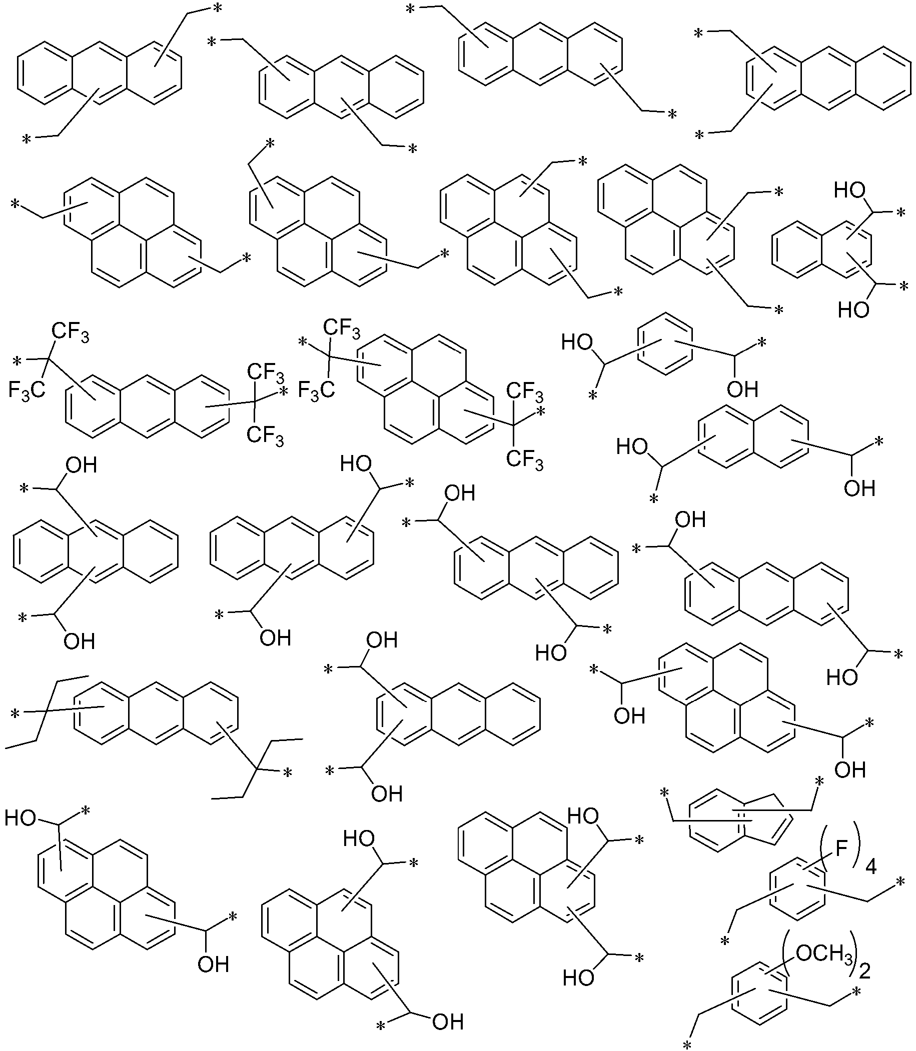

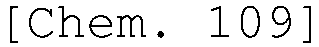

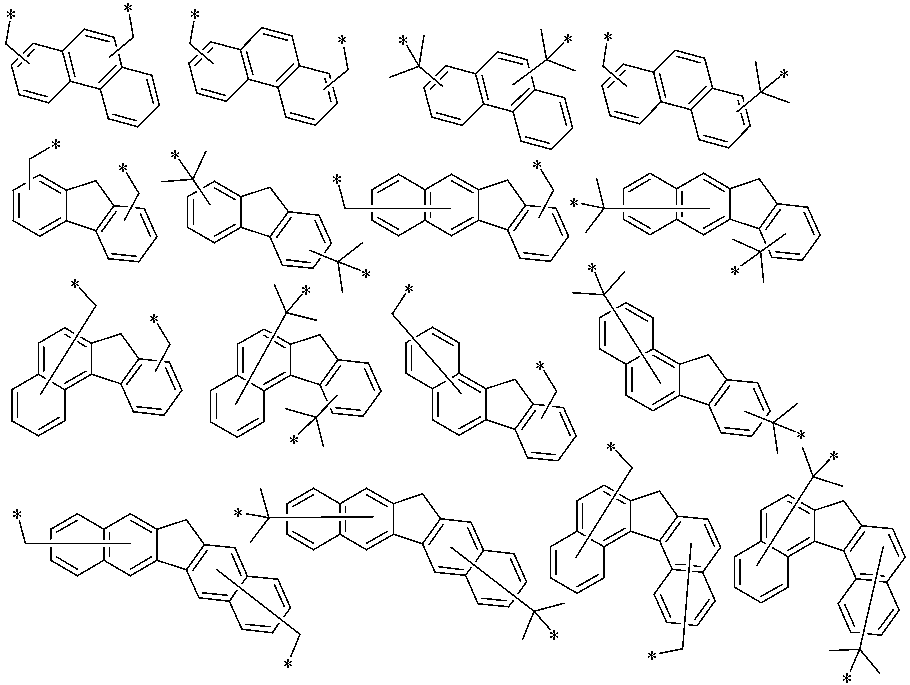

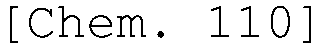

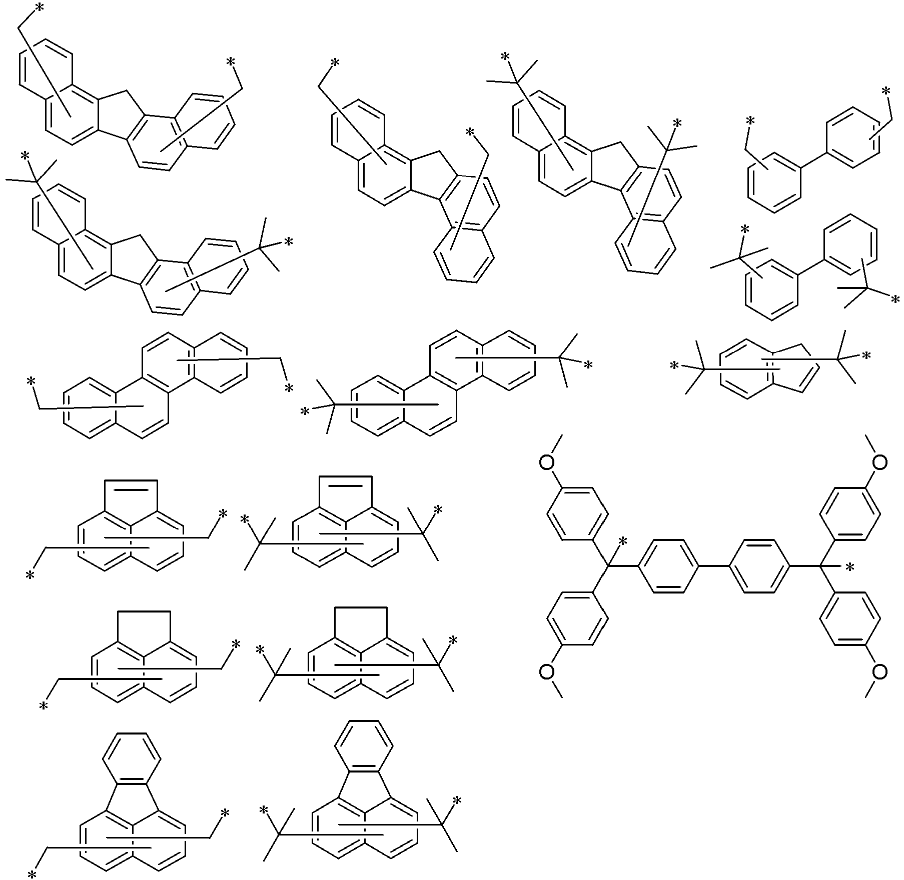

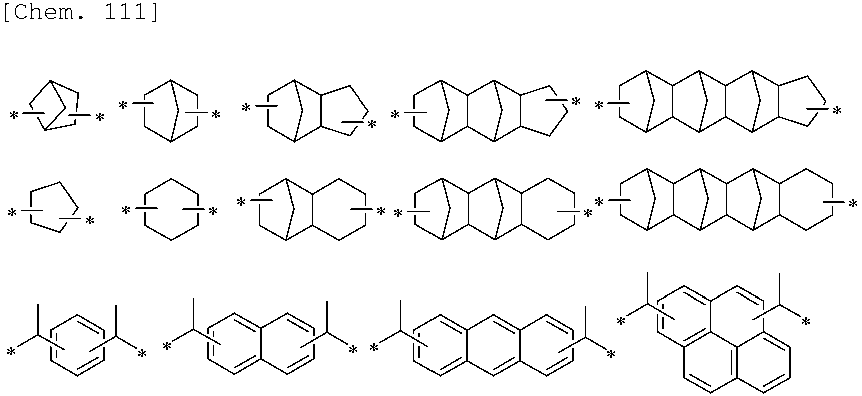

### <<<B-5: Formula (B3)>>>

The unit structure (B-II) includes, for example, a structure represented by the following Formula (B3). The unit structure (B-II) may be a structure represented by the following Formula (B3).

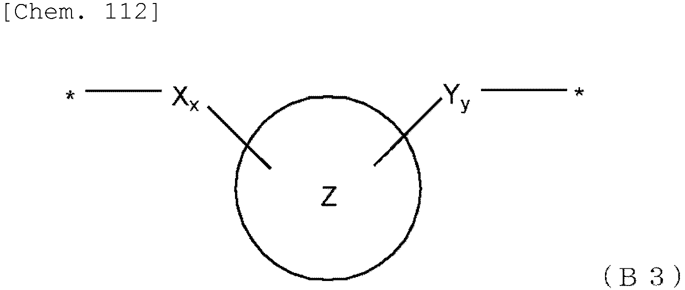

In Formula (B3), Z is a group having a monocyclic ring or a bicyclic, tricyclic, or tetracyclic condensed ring having 4 to 25 carbon atoms, which may have a substituent. The number of carbon atoms referred to herein means the number of carbon atoms constituting the ring skeleton of a monocyclic ring or a bicyclic, tricyclic, or tetracyclic condensed ring only, excluding a substituent, and does not include the number of heteroatoms constituting a heterocyclic ring when the monocyclic ring or the condensed ring is a heterocyclic ring.

The monocyclic ring is a monocyclic ring (hereinafter, it may be referred to as a "non-Hückel monocyclic ring") in which the number of π electrons does not satisfy 4n+2 (n is an integer of 0 or more), and at least one of the monocyclic rings constituting the bicyclic ring, the tricyclic ring, and the tetracyclic ring is a monocyclic ring in which the number of π electrons does not satisfy 4n+2 (n is an integer of 0 or more), and the remaining monocyclic rings may be a monocyclic ring in which the number of π electrons satisfies 4n+2 (n is an integer of 0 or more) or a monocyclic ring in which the number of π electrons does not satisfy 4n+2 (n is an integer of 0 or more).

The monocyclic, or the bicyclic, tricyclic, or tetracyclic condensed ring may further form a condensed ring with one or more aromatic rings to form a pentacyclic or higher condensed ring, the number of carbon atoms of the pentacyclic or higher condensed ring is preferably 40 or less, and the number of carbon atoms referred to herein means the number of carbon atoms constituting the ring skeleton of the pentacyclic or higher condensed ring only, excluding substituents, and does not include the number of heteroatoms constituting a heterocyclic ring when the pentacyclic or higher condensed ring is a heterocyclic ring.

X and Y are the same or different and each represent a -CR³¹R³²- group, and R³¹ and R³² are the same or different and each represent a hydrogen atom or a hydrocarbon group having 1 to 6 carbon atoms.

x and y each represent the number of X and Y, respectively, and each independently represent 0 or 1.

At least one of 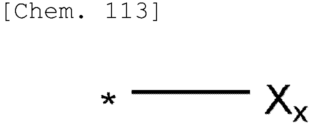 in Formula (B3) and 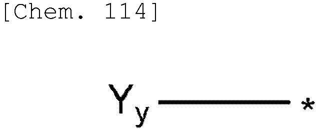 in Formula (B3) is bonded to any carbon atom (referred to as "carbon atom Z") constituting the non-Hückel monocyclic ring of Z (when x=1 and y=1) or extends from the carbon atom Z (when x=0 and y=0).

For example, in Formula (B3), 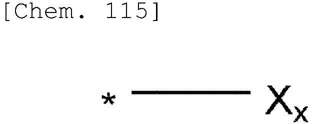 is bonded (when x= 1) to any carbon atom constituting the non-Hückel monocyclic ring of Z (referred to as "carbon atom 1") or extends from carbon atom 1 (when x= 0).

In Formula (B3), 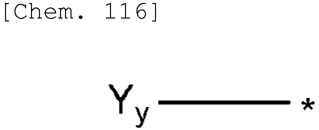 is bonded to any carbon atom (referred to as "carbon atom 2") (when y = 1) constituting the non-Hückel monocyclic ring of Z or extends from the carbon atom 2 (when y= 0), and the carbon atom 1 and the carbon atom 2 may be the same or different, and when being different, may belong to the same non-Hückel monocyclic ring or may belong to different non-Hückel monocyclic rings.

In Formula (B3), optionally, a linked carbon atom other than carbon atom 1 and carbon atom 2 may be contained.

When Z is a tricyclic or more condensed ring, the permutation positional relationship in the condensed ring of one or two non-Hückel monocyclic rings to which carbon atoms 1 and 2 in Formula (B3) respectively belong and the remaining monocyclic rings is optional, and when carbon atoms 1 and carbon atoms 2 respectively belong to different non-Hückel monocyclic rings (referred to as "non-Hückel monocyclic ring 1" and "non-Hückel monocyclic ring 2", respectively), the permutation positional relationship in the condensed ring of the non-Hückel monocyclic ring 1 and the non-Hückel monocyclic ring 2 is also optional.

Specific examples of the organic group including the structure represented by Formula (B3) are as follows: The binding site with the unit structure (A) is not particularly limited. Needless to say, the structure may include the exemplary structure as a part of the whole.

Although an example in which the number of bonding sites (*) exceeds 2 is also included, these surplus bonding sites can be used for bonding to an aromatic ring in another polymer chain, crosslinking, or the like, or may be a bonding site to a hydrogen bond.

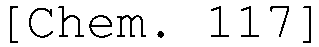

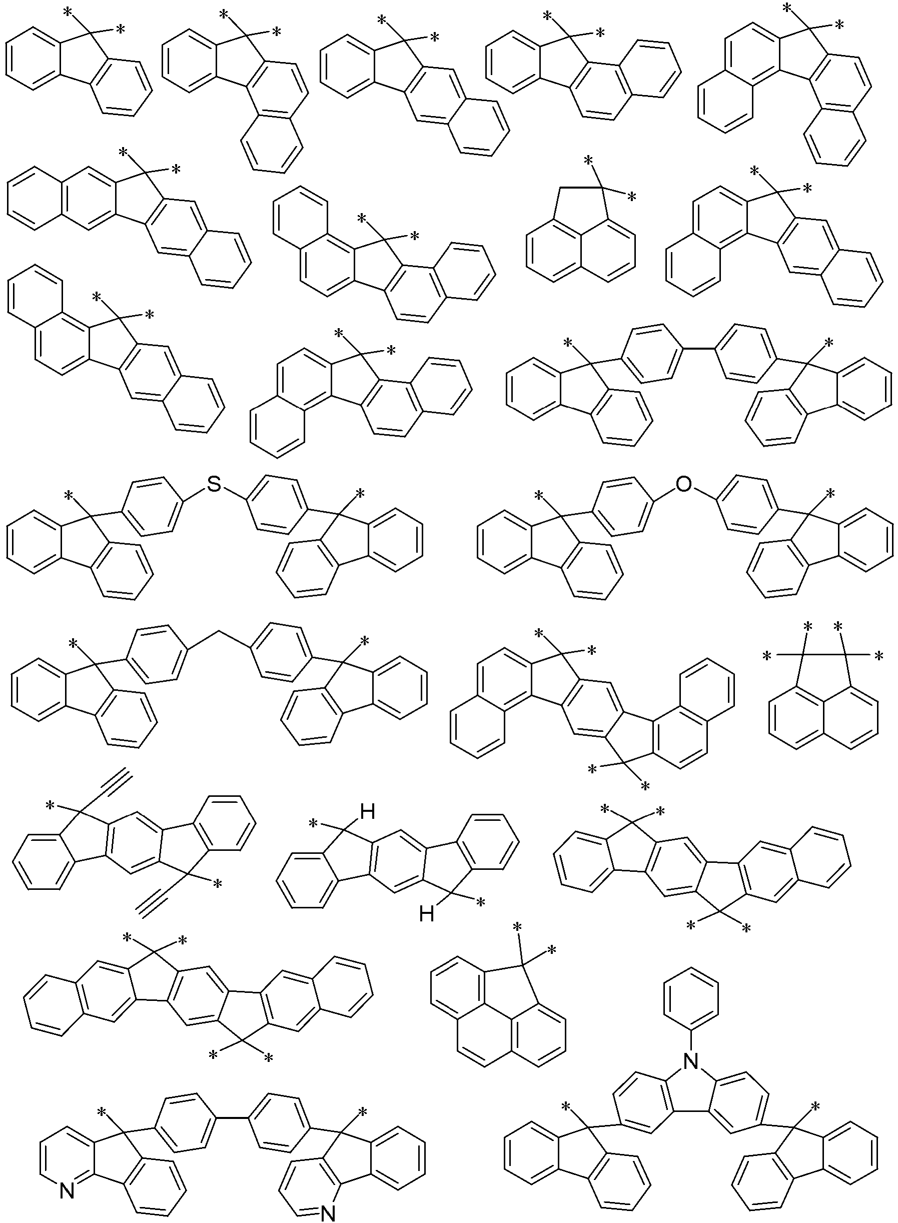

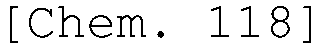

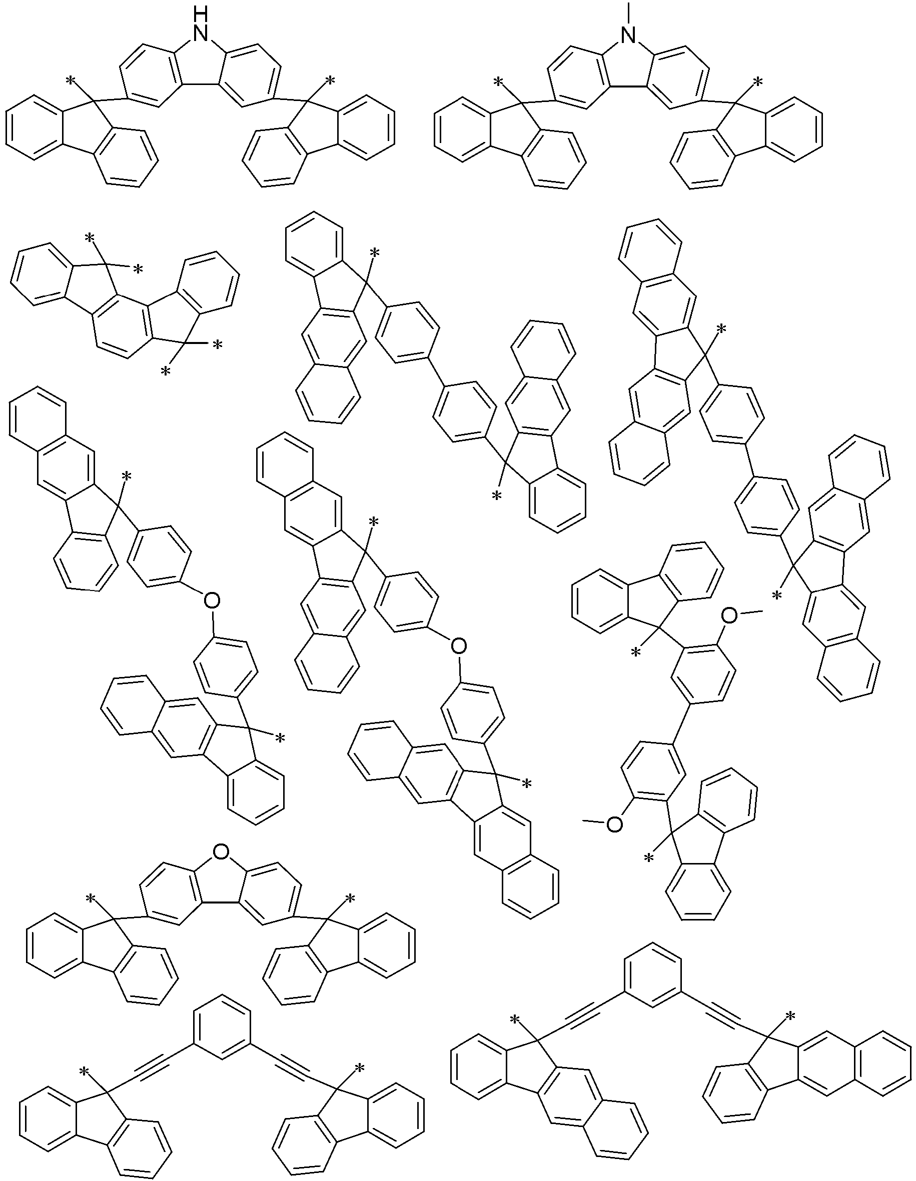

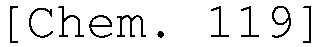

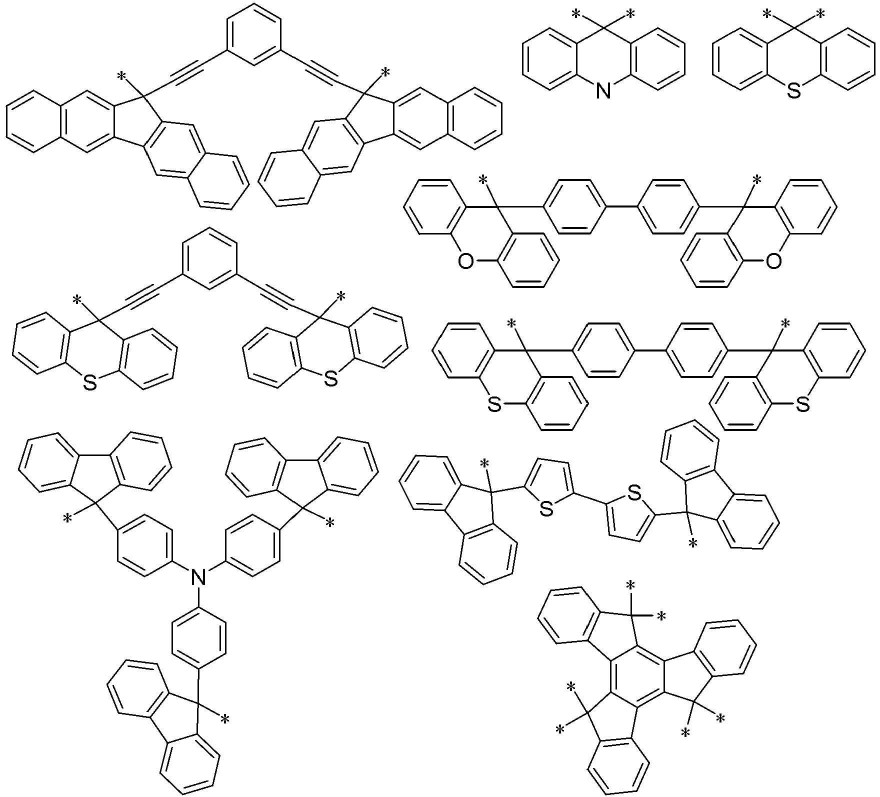

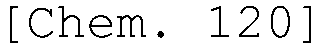

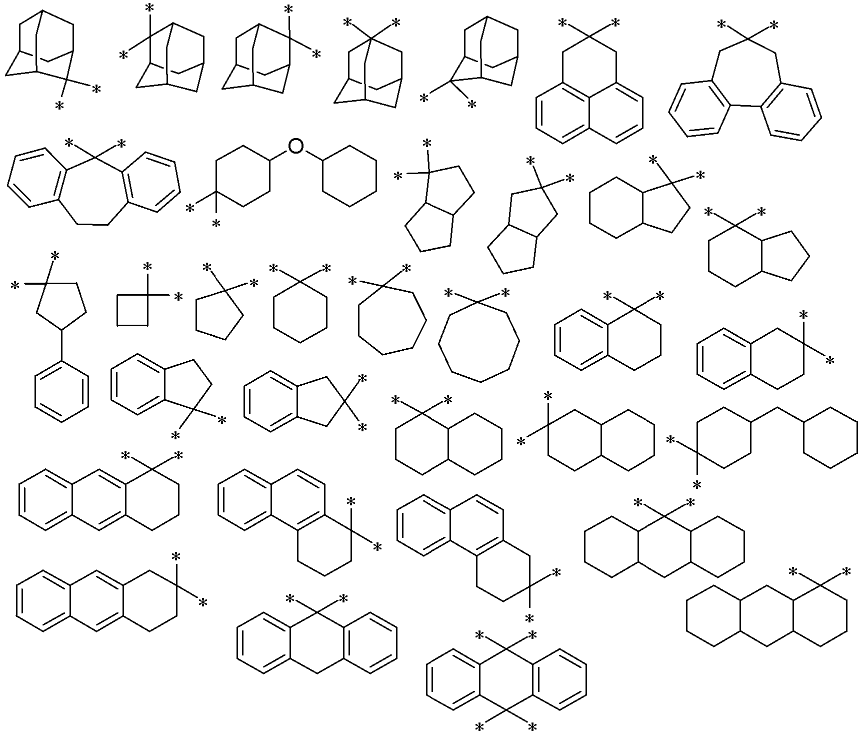

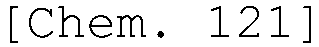

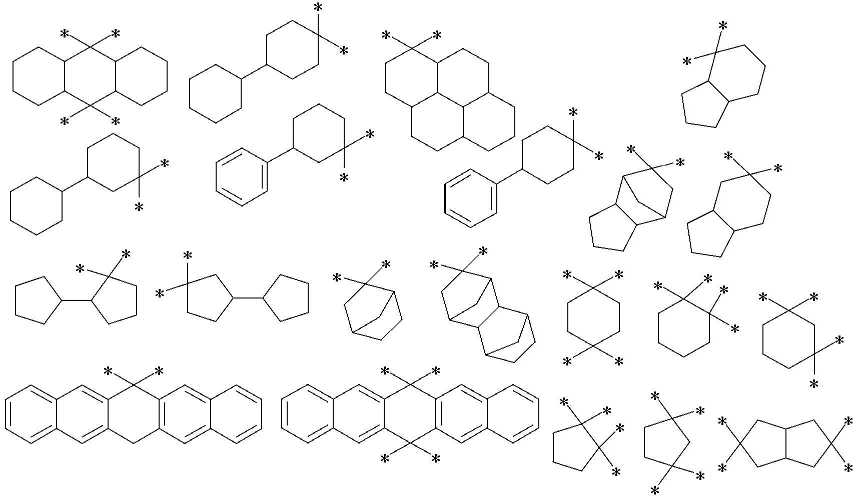

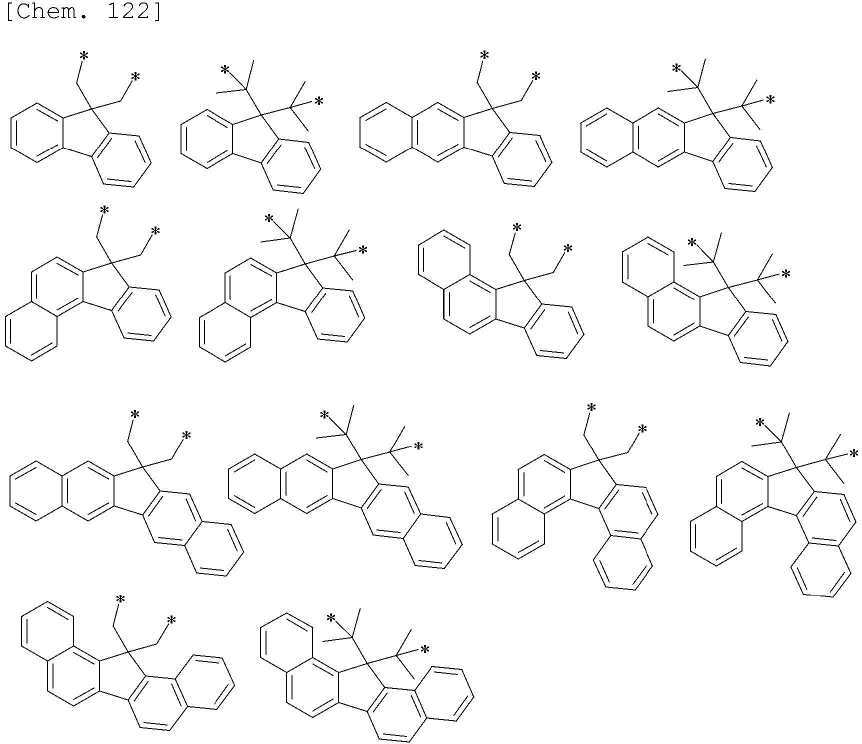

A case where in Formula (B3), only one of 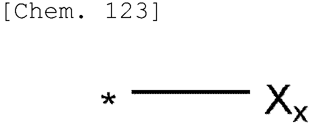 in Formula (B3) and 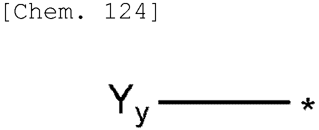 in Formula (B3) is bonded to any carbon atom (referred to as "carbon atom Z") constituting the non-Hückel single ring of Z (when x=1 and y=1) or extends from the carbon atom Z (when x=0 and y=0) will be described below.

As a more specific structure of Formula (B3) in this case, for example, in Formula (C31) below, among p, k₁, and k₂ that can form bonding sites, a unit structure (B) represented by Formula (B3) can be obtained by p and k₁ or p and k₂. The remaining bonding sites are bonded to hydrogen atoms.

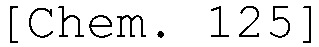

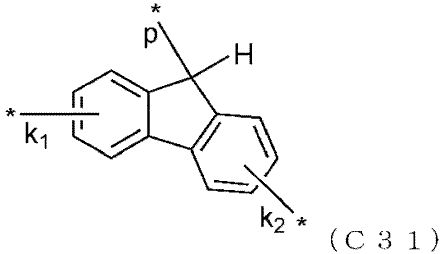

In addition, in Formula (C32) below, among p, k₁, k₂, and m that can form bonding sites, p and k₁, p and k₂, or p and m can form a unit structure (B) represented by Formula (B3). The remaining bonding sites are bonded to hydrogen atoms.

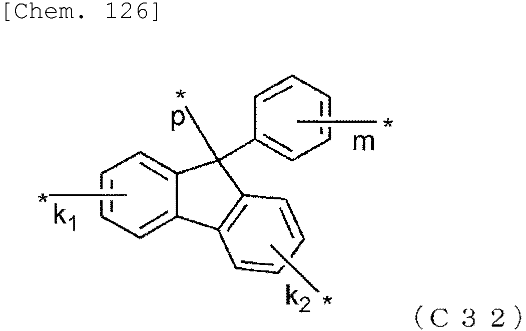

More specific various examples of Formula (B3) corresponding to Formula (C31) or (C32) are as follows. * represents a binding site with the unit structure (A).

In Formula (B3), a bond that bonds to another unit structure (for example, the unit structure (A)) separately extends from the aromatic ring in these structures, but such bonding sites are omitted in the following specific examples. Needless to say, the structure may be a unit structure including the exemplary structure as a part of the whole.

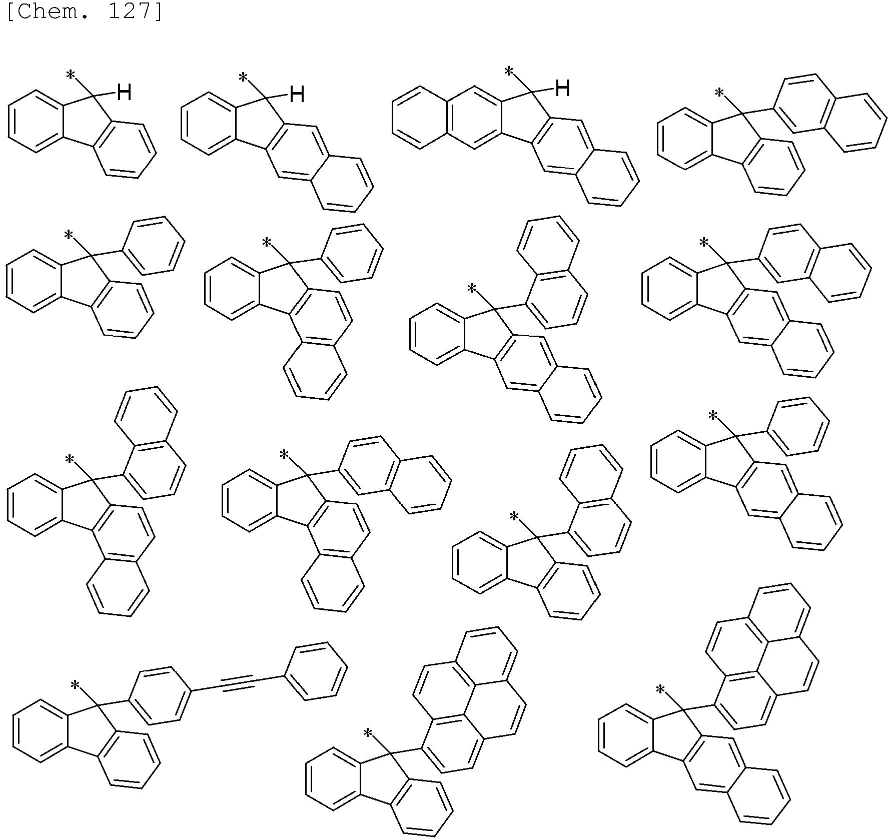

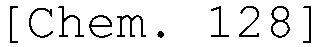

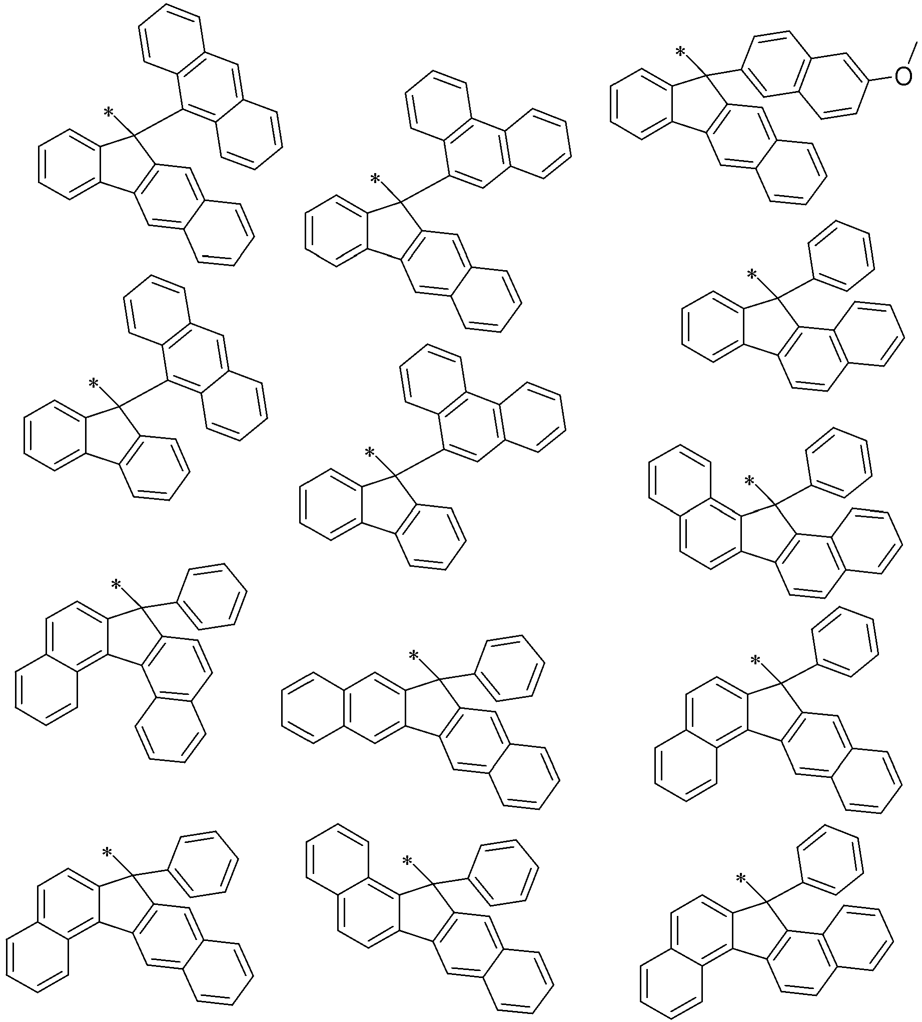

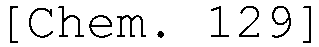

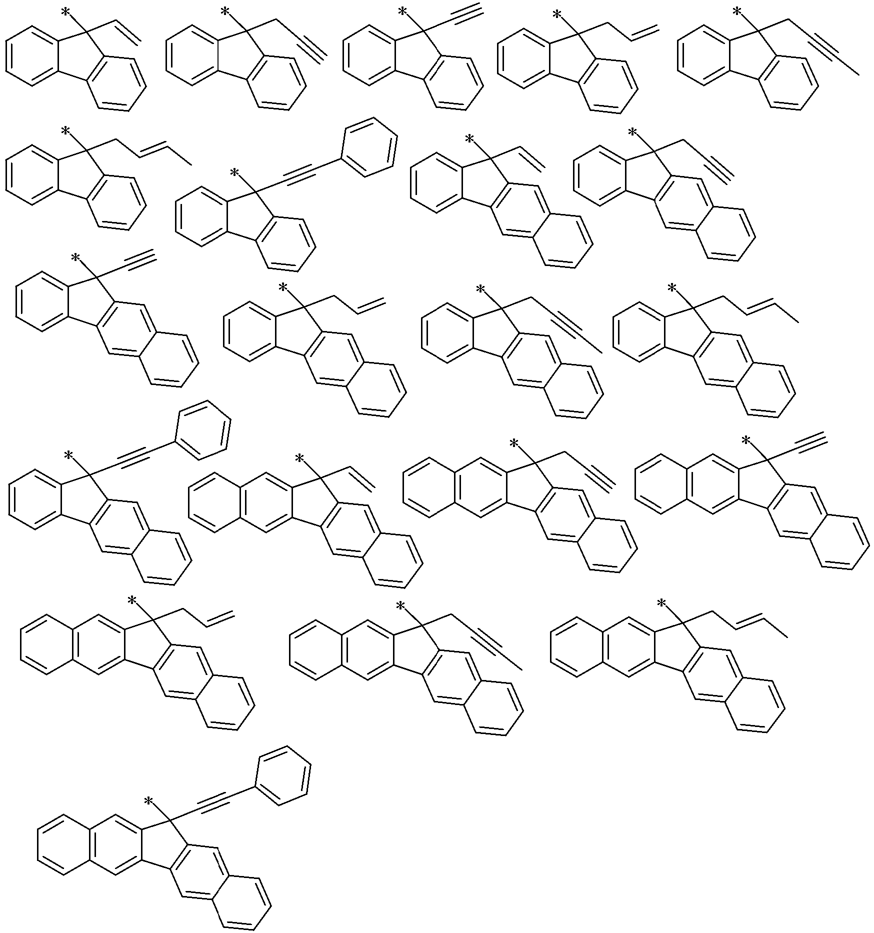

In the above specific examples, when there is no bonding site from the aromatic ring, such a structure can be a specific example of a polymer terminal.

### <<<B-6: Formula (B4)>>>

The unit structure (B-II) includes, for example, a structure represented by the following Formula (B4). The unit structure (B-II) may be a structure represented by the following Formula (B4).

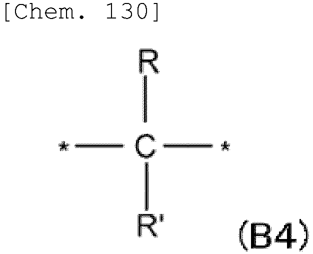

In Formula (B4), R and R' each independently represent a hydrogen atom, an aromatic ring having 5 to 30 carbon atoms which may have a substituent, a heterocyclic ring having 3 to 30 carbon atoms which may have a substituent, or a linear or branched alkyl group having 10 or less carbon atoms which may have a substituent. R and R' may form a structure having a ring structure together with a carbon atom to which they are bonded. * represents a bonding site.

Examples of the substituent include a hydroxy group, a carboxy group, a formyl group, a nitro group, an alkyl group, an alkoxy group, an aryl group, an aryloxy group, a cyano group, a group in which H of a hydroxy group is substituted with the substituent (S) above, and a halo group.

In addition, the two bonding sites of Formula (B4) can each be covalently bonded to each aromatic ring in the two unit structures (A).

In the definitions of R and R' in Formula (B4), the above (I-3) and (I-4) can be referred to for the "aromatic ring" and the "heterocyclic ring".

In the definitions of R and R' in Formula (B4), examples of the "alkyl group" include groups similar to those for R and R' in Formula (B1).

Preferably, R and R' are each independently phenyl, naphthalenyl, anthracenyl, phenanthrenyl, naphthacenyl, or pyrenyl.

Examples of the structures having a ring structure formed by R and R' together with a carbon atom bonded thereto include the structures represented by the following formula: 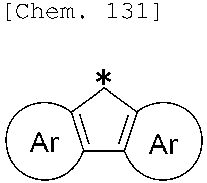 (where each Ar independently represents a residue of an aromatic ring, the carbon atom represented by * is a carbon atom bonded to R and R' in Formula (B4).)

Examples of the aromatic ring of Ar include an aromatic ring represented by Formula (G1).

The unit structure (B-II) including the structure represented by Formula (B4) is derived from, for example, an aldehyde compound or a ketone compound.

Examples of the aldehyde compound include the compound represented by Formula (B-1a) described above.

Examples of the ketone compound include the compound represented by Formula (B-1b) described above.

Some specific examples of the unit structure (B-II) including the structure represented by Formula (B4) are as follows. * basically indicates a binding site with the unit structure (A). Needless to say, the structure may include the exemplary structure as a part of the whole.

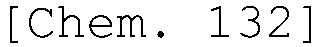

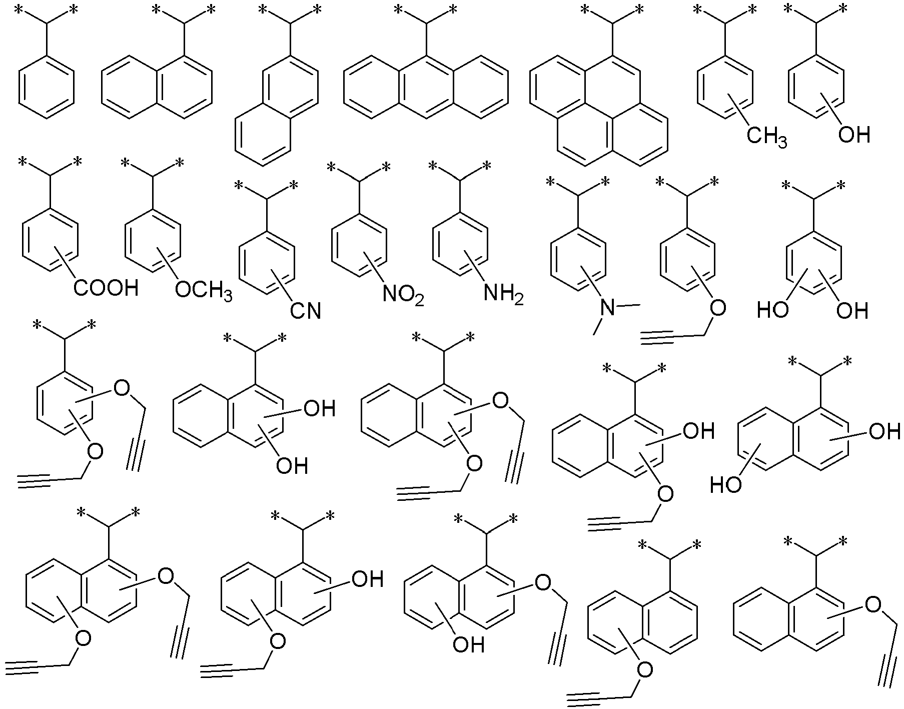

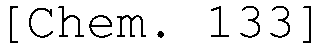

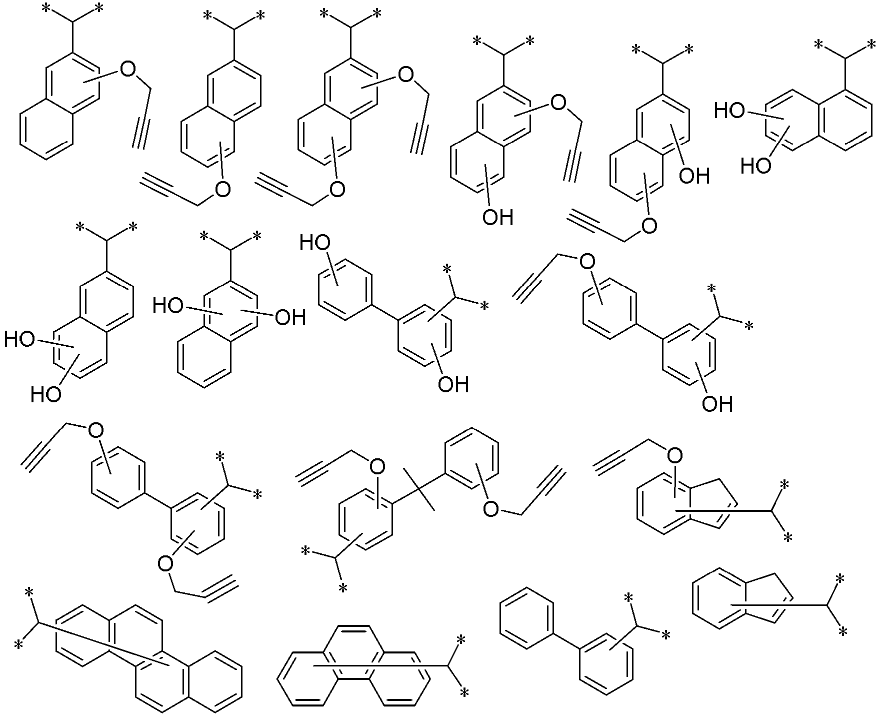

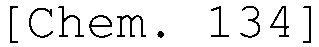

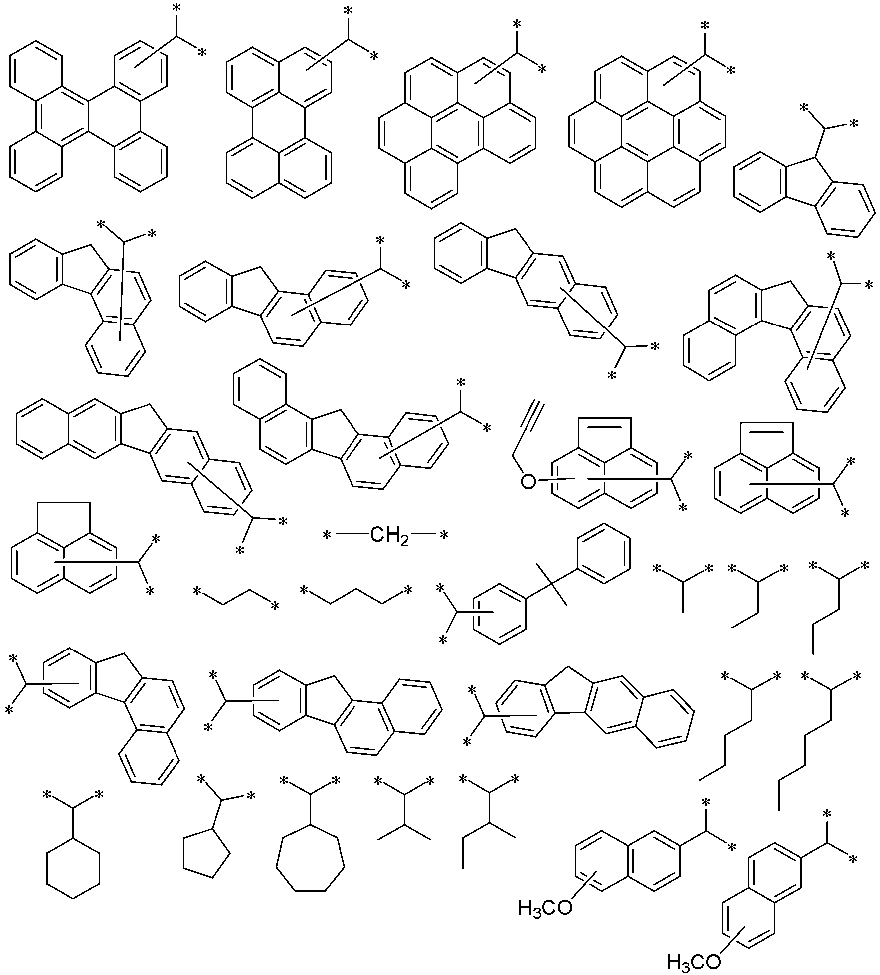

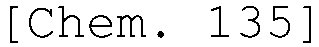

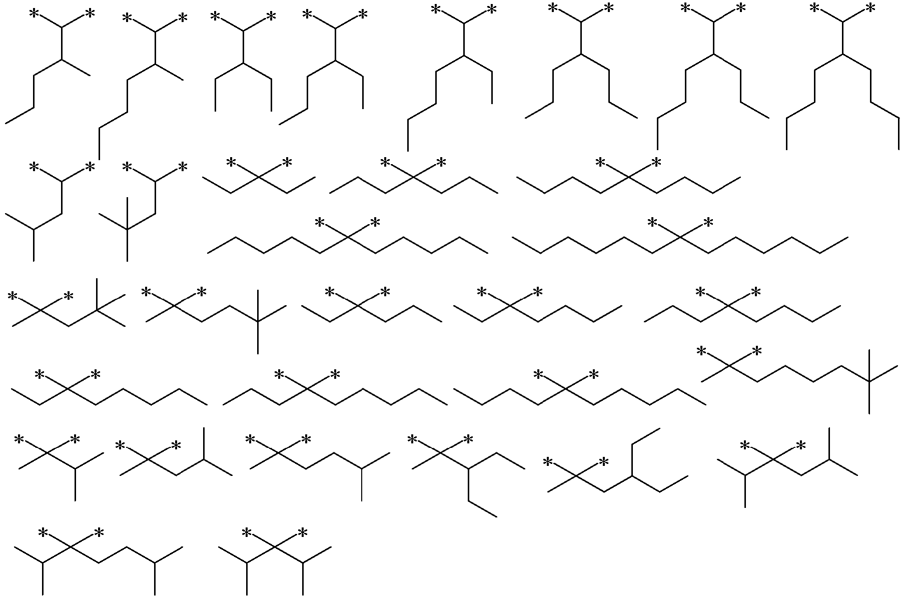

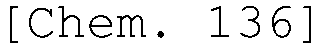

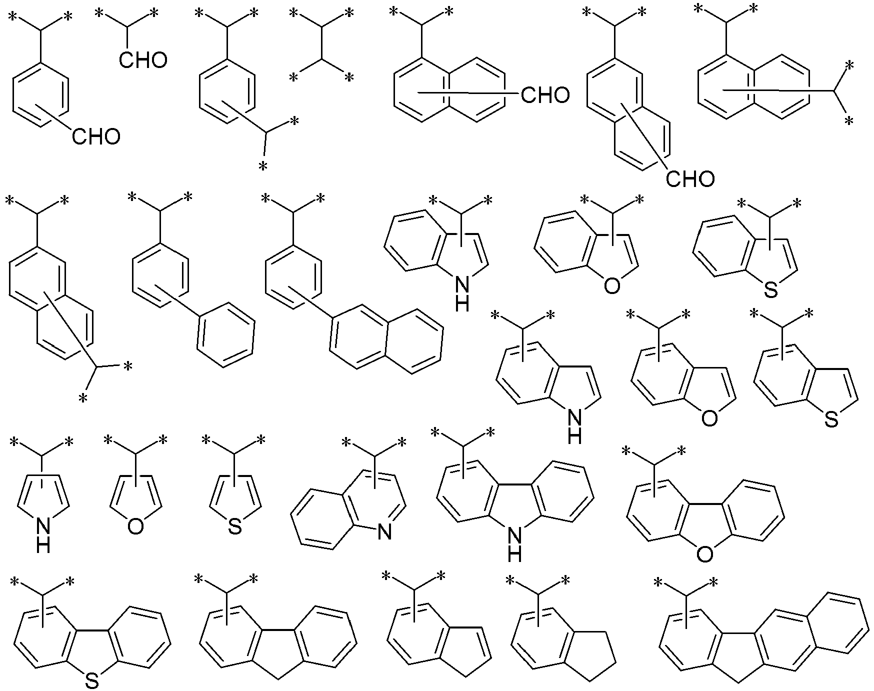

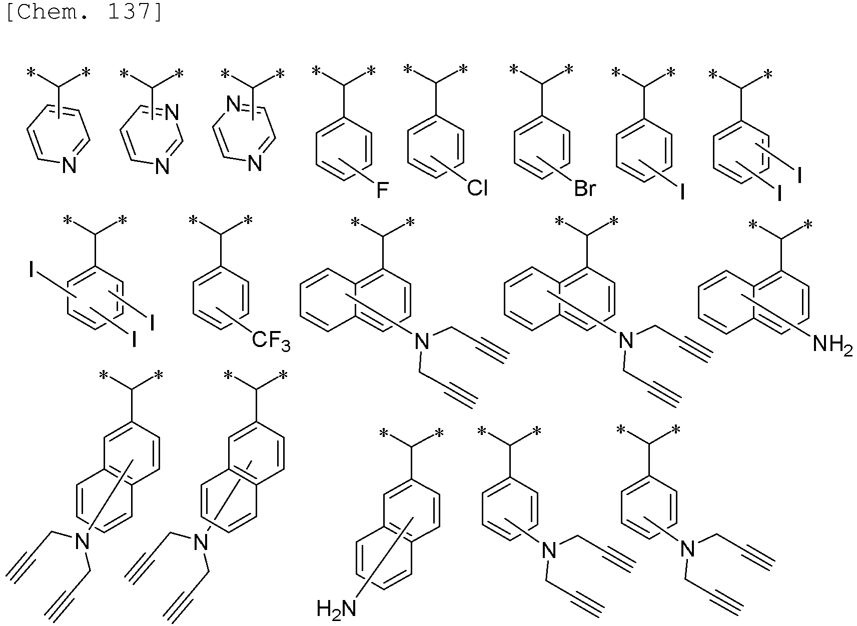

The novolac resin having the structure represented by Formula (AB) can be prepared by a known method. For example, it can be prepared by condensing a ring-containing compound represented by H-A-H with an oxygen-containing compound represented by OHC-B, O=C-B, RO-B-OR, RO-CH₂-B-CH₂-OR, or the like. Here, in the formula, A and B have the same meaning as described above. R represents a hydrogen atom, halogen, or an alkyl group having about 1 to 3 carbon atoms.

For both the ring-containing compound and the oxygen-containing compound, one kind may be used alone, or two or more kinds may be used in combination. In this condensation reaction, the oxygen-containing compound can be used in a ratio of 0.1 to 10 mol, preferably 0.1 to 2 mol with respect to 1 mol of the ring-containing compound.

As the catalyst used in the condensation reaction, for example, mineral acids such as sulfuric acid, phosphoric acid, and perchloric acid, organic sulfonic acids such as p-toluenesulfonic acid, p-toluenesulfonic acid monohydrate, methanesulfonic acid, and trifluoromethanesulfonic acid, and carboxylic acids such as formic acid and oxalic acid can be used. The use amount of the catalyst varies depending on the type of the catalyst to be used, but is usually 0.001 to 10,000 parts by mass, preferably 0.01 to 1,000 parts by mass, and more preferably 0.05 to 100 parts by mass with respect to 100 parts by mass of the ring-containing compound (in the case of two or more kinds, the total thereof).

The condensation reaction is also performed without a solvent, but is usually performed using a solvent. The solvent is not particularly limited as long as it can dissolve the reactive substrate and does not inhibit the reaction. Examples thereof include 1,2-dimethoxyethane, diethylene glycol dimethyl ether, propylene glycol monomethyl ether, propylene glycol monomethyl ether acetate, tetrahydrofuran, tetrahydropyran, dioxane, 1,2-dichloromethane, 1,2-dichloroethane, toluene, N-methylpyrrolidone, and dimethylformamide. The condensation reaction temperature is usually 40°C to 200°C, and preferably 100°C to 180°C. The reaction time varies depending on the reaction temperature, but is usually 5 minutes to 50 hours, and preferably 5 minutes to 24 hours.

The weight average molecular weight of the novolac resin according to an aspect of the present invention is usually 500 to 100,000, and preferably 600 to 50,000, 700 to 10,000, or 800 to 8,000.

The content of the resin (G) in the resist underlayer film-forming composition is, for example, preferably 25 to 100 mass%, more preferably 50 to 100 mass%, and still more preferably 70 to 100 mass% with respect to the mass of the film-forming component.

Here, the film-forming component refers to a component obtained by removing a solvent component from the resist underlayer film-forming composition.

The molar ratio between the unit structure (A) and the unit structure (B) in the resin (G) is, for example, preferably 30:70 to 50:50, more preferably 40:60 to 50:50, and still more preferably 50:55 to 50:50.

The molar ratio between the unit structure (A) and the unit structure (B) in the resin (G) can also be represented by a molar ratio between the compound (A) serving as a raw material of the unit structure (A) and the compound (B) serving as a raw material of the unit structure (B).

The molar ratio between the compound (A) and the compound (B) is, for example, preferably 30:70 to 50:50, more preferably 40:60 to 50:50, and still more preferably 50:55 to 50:50. Here, the compound (A) may be used singly or in combination of two or more kinds thereof. Similarly, the compound (B) may be used singly or in combination of two or more kinds thereof.

The content ratio (molar ratio) of the unit structure (A-I) in the unit structure (A) is preferably 10 mol% or more, more preferably 20 mol% or more, still more preferably 30 mol% or more, further still more preferably 40 mol% or more, further still more preferably 50 mol% or more, further still more preferably 60 mol% or more, further still more preferably 70 mol% or more, further still more preferably 80 mol% or more, further still more preferably 90 mol% or more, and may be 100 mol%.

The content ratio (molar ratio) of the unit structure (A-I) in the unit structure (A) can also be represented by the molar ratio of the compound (A-I) to be a raw material of the unit structure (A-I) in the compound (A).

The molar ratio of the compound (A-I) in the compound (A) is preferably 10 mol% or more, more preferably 20 mol% or more, still more preferably 30 mol% or more, further still more preferably 40 mol% or more, further still more preferably 50 mol% or more, further still more preferably 60 mol% or more, further still more preferably 70 mol% or more, further still more preferably 80 mol% or more, further still more preferably 90 mol% or more, and may be 100 mol%.

The content ratio (molar ratio) of the unit structure (B-I) in the unit structure (B) is preferably 10 mol% or more, more preferably 20 mol% or more, still more preferably 30 mol% or more, further still more preferably 40 mol% or more, further still more preferably 50 mol% or more, further still more preferably 60 mol% or more, further still more preferably 70 mol% or more, further still more preferably 80 mol% or more, further still more preferably 90 mol% or more, and may be 100 mol%.

The content ratio (molar ratio) of the unit structure (B-I) in the unit structure (B) can also be represented by a molar ratio of the compound (B-I) serving as a raw material of the unit structure (B-I) in the compound (B).

The molar ratio of the compound (B-I) in the compound (B) is preferably 10 mol% or more, more preferably 20 mol% or more, still more preferably 30 mol% or more, further still more preferably 40 mol% or more, further still more preferably 50 mol% or more, further still more preferably 60 mol% or more, further still more preferably 70 mol% or more, further still more preferably 80 mol% or more, further still more preferably 90 mol% or more, and may be 100 mol%.

The resin (G) is preferably a resin synthesized by polymerizing at least one compound having a biphenyl skeleton and at least one aromatic ketone or aliphatic ketone in the presence of an acid catalyst.

Examples of the aromatic ketone or the aliphatic ketone include the ketone compounds described in the above (B-3).

Examples of the acid catalyst include at least one selected from the group consisting of an acid, a salt thereof, and an acid generator, which will be described later.

### <Solvent>

The resist underlayer film-forming composition, which is an aspect of the present invention, includes a solvent.

The solvent is not particularly limited as long as it can dissolve the specific novolac resin and other optional components added as necessary.

Examples of the solvent include methyl cellosolve acetate, ethyl cellosolve acetate, propylene glycol, propylene glycol monomethyl ether, propylene glycol monoethyl ether, propylene glycol monopropyl ether, methyl isobutyl carbinol, propylene glycol monobutyl ether, propylene glycol monomethyl ether acetate, propylene glycol monoether ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether, ethylene glycol monoethyl ether, ethylene glycol monopropyl ether, ethylene glycol monobutyl ether, ethylene glycol monomethyl ether acetate, ethylene glycol monoethyl ether acetate, ethylene glycol monopropyl ether acetate, ethylene glycol monobutyl ether acetate, diethylene glycol monomethyl ether, diethylene glycol monoethyl ether, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, methyl 2-hydroxy-2-methylpropionate, ethyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methylpyrrolidone, 4-methyl-2-pentanol, and γ-butyrolactone. These solvents can be used alone or two or more types thereof can be used in combination.

In addition, a solvent having a boiling point of 160°C or higher can be included in combination with a solvent having a boiling point of less than 160°C.

As such a high boiling point solvent, for example, the following compounds described in WO 2018/131562 (A1) can be preferably used. 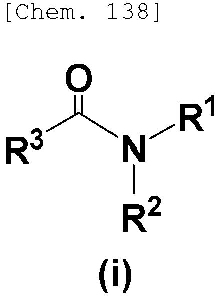 [R¹, R² and R³ in Formula (i) each represent a hydrogen atom or an alkyl group having 1 to 20 carbon atoms which may be interrupted by an oxygen atom, a sulfur atom, or an amide bond, may be the same or different, and may be bonded to each other to form a ring structure.]

Alternatively, 1,6-diacetoxyhexane (boiling point: 260°C), tripropylene glycol monomethyl ether (boiling point: 242°C) described in JP 2021-84974 A, and various other high boiling point solvents described in paragraph 0082 of the above-mentioned publication can be preferably used.

Alternatively, dipropylene glycol monomethyl ether acetate (boiling point: 213°C), diethylene glycol monoethyl ether acetate (boiling point: 217°C), diethylene glycol monobutyl ether acetate (boiling point: 247°C), dipropylene glycol dimethyl ether (boiling point: 171°C), dipropylene glycol monomethyl ether (boiling point: 187°C), dipropylene glycol monobutyl ether (boiling point: 231°C), tripropylene glycol monomethyl ether (boiling point: 242°C), γ-butyrolactone (boiling point: 204°C), benzyl alcohol (boiling point: 205°C), propylene carbonate (boiling point: 242°C), tetraethylene glycol dimethyl ether (boiling point: 275°C), 1,6-diacetoxyhexane (boiling point: 260°C), dipropylene glycol (boiling point: 230°C), and 1,3-butylene glycol diacetate (boiling point: 232°C) described in JP 2019-20701 A, and various other high boiling point solvents described in paragraphs 0023 to 0031 of the publication can be preferably used.

The resist underlayer film-forming composition, which is an aspect of the present invention, can include an acid and/or a salt thereof and/or an acid generator.

Examples of the acid include p-toluenesulfonic acid, trifluoromethanesulfonic acid, salicylic acid, 5-sulfosalicylic acid, 4-phenolsulfonic acid, camphorsulfonic acid, 4-chlorobenzenesulfonic acid, benzenedisulfonic acid, 1-naphthalenesulfonic acid, citric acid, benzoic acid, hydroxybenzoic acid, and naphthalenecarboxylic acid.

As the salt, a salt of the above-described acid can also be used. The salt is not limited, but an ammonia derivative salt such as a trimethylamine salt or a triethylamine salt, a pyridine derivative salt, a morpholine derivative salt, or the like can be suitably used.

Only one kind of the acid and/or the salt thereof can be used, or two or more kinds thereof can be used in combination. The blending amount is usually 0.0001 to 20 mass%, preferably 0.0005 to 10 mass%, and more preferably 0.01 to 5 mass% with respect to the total solid content.

Examples of the acid generator include a thermal acid generator and a photoacid generator.

Examples of the thermal acid generator include 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (manufactured by King Industries), and SI-45, SI-60, SI-80, SI-100, SI-110, and SI-150 (manufactured by Sanshin Chemical Industry Co., Ltd.), and other organic sulfonic acid alkyl esters.

The photoacid generator generates an acid during exposure of the resist. Therefore, the acidity of the underlayer film can be adjusted. This is one method for matching the acidity of the underlayer film to the acidity of the upper layer resist. In addition, the pattern shape of the resist formed on the upper layer can be adjusted by adjusting the acidity of the underlayer film.

Examples of the photoacid generator contained in the resist underlayer film-forming composition of the present invention include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate, and the like.

Examples of the sulfonimide compound include N-(trifluoromethanesulfonyloxy)succinimide, N-(nonafluoro-normal-butanesulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

As the acid generator, only one type can be used, or two or more types can be used in combination.

When the acid generator is used, the proportion thereof is 0.01 to 10 parts by mass, 0.1 to 8 parts by mass, or 0.5 to 5 parts by mass with respect to 100 parts by mass of the solid content of the resist underlayer film-forming composition.

The resist underlayer film-forming composition, which is an aspect of the present invention, may include a crosslinking agent, a surfactant, a light absorbing agent, a rheology modifier, an adhesion aid, and the like, if necessary, in addition to the above.

Examples of the representative crosslinking agent include an aminoplast crosslinking agent and a phenoplast crosslinking agent.

As the crosslinking agent, a crosslinking agent having high heat resistance can be used. As the crosslinking agent having high heat resistance, a compound containing a crosslinking-forming substituent having an aromatic ring (for example, a benzene ring or a naphthalene ring) in the molecule can be preferably used.

Examples of the aminoplast crosslinking agent include highly alkylated, alkoxylated, or alkoxyalkylated melamine, benzoguanamine, glycoluril, urea, polymers thereof, and the like. Preferably, the crosslinking agent is a crosslinking agent having at least two crosslinking-forming substituents, and is a compound such as methoxymethylated glycoluril, butoxymethylated glycoluril, methoxymethylated melamine, butoxymethylated melamine, methoxymethylated benzoguanamine, butoxymethylated benzoguanamine, methoxymethylated urea, butoxymethylated urea, methoxymethylated thiourea, or methoxymethylated thiourea. In addition, condensates of these compounds can also be used.

It is preferably at least one selected from the group consisting of tetramethoxymethylglycoluril and hexamethoxymethylmelamine.

Specific examples are as follows.

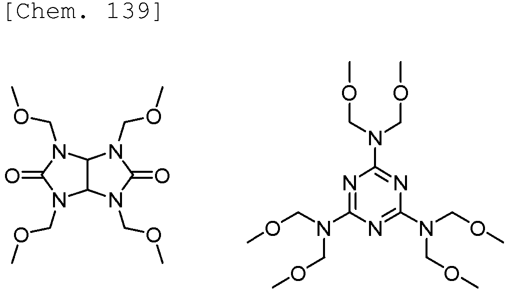

Examples of the phenoplast crosslinking agent include highly alkylated, alkoxylated, or alkoxyalkylated aromatics, polymers thereof, and the like. Preferably, the crosslinking agent is a compound having at least two crosslink-forming substituents in one molecule, such as 2,6-dihydroxymethyl-4-methylphenol, 2,4-dihydroxymethyl-6-methylphenol, bis(2-hydroxy-3-hydroxymethyl-5-methylphenyl)methane, bis(4-hydroxy-3-hydroxymethyl-5-methylphenyl)methane, 2,2-bis(4-hydroxy-3,5-dihydroxymethylphenyl)propane, bis(3-formyl-4-hydroxyphenyl) methane, bis(4-hydroxy-2,5-dimethylphenyl)formylmethane, or α,α-bis(4-hydroxy-2,5-dimethylphenyl)-4-formyltoluene. In addition, condensates of these compounds can also be used.

In addition to the above-mentioned compounds, examples of such a compound include a compound having a partial structure of the following Formula (4), and a polymer or oligomer having a repeating unit of the following Formula (5). 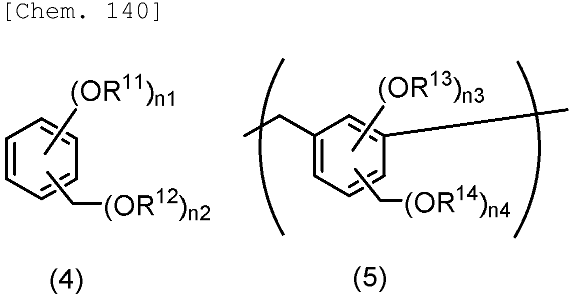 The R¹¹, R¹², R¹³, and R¹⁴ each represent a hydrogen atom or an alkyl group having 1 to 10 carbon atoms, and the above-described examples can be used for these alkyl groups. n1 represents an integer of 1 to 4, n2 represents an integer of 1 to (5 - n1), and (n1 + n2) represents an integer of 2 to 5. n3 represents an integer of 1 to 4, n4 represents an integer of 0 to (4 - n3), and (n3 + n4) represents an integer of 1 to 4. The oligomer and polymer can be used when the number of repeating unit structures is 2 to 100 or 2 to 50.

Specific examples are as follows.

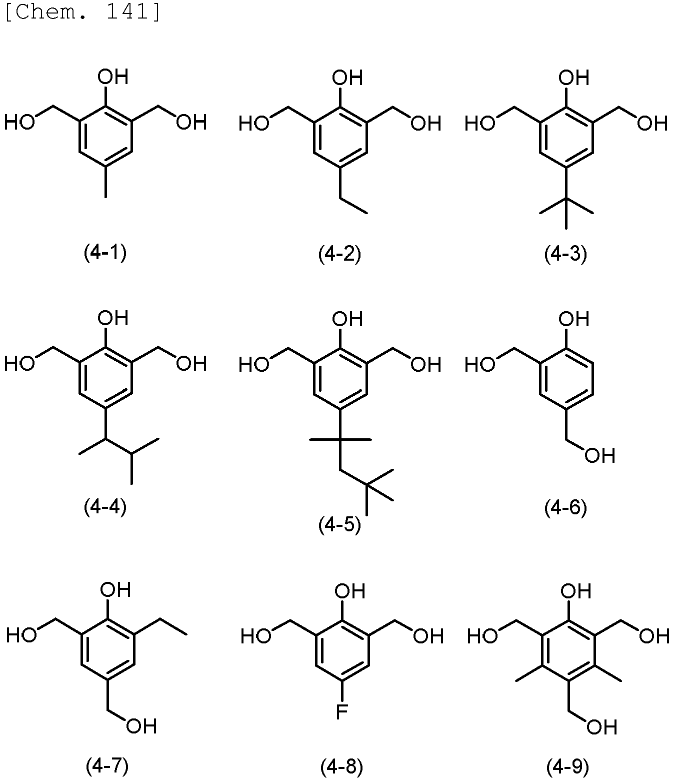

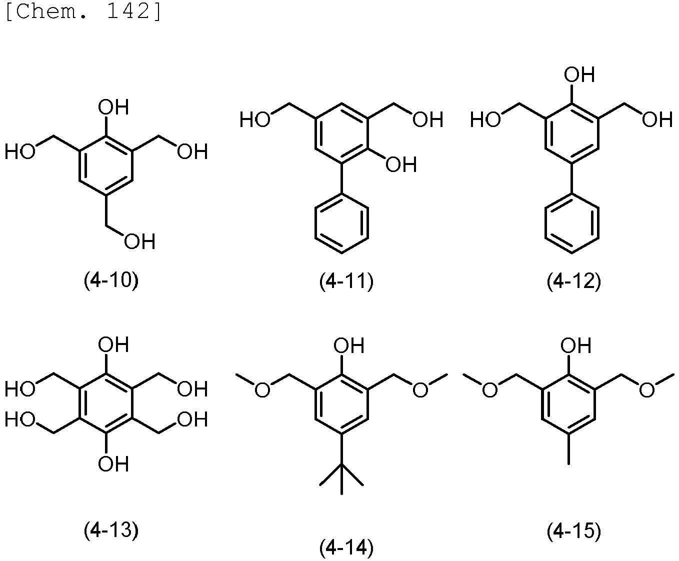

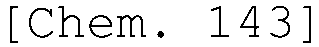

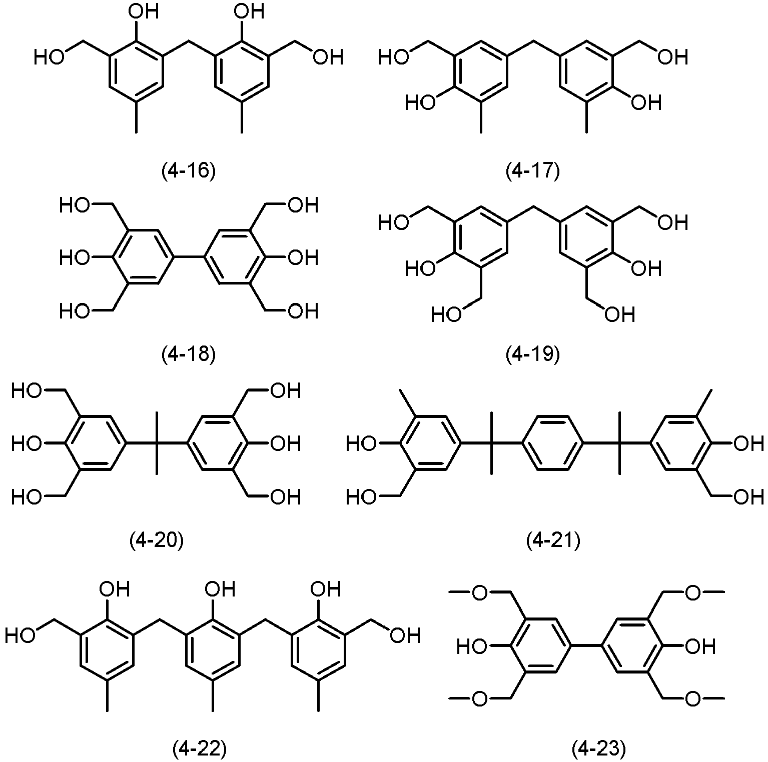

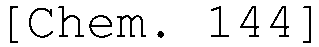

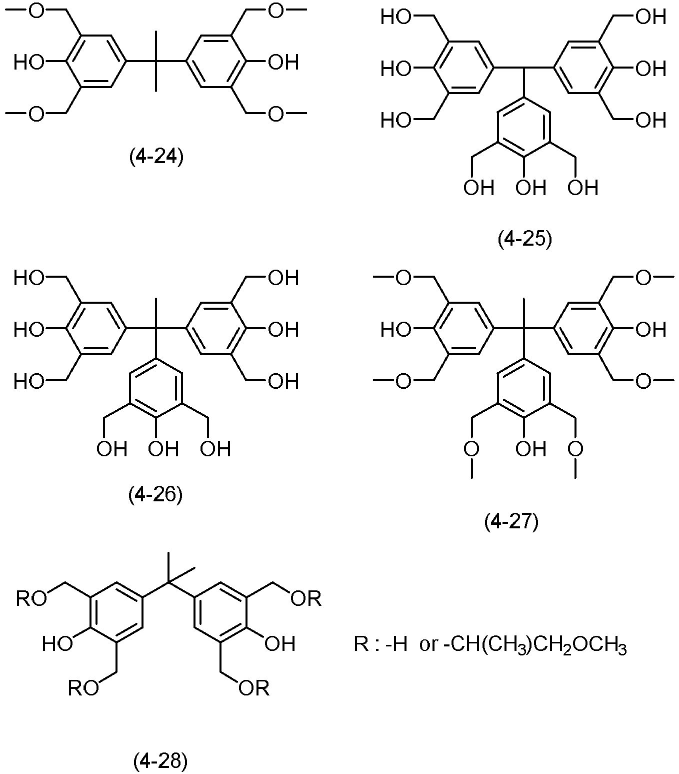

Any one of the crosslinking agents such as an aminoplast crosslinking agent and a phenoplast crosslinking agent may be used alone, or two or more thereof may be used in combination. The aminoplast crosslinking agent can be produced by a method known per se or a method similar thereto, and a commercially available product may be used.

In addition, the amount of the crosslinking agent such as an aminoplast crosslinking agent or a phenoplast crosslinking agent to be used varies depending on the coating solvent to be used, the base substrate to be used, the required solution viscosity, the required film shape, and the like, but is 0.001 mass% or more, 0.01 mass% or more, 0.05 mass% or more, 0.5 mass% or more, or 1.0 mass% or more, and 80 mass% or less, 50 mass% or less, 40 mass% or less, 20 mass% or less, or 10 mass% or less with respect to the total solid content of the resist underlayer film-forming composition according to the present invention.

In the resist underlayer film-forming composition according to the present invention, a surfactant can be blended in order to further improve the coatability for surface unevenness without generating pinholes, striations, and the like.

Examples of the surfactant include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl aryl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine surfactants such as EFTOP EF301, EF303, and EF352 (manufactured by Tokem Products, trade name), MEGAFACE F171, F173, R-30, and R-40 (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by AGC Inc., trade name); and organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition according to the present invention. These surfactants may be added alone, or two or more types thereof can also be added in combination.

As the light absorbing agent, commercially available light absorbing agents described in "Technique and Market of Industrial Pigments" (CMC Publishing Co., Ltd.) or "Dye Handbook" (edited by The Society of Synthetic Organic Chemistry, Japan), such as C.I. Disperse Yellow 1, 3, 4, 5, 7, 8, 13, 23, 31, 49, 50, 51, 54, 60, 64, 66, 68, 79, 82, 88, 90, 93, 102, 114, and 124; C.I. Disperse Orange 1, 5, 13, 25, 29, 30, 31, 44, 57, 72, and 73; C.I. Disperse Red 1, 5, 7, 13, 17, 19, 43, 50, 54, 58, 65, 72, 73, 88, 117, 137, 143, 199, and 210; C.I. Disperse Violet 43; C.I. Disperse Blue 96; C.I. Fluorescent Brightening Agent 112, 135, and 163; C.I. Solvent Orange 2 and 45; C.I. Solvent Red 1, 3, 8, 23, 24, 25, 27, and 49; C.I. Pigment Green 10; and C.I. Pigment Brown 2, can be suitably used. The light absorbing agent is usually blended in a ratio of 10 mass% or less, and preferably 5 mass% or less, with respect to the total solid content of the resist underlayer film-forming composition according to the present invention.

The rheology modifier is added mainly to improve fluidity of the resist underlayer film-forming composition, and in particular, to improve film thickness uniformity of the resist underlayer film or to enhance filling properties of the resist underlayer film-forming composition into holes in a baking step. Specific examples thereof include phthalic acid derivatives such as dimethyl phthalate, diethyl phthalate, diisobutyl phthalate, dihexyl phthalate, and butyl isodecyl phthalate; adipic acid derivatives such as dinormal butyl adipate, diisobutyl adipate, diisooctyl adipate, and octyl decyl adipate; maleic acid derivatives such as di(n-butyl) maleate, diethyl maleate, and dinonyl maleate; oleic acid derivatives such as methyl oleate, butyl oleate, and tetrahydrofurfuryl oleate; and stearic acid derivatives such as n-butyl stearate and glyceryl stearate. These rheology modifiers are usually blended in a ratio of less than 30 mass% with respect to the total solid content of the resist underlayer film-forming composition according to the present invention.

The adhesion assistant is mainly added to improve adhesion of the resist underlayer film-forming composition to a substrate or a resist, and in particular, to prevent peeling of the resist in development. Specific examples include chlorosilanes such as trimethylchlorosilane, dimethylvinylchlorosilane, methyldiphenylchlorosilane, and chloromethyldimethylchlorosilane; alkoxysilanes such as trimethylmethoxysilane, dimethyldiethoxysilane, methyldimethoxysilane, dimethylvinylethoxysilane, diphenyldimethoxysilane, and phenyltriethoxysilane; silazanes such as hexamethyldisilazane, N,N'-bis(trimethylsilyl)urea, dimethyltrimethylsilylamine, and trimethylsilylimidazole; silanes such as vinyltrichlorosilane, γ-chloropropyltrimethoxysilane, γ-aminopropyltriethoxysilane, and γ-glycidoxypropyltrimethoxysilane; heterocyclic compounds such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, and mercaptopyrimidine; ureas such as 1,1-dimethylurea and 1,3-dimethylurea; and thiourea compounds. These adhesion assistants are usually blended in a ratio of less than 5 mass%, and preferably less than 2 mass%, with respect to the total solid content of the resist underlayer film-forming composition according to the present invention.

The solid content of the resist underlayer film-forming composition according to the present invention is 0.1 to 70 mass% or 0.1 to 60 mass%. The solid content is a content ratio of all components excluding the solvent from the resist underlayer film-forming composition. The solid content may contain a crosslinkable resin in a proportion of 1 to 99.9 mass%, 50 to 99.9 mass%, 50 to 95 mass%, or 50 to 90 mass%.

### [Resist underlayer film]

The resist underlayer film can be formed, for example, as follows using the resist underlayer film-forming composition according to the present invention.

A resist underlayer film-forming composition, which is an aspect of the present invention, is applied onto a substrate (for example, a silicon wafer substrate, a silicon dioxide coated substrate (SiO₂ substrate), a silicon nitride substrate (SiN substrate), a silicon oxynitride substrate (SiON substrate), a titanium nitride substrate (TiN substrate), a tungsten substrate (W substrate), a glass substrate, an ITO substrate, a polyimide substrate, a low dielectric constant material (low-k material) coated substrate, and the like) used for producing a semiconductor device by an appropriate application method such as a spinner or a coater, and then baked using a heating means such as a hot plate to form a resist underlayer film. The baking conditions are appropriately selected from a baking temperature of 80°C to 800°C, and a baking time of 0.3 to 60 minutes. Preferably, the baking temperature is 150°C to 500°C, and the baking time is 0.5 to 2 minutes. As the atmospheric gas during baking, air may be used, and an inert gas such as nitrogen or argon may also be used. In one aspect, the oxygen concentration is particularly preferably 1% or less. Here, the film thickness of the underlayer film to be formed is, for example, 10 to 1,000 nm, 20 to 500 nm, 30 to 400 nm, or 50 to 300 nm. In addition, when a quartz substrate is used as the substrate, a replica (mold replica) of a quartz imprint mold can be produced.

In addition, an adhesion layer and/or a silicon-containing layer containing 99 mass% or less, or 50 mass% or less, of Si can also be formed by coating or vapor deposition on the resist underlayer film, which is an aspect of the present invention. For example, a Si-based inorganic material film can be formed by a CVD method or the like, in addition to methods of forming, by spin coating, an adhesion layer described in JP 2013-202982 A or JP 5827180 B, and a silicon-containing resist underlayer film (inorganic resist underlayer film) using the composition described in WO 2009/104552 (A1).

In addition, by applying the resist underlayer film-forming composition, which is an aspect of the present invention, onto a semiconductor substrate (so-called stepped substrate) having a portion having a step and a portion not having a step, and baking the composition, a step between the portion having a step and the portion not having a step can be reduced.

### [Method for producing semiconductor device]

(i) A method for manufacturing a semiconductor device, which is an aspect of the present invention, includes: a step of forming a resist underlayer film on a semiconductor substrate using the resist underlayer film-forming composition which is an aspect of the present invention; a step of forming a resist film on the resist underlayer film; a step of forming a resist pattern by irradiating the resist film with light or an electron beam and developing the resist film; a step of etching the resist underlayer film through the resist pattern to form a patterned resist underlayer film; and a step of processing the semiconductor substrate through the patterned resist underlayer film.
(ii) In addition, a method for manufacturing a semiconductor device, which is an aspect of the present invention, includes: a step of forming a resist underlayer film on a semiconductor substrate using the resist underlayer film-forming composition which is an aspect of the present invention; a step of forming a hard mask on the resist underlayer film; a step of further forming a resist film on the hard mask; a step of forming a resist pattern by irradiating the resist film with light or an electron beam and developing the resist film; a step of etching the hard mask through the resist pattern to form a patterned hard mask; a step of etching the resist underlayer film through the patterned hard mask to form a patterned resist underlayer film; and a step of processing the semiconductor substrate through the patterned resist underlayer film.
(iii) In addition, a method for manufacturing a semiconductor device, which is an aspect of the present invention, includes: a step of forming a resist underlayer film on a semiconductor substrate using the resist underlayer film-forming composition which is an aspect of the present invention; a step of forming a hard mask on the resist underlayer film; a step of further forming a resist film on the hard mask; a step of forming a resist pattern by irradiating the resist film with light or an electron beam and developing the resist film; a step of etching the hard mask through the resist pattern to form a patterned hard mask; a step of etching the resist underlayer film through the patterned hard mask to form a patterned resist underlayer film; a step of removing the hard mask; and a step of processing the semiconductor substrate through the patterned resist underlayer film.
(iv) In addition, a method for manufacturing a semiconductor device, which is an aspect of the present invention, includes: a step of forming a resist underlayer film on a semiconductor substrate using the resist underlayer film-forming composition which is an aspect of the present invention; a step of forming a hard mask on the resist underlayer film; a step of further forming a resist film on the hard mask; a step of forming a resist pattern by irradiating the resist film with light or an electron beam and developing the resist film; a step of etching the hard mask through the resist pattern to form a patterned hard mask; a step of etching the resist underlayer film through the patterned hard mask to form a patterned resist underlayer film; a step of removing the hard mask; a step of forming a deposited film (spacer) on the resist underlayer film after the removal of the hard mask; a step of processing the deposited film (spacer) by etching; a step of removing the patterned resist underlayer film to leave a patterned deposited film (spacer); and a step of processing the semiconductor substrate through the patterned deposited film (spacer).

The semiconductor substrate can be processed using the producing methods (i) to (iv).

The step of forming a resist underlayer film using the resist underlayer film-forming composition according to an aspect of the present invention is as described above in [resist underlayer film].

A hard mask such as a silicon-containing film may be formed as a second resist underlayer film on the resist underlayer film formed in the above step, and a resist pattern may be formed thereon [the above (ii) to (iv)].

The hard mask may be a coating film of an inorganic substance or the like, or a deposited film of an inorganic substance or the like formed by a vapor deposition method such as CVD or PVD, and examples thereof include a SiON film, a SiN film, and a SiO₂ film.

Furthermore, an antireflective film (BARC) may be formed on the hard mask, or a resist shape correction film having no antireflection performance may be formed.

In the step of forming the resist pattern, exposure is performed through a mask (reticle) for forming a predetermined pattern or by direct drawing. As an exposure source, for example, a g-line, an i-line, a KrF excimer laser, an ArF excimer laser, an EUV, or an electron beam can be used. After the exposure, Post Exposure Bake is performed as necessary. Thereafter, development is performed with a developer (for example, 2.38 mass% aqueous tetramethylammonium hydroxide solution, butyl acetate), and rinsing is further performed with a rinse liquid or pure water to remove the used developer. Thereafter, post-baking is performed to dry the resist pattern and enhance adhesion to the base.

The etching step performed after the resist pattern is formed is performed by dry etching.

Note that the following gases, that is, CF₄, CHF₃, CH₂F₂, CH₃F, C₄F₆, C₄F₈, O₂, N₂O, NO₂, H₂, and He can be used for processing the hard mask (silicon-containing layer), the resist underlayer film, and the substrate. These gases may be used alone or as a mixture of two or more kinds of gases. Furthermore, argon, nitrogen, carbon dioxide, carbonyl sulfide, sulfur dioxide, neon, or nitrogen trifluoride can be mixed with these gases and used.

The resist film may be patterned by a nanoimprint method or a self-assembled film method.

In the nanoimprint method, a resist composition is shaped using a patterned mold that is transparent to irradiation light. In addition, in the self-assembled film method, a pattern is formed using a self-assembled film that naturally forms a regular structure on the order of nanometers, such as a diblock polymer (polystyrene-polymethyl methacrylate or the like).

In the nanoimprint method, before a curable composition to be a resist film is applied, a silicon-containing layer (hard mask layer) may be optionally formed on the resist underlayer film by coating or vapor deposition, an adhesion layer may be formed on the resist underlayer film or the silicon-containing layer (hard mask layer) by coating or vapor deposition, and the curable composition to be a resist film may be applied on the adhesion layer.

Note that wet etching processing may be performed for the purpose of simplifying the process steps and reducing damage to the processed substrate. This leads to suppression of variations in processing dimensions and reduction in pattern roughness, and enables processing of the substrate with high yield. Therefore, in the above (iii) to (iv), the removal of the hard mask can be performed by either etching or an alkaline chemical solution. In particular, when an alkaline chemical solution is used, the components are not limited, but as the alkaline component, those including the following are preferable.

Examples of the alkaline component include tetramethylammonium hydroxide, tetraethylammonium hydroxide, tetrapropylammonium hydroxide, tetrabutylammonium hydroxide, methyltripropylammonium hydroxide, methyltributylammonium hydroxide, ethyltrimethylammonium hydroxide, dimethyldiethylammonium hydroxide, benzyltrimethylammonium hydroxide, hexadecyltrimethylammonium hydroxide, (2-hydroxyethyl)trimethylammonium hydroxide, monoethanolamine, diethanolamine, triethanolamine, 2-(2-aminoethoxy)ethanol, N,N-dimethylethanolamine, N,N-diethylethanolamine, N,N-dibutylethanolamine, N-methylethanolamine, N-ethylethanolamine, N-butylethanolamine, N-methyldiethanolamine, monoisopropanolamine, diisopropanolamine, triisopropanolamine, tetrahydrofurfurylamine, N-(2-aminoethyl)piperazine, 1,8-diazabicyclo[5.4.0]undecene-7, 1,4-diazabicyclo[2.2.2]octane, hydroxyethylpiperazine, piperazine, 2-methylpiperazine, trans-2,5-dimethylpiperazine, cis-2,6-dimethylpiperazine, 2-piperidinemethanol, cyclohexylamine, 1,5-diazabicyclo[4,3,0]nonene-5, and the like. In particular, from the viewpoint of handling, tetramethylammonium hydroxide and tetraethylammonium hydroxide are particularly preferable, and an inorganic base may be used in combination with a quaternary ammonium hydroxide. As the inorganic base, hydroxides of alkali metals such as potassium hydroxide, sodium hydroxide, and rubidium hydroxide are preferable, and potassium hydroxide is more preferable.

### Examples

Hereinafter, the present invention will be described more specifically with reference to Synthesis Examples, Examples, and Comparative Examples, but the present invention is not limited only to the following Examples.

The weight average molecular weights Mw of the resins shown in the following Synthesis Examples 1 to 9 are measurement results by gel permeation chromatography (hereinafter, abbreviated as GPC). In the measurement, a GPC apparatus manufactured by Tosoh Corporation was used, and measurement conditions and the like are as follows:
GPC column: TSKgel Super-MultiporeHZ-N (two columns)
Column temperature: 40°C
Solvent: tetrahydrofuran (THF)
Flow rate: 0.35 ml/min
Standard sample: Polystyrene (manufactured by Tosoh Corporation)

### [Synthesis of polymer]

For the synthesis of the structural formulae (S1) to (S7) as the polymer used for the resist underlayer film and the synthesis of the structural formulae (S'1) to (S'2) as comparative examples, the following compound group A, compound group B, compound group C, catalyst group D, solvent group E, and reprecipitation solvent group F were used.

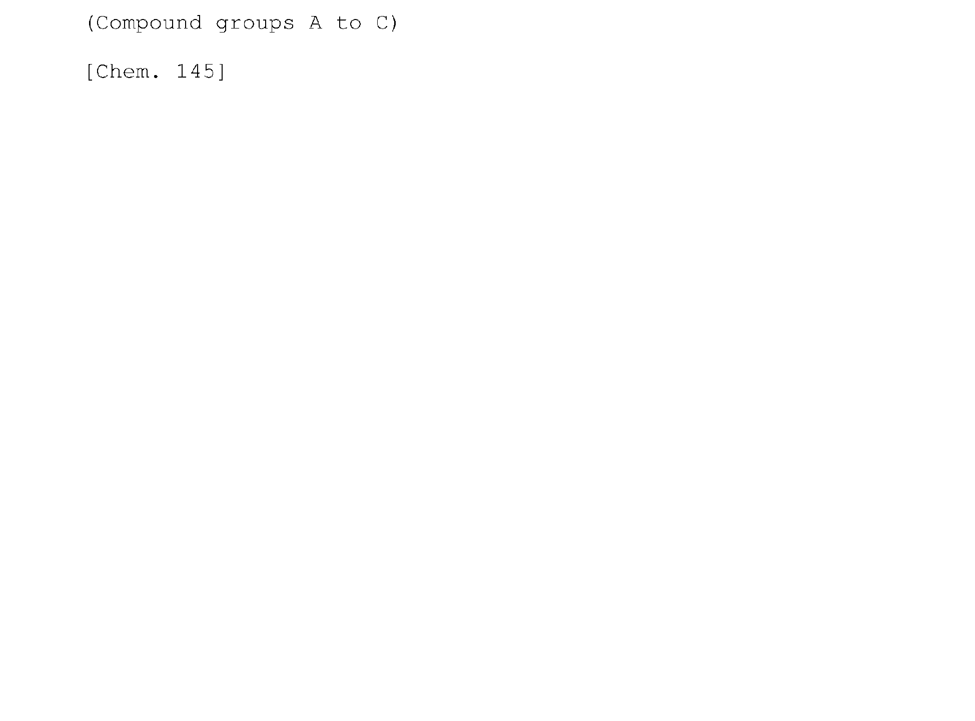

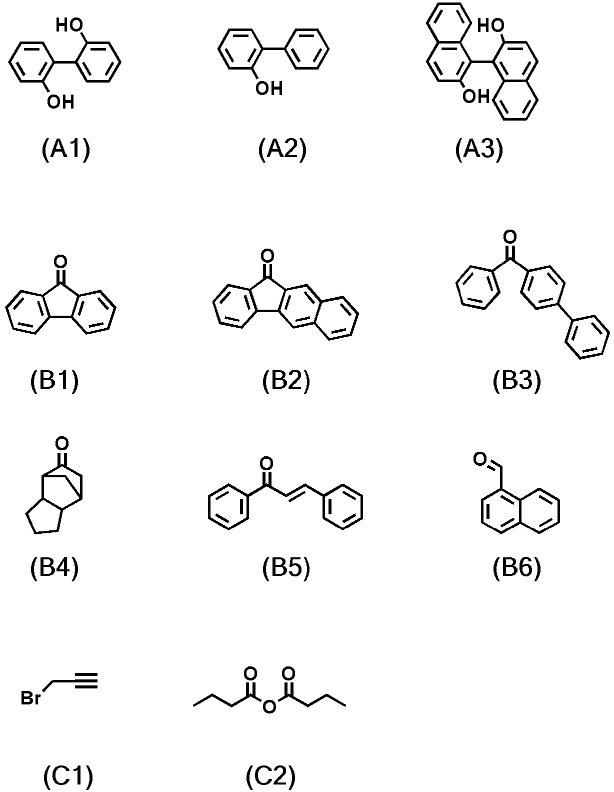

### (Catalyst group D)

Methanesulfonic acid: D1
3-Mercaptopropionic acid: D2
Tetrabutylammonium iodide: D3

### (Solvent group E)

Propylene glycol monomethyl ether acetate (=PGMEA): E1
Tetrahydrofuran: E2
25% aqueous sodium hydroxide solution: E3

### (Reprecipitation solvent group F)

Methanol: F1

### (Separation solvent group G)

Butyl acetate/water: G1

### [Synthesis Example 1]

Into a flask, 10.0 g of (A1), 9.7 g of (B1), 10.3 g of (D1), 1.1 g of (D2), and 25.5 g of (E1) were put. Thereafter, the mixture was heated at 100°C under nitrogen and was caused to react for about 20 hours. After the reaction was stopped, the mixture was reprecipitated with (F1) and dried to obtain a resin (S1). The weight average molecular weight Mw measured in terms of polystyrene by GPC was about 3,500. The obtained resin was dissolved in PGMEA, and ion exchange was performed for 4 hours using a cation exchange resin and an anion exchange resin to obtain a target compound solution.

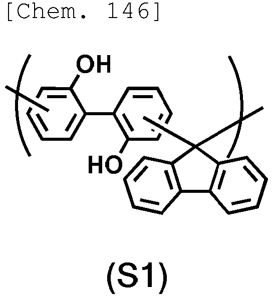

### [Synthesis Examples 2 to 7]

A resin used for a resist underlayer film was synthesized by changing the compound group A, the compound group B, the compound group C, the catalyst group D, the solvent group E, and the reprecipitation solvent group F. The experimental operation is the same as that in Synthesis Example 1. Synthesis was performed under the conditions described in Table 1 below to obtain Example resins (S2) to (S6), a Comparative Example resin (S'1), and solutions thereof. In Table 1, the upper part of the column of compound represents the type of compound used for the synthesis, and the lower part represents the mass of the compound. Similarly, the upper part of the column of catalyst and solvent represents the type of catalyst or solvent, and the lower part represents the mass thereof. The column of "Temperature/Time" represents the reaction temperature and the reaction time.

**[Table 1]**

| Synthesis Example | Resin | Compound | Catalyst | Solvent | Temperature/Time | Reprecipitation solvent | Weight-average molecular weight |
|---|---|---|---|---|---|---|---|
| 1 | S1 | A1/B1 | D1/D2 | E1 | 100°C/20 h | F1 | 3500 |
| | | 10.0 g/9.7 g | 10.3 g/1.1 g | 25.5g | | | |
| 2 | S2 | A1/A2/B2 | D1/D2 | E1 | 100°C/21 h | F1 | 2600 |
| | | 6.0 g/3.7 g/12.4 g | 5.2 g/0.6 g | 22.7g | | | |
| 3 | S3 | A1/B1/B3 | D1/D2 | E1 | 100°C/21 h | F1 | 2800 |
| | | 4.0 g/2.9 g/1.4 g | 4.1 g/0.5 g | 10.5g | | | |
| 4 | S4 | A1/B1/B4 | D1/D2 | E1 | 100°C/23 h | F1 | 2700 |
| | | 4.0 g/3.1 g/0.8 g | 4.1 g/0.5 g | 10.2g | | | |
| 5 | S5 | A1/B1/B5 | D1/D2 | E1 | 100°C/24 h | F1 | 2200 |
| | | 19.6 g/11.0 g/9.5 g | 20.2 g/2.2 g | 26.8g | | | |
| 6 | S6 | A1/A3/B1 | D1/D2 | E1 | 100°C/28 h | F1 | 2800 |
| | | 4.0 g/6.1 g/8.4 g | 4.5 g/0.5 g | 10.0g | | | |
| 7 | S'1 | A1/B6 | D1 | E1 | 120°C/4 h | F1 | 1700 |
| | | 7.5 g/12.6 g | 1.6g | 26.4g | | | |

The structural formulae of the obtained resins (S1) to (S6) and resin (S'1) are shown below.

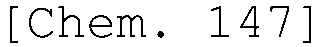

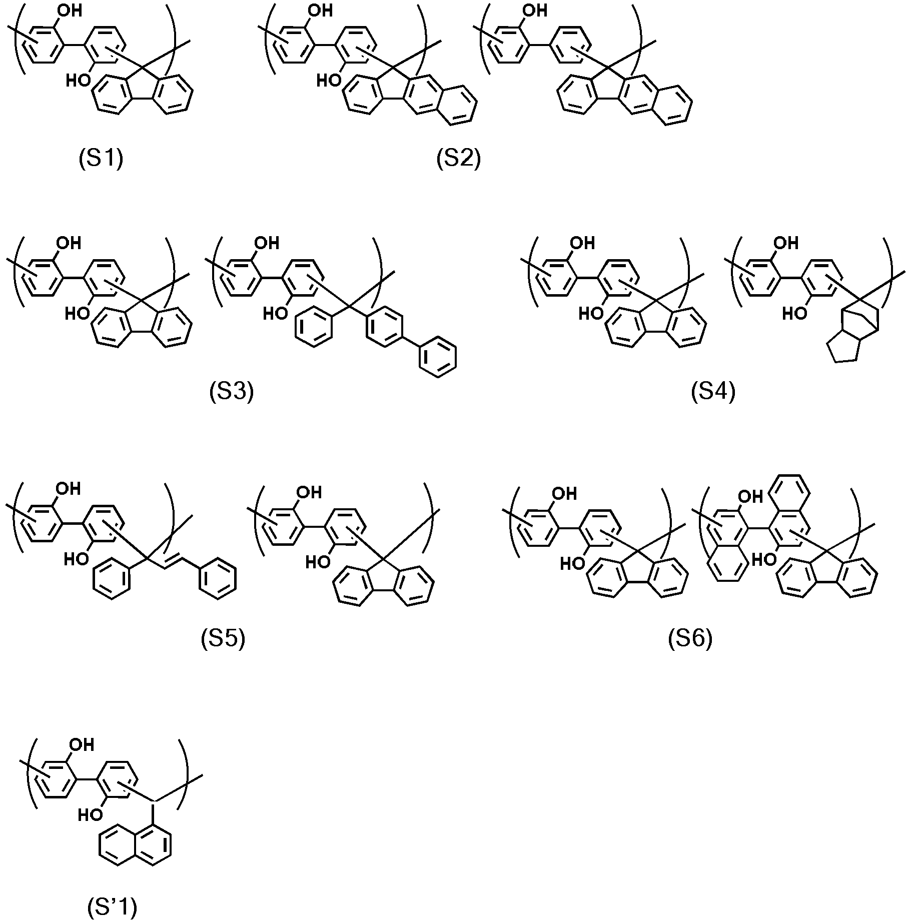

### [Synthesis Example 8]

Into a flask, 10.0 g of the resin (S1) obtained after the reprecipitation treatment in Synthesis Example 1, 6.8 g of (C4), 3.2 g of (D3), 25.0 g of (E2), and 27.6 g of (E3) were put. Thereafter, the mixture was heated to 55°C under nitrogen and was caused to react for about 24 hours. After the reaction was stopped, the liquid separation operation was repeated with (G1), and the organic phase was concentrated, redissolved in PGMEA, reprecipitated using (F1), and dried to obtain a resin (S7). The weight average molecular weight Mw measured in terms of polystyrene by GPC was about 5,300. The obtained resin was dissolved in PGMEA, and ion exchange was performed for 4 hours using a cation exchange resin and an anion exchange resin to obtain a target compound solution.

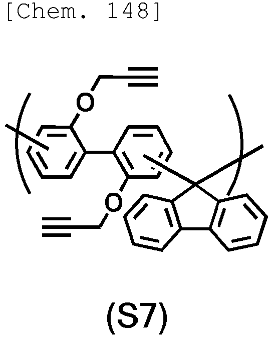

### [Synthesis Example 9]

Into a flask, 10.0 g of the resin (S1) obtained after the reprecipitation treatment in Synthesis Example 1, 11.4 g of (C2), and 30.0 g of (E1) were put. Thereafter, the mixture was heated to 100°C under nitrogen and was caused to react for about 24 hours. After the reaction was stopped, the mixture was concentrated, reprecipitated using (F1), and dried to obtain a resin (S8). The weight average molecular weight Mw measured in terms of polystyrene by GPC was about 7,300. The obtained resin was dissolved in PGMEA to obtain a target compound solution.

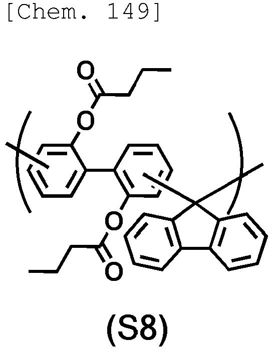

### [Preparation of resist underlayer film-forming composition]

Resins (S1) to (S7) and (S'1), a crosslinking agent (CL1), an acid generator (Ad1), solvents (propylene glycol monomethyl ether acetate (PGMEA) and propylene glycol monomethyl ether (PGME)), and MEGAFACE R-40 (manufactured by DIC Corporation, R-40) as a surfactant were mixed in the proportions shown in Table 2 below, and the mixtures were filtered through a 0.1 µm polytetrafluoroethylene microfilter to prepare resist underlayer film-forming compositions (M1 to M9 and Comparative M1 to M2).

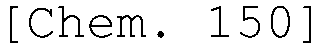

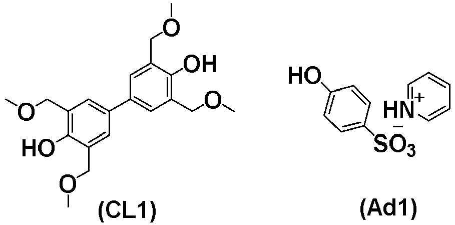

**[Table 2]**

| Composition | Resin | | Crosslinking agent | | Acid generator | | Surfactant | | Solvent (wt%) | |
|---|---|---|---|---|---|---|---|---|---|---|
| | Type | Parts by mass | Type | Parts by mass | Type | Parts by mass | Type | Parts by mass | PGMEA | PGME |
| M1 | S1 | 100 | - | - | - | - | R-40 | 0.1 | 35 | 15 |
| M2 | S1 | 100 | CL1 | 10 | Ad1 | 1 | R-40 | 0.1 | 35 | 15 |
| M3 | S2 | 100 | - | - | - | - | R-40 | 0.1 | 70 | 30 |
| M4 | S3 | 100 | - | - | - | - | R-40 | 0.1 | 70 | 30 |
| M5 | S4 | 100 | - | - | - | - | R-40 | 0.1 | 35 | 15 |
| M6 | S5 | 100 | - | - | - | - | R-40 | 0.1 | 40 | 20 |
| M7 | S6 | 100 | - | - | - | - | R-40 | 0.1 | 70 | 30 |
| M8 | S7 | 100 | - | - | - | - | R-40 | 0.1 | 70 | 30 |
| M9 | S8 | 100 | - | - | - | - | R-40 | 0.1 | 40 | 20 |
| Comparative M1 | S'1 | 100 | - | - | - | - | R-40 | 0.1 | 35 | 15 |
| Comparative M2 | S'1 | 100 | CL1 | 10 | Ad1 | 1 | R-40 | 0.1 | 35 | 15 |

### [Elution test in resist solvent]

### [Examples 1 to 9 and Comparative Examples 1 and 2]

The concentrations of the resist underlayer film-forming compositions of M1 to M9 and Comparative M1 to M2 were adjusted so that the film thickness of a film obtained by baking them at 400°C for 60 seconds was about 100 nm. Using a coating and developing apparatus (ACT-8) manufactured by Tokyo Electron Limited, each resist underlayer film-forming composition was applied onto a silicon wafer and baked in the air at the predetermined temperature for the predetermined time described in Table 3 to form a resist underlayer film of 100 nm. The formed resist underlayer film was immersed for 60 seconds in a PGME/PGMEA mixed solution (mass ratio = 7/3), which is a general-purpose thinner, to confirm the resistance to a solvent. A case where the reduction rate of the film thickness before and after the immersion in the thinner was 1% or less was judged as "o". The results are shown in Table 3.

### [Measurement of etching rate]

The etcher and etching gas used for the etching measurement are as follows.
RIE-200NL (manufactured by Samco): CF₄ 50 sccm

The concentrations of the resist underlayer film-forming compositions of M1 to M9 and Comparative M1 to M2 were adjusted so that the thickness of a film obtained by baking them at 400°C for 60 seconds was about 100 nm, and each composition was applied onto a silicon wafer using a spin coater and baked. The dry etching rate was measured using CF₄ as an etching gas. The dry etching rate ratio was defined as (resist underlayer film)/(KrF resist), and a case where the dry etching rate ratio was smaller than 0.85 was judged as etching resistance "o", and a case where the dry etching rate ratio was 0.85 or more was judged as etching resistance "×". The results are shown in Table 3.

### [Measurement of Sublimate Quantity]

The concentrations of the resist underlayer film-forming compositions of M1 to M9 and Comparative M1 to M2 were adjusted so that the film thickness of a film obtained by baking them at 400°C for 60 seconds was about 100 nm, and each composition was applied onto a silicon wafer using a spin coater. This wafer was set in a sublimate amount measuring device integrated with a hot plate adjusted to 300°C, baked for 60 seconds, and the sublimate was collected and quantified using a QCM sensor. In the measurement, the temperature of the hot plate was raised to 300°C, the pump flow rate was set to 0.24 m³/s, and the hot plate was left for aging for the first 60 seconds, and immediately thereafter, the wafer coated with the film was quickly placed on the hot plate from the slide port (the measurement object was installed), and the sublimate was collected from the 60-second time point to the 120-second time point (60 seconds). A QCM sensor using an electrode made of a compound containing silicon and aluminum was used, in which the crystal resonator had a diameter (sensor diameter) of 14 mm, the electrode diameter on the surface of the crystal resonator was 5 mm, and the resonance frequency was 9 MHz. A case where the sublimate amount during 60 seconds was less than 1500 ng was judged as "o", and a case where it was 1500 ng or more was judged as "×". The results are shown in Table 3.

### [Embeddability test on stepped substrate]

As a coating test on a stepped substrate, it was confirmed whether or not the stepped substrate, which was a SiO₂ substrate having a film thickness of 100 nm and having a trench width of 20 nm and a depth of 110 nm, was filled with a resist underlayer film. After the resist underlayer film-forming compositions of M1 to M9 and Comparative M1 to M2 were applied to the stepped substrate, they were baked at 400°C for 60 seconds to form a resist underlayer film of about 100 nm. The planarizability of this substrate was observed using a scanning electron microscope (S-4800) manufactured by Hitachi High-Technologies Corporation, and a case where the substrate was filled without voids was regarded as good embeddability and judged as "o", and a case where voids could be confirmed was regarded as poor embeddability and judged as "×". The results are shown in Table 3.

**[Table 3]**

| Examples/ Comparative Examples | Composition | Baking temperature /Time | Solvent resistance | Etching resistance | Sublimate amount | Embeddability |
|---|---|---|---|---|---|---|
| | | | Air 400°C | CF₄ | | |
| Example 1 | M1 | 400°C/60 sec | ○ | ○ | ○ | ○ |
| Example 2 | M2 | 400°C/60 sec | ○ | ○ | ○ | ○ |
| Example 3 | M3 | 400°C/60 sec | ○ | ○ | ○ | ○ |
| Example 4 | M4 | 400°C/60 sec | ○ | ○ | ○ | ○ |
| Example 5 | M5 | 400°C/60 sec | ○ | ○ | ○ | ○ |
| Example 6 | M6 | 400°C/60 sec | ○ | ○ | ○ | ○ |
| Example 7 | M7 | 400°C/60 sec | ○ | ○ | ○ | ○ |
| Example 8 | M8 | 400°C/60 sec | ○ | ○ | ○ | ○ |
| Example 9 | M9 | 400°C/60 sec | ○ | ○ | ○ | ○ |
| Comparative Example 1 | Comparative M1 | 400°C/60 sec | ○ | ○ (0.79) | × (4000 ng) | ○ |
| Comparative Example 2 | Comparative M2 | 400°C/60 sec | ○ | × (0.95) | ○ | × |

As described above, by using the resin obtained in the present invention, the resin alone not only exhibited sufficient solvent resistance in the atmosphere, but also exhibited sufficient etching resistance to a fluorine-based gas, which is a general-purpose etching gas. In addition, since the resin has high heat resistance, the generation of sublimates can also be suppressed, and since the self-crosslinking group contained in the polymer can raise the crosslinking initiation temperature, sufficient reflowability can be obtained, and good embeddability with respect to a substrate with a pattern can be obtained. From these viewpoints, application to a wide range of semiconductor devices can be expected.

### Industrial Applicability

The resist underlayer film-forming composition used in the lithography process using the multilayer film of the present invention exhibits excellent etching resistance, has good planarizability and embeddability with respect to a finely processed substrate, provides an excellent resist pattern, and can further provide a resist underlayer film that has resistance to a solvent even in an air atmosphere, exhibits sufficient curing characteristics, and can also have an effect as an antireflection film. In addition, it was found that the resist underlayer film-forming composition of the present invention has heat resistance capable of forming a hard mask on an upper layer by vapor deposition.

## Claims

1. A resist underlayer film-forming composition comprising:
a resin (G) having a composite unit structure; and
a solvent,
wherein the composite unit structure has
a unit structure (A) having an aromatic ring, and a unit structure (B) having one or more carbon atoms,
the resin (G) is a resin obtained by a reaction of generating a covalent bond between a carbon atom constituting the aromatic ring of the unit structure (A) and a carbon atom in the unit structure (B),
the unit structure (A) includes a unit structure (A-I) containing at least a biphenyl skeleton, and
the unit structure (B) includes a unit structure (B-I) having a quaternary carbon atom bonded to a carbon atom constituting the aromatic ring of the unit structure (A).

2. The resist underlayer film-forming composition according to claim 1, wherein the resin (G) includes, as the composite unit structure, any one or two of the composite unit structures represented by Formulae (1a) and (1b) below, 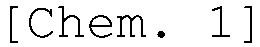 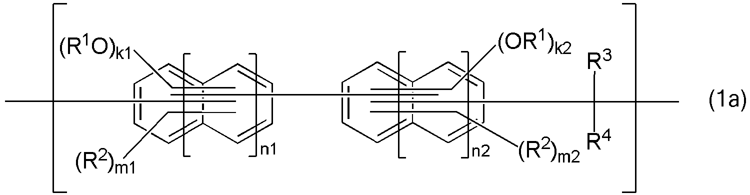 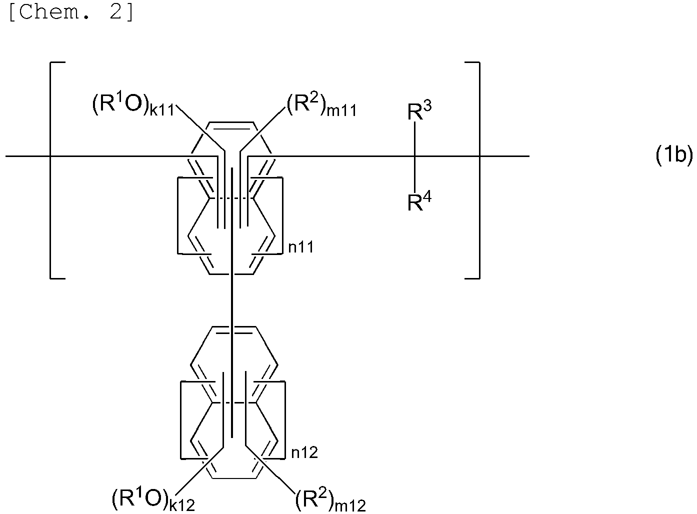 (in Formulae (1a) and (1b), each R¹ independently represents a hydrogen atom, an alkyl group having 1 to 10 carbon atoms, an alkenyl group having 2 to 6 carbon atoms, an alkynyl group having 2 to 6 carbon atoms, or an acyl group having 2 to 7 carbon atoms, each R² independently represents an alkyl group having 1 to 10 carbon atoms, an alkenyl group having 2 to 6 carbon atoms, or a halo group, R³ and R⁴ each independently represent an aromatic or aliphatic hydrocarbon group which may have a substituent, and when R³ and R⁴ bonded to the same carbon atom each represent an aromatic hydrocarbon group, R³ and R⁴ may be bonded to each other to form a fluorene ring, and when R³ and R⁴ bonded to the same carbon atom each represent an aliphatic hydrocarbon group, R³ and R⁴ may be bonded to each other to form an aliphatic hydrocarbon ring, k1, k2, m1, m2, n1, and n2 each independently represent 0 or 1, (k1+k2) is 1 or 2, k11, k12, m11, m12, n11, and n12 each independently represent 0 or 1, and (k11+k12) is 1 or 2).

3. The resist underlayer film-forming composition according to claim 2,
wherein, in Formulae (1a) and (1b), the substituent that the aromatic or aliphatic hydrocarbon group may have is one or more groups selected from a halo group, an alkyl group, an alkenyl group, an alkynyl group, an alkoxy group, an aryl group, an aryloxy group, an amino group, a hydroxy group, a hydroxyalkyl group, a carboxy group, a formyl group, a cyano group, a nitro group, an ester group, an amide group, a sulfonyl-containing group, a thiol group, a sulfide-containing group, and an ether bond-containing group.

4. The resist underlayer film-forming composition according to claim 2,
wherein, in Formulae (1a) and (1b), the aromatic hydrocarbon group is a phenyl group or a naphthyl group.

5. The resist underlayer film-forming composition according to claim 2,
wherein, in Formulae (1a) and (1b), the aliphatic hydrocarbon group is an alkyl group having 1 to 10 carbon atoms.

6. The resist underlayer film-forming composition according to claim 1,
wherein the resin (G) is a resin synthesized by a polymerization reaction of at least one compound having a biphenyl skeleton and at least one aromatic ketone or aliphatic ketone in the presence of an acid catalyst.

7. The resist underlayer film-forming composition according to claim 1, wherein the solvent includes a solvent having a boiling point of 160°C or higher.

8. The resist underlayer film-forming composition according to claim 1, further comprising at least one selected from the group consisting of an acid, a salt thereof, and an acid generator.

9. The resist underlayer film-forming composition according to claim 1, further comprising a crosslinking agent.

10. The resist underlayer film-forming composition according to claim 9, wherein the crosslinking agent is at least one selected from the group consisting of an aminoplast crosslinking agent and a phenoplast crosslinking agent.

11. The resist underlayer film-forming composition according to claim 1, further comprising a surfactant.

12. A resist underlayer film on a semiconductor substrate, which is a cured product of the resist underlayer film-forming composition according to any one of claims 1 to 11.

13. A method for forming a resist pattern used for manufacturing a semiconductor, the method comprising: a step of applying the resist underlayer film-forming composition according to any one of claims 1 to 11 onto a semiconductor substrate and baking the composition to form a resist underlayer film.

14. A method for manufacturing a semiconductor device, the method comprising:
a step of forming a resist underlayer film on a semiconductor substrate using the resist underlayer film-forming composition according to any one of claims 1 to 11;
a step of forming a resist film on the resist underlayer film;
a step of forming a resist pattern by irradiating the resist film with light or an electron beam and developing the resist film;
a step of etching the resist underlayer film through the resist pattern to form a patterned resist underlayer film; and
a step of processing the semiconductor substrate through the patterned resist underlayer film.

15. A method for manufacturing a semiconductor device, the method comprising:
a step of forming a resist underlayer film on a semiconductor substrate using the resist underlayer film-forming composition according to any one of claims 1 to 11;
a step of forming a hard mask on the resist underlayer film;
a step of further forming a resist film on the hard mask;
a step of forming a resist pattern by irradiating the resist film with light or an electron beam and developing the resist film;
a step of etching the hard mask through the resist pattern to form a patterned hard mask;
a step of etching the resist underlayer film through the patterned hard mask to form a patterned resist underlayer film; and
a step of processing the semiconductor substrate through the patterned resist underlayer film.

16. A method for manufacturing a semiconductor device, the method comprising:
a step of forming a resist underlayer film on a semiconductor substrate using the resist underlayer film-forming composition according to any one of claims 1 to 11;
a step of forming a hard mask on the resist underlayer film;
a step of further forming a resist film on the hard mask;
a step of forming a resist pattern by irradiating the resist film with light or an electron beam and developing the resist film;
a step of etching the hard mask through the resist pattern to form a patterned hard mask;
a step of etching the resist underlayer film through the patterned hard mask to form a patterned resist underlayer film;
a step of removing the hard mask; and
a step of processing the semiconductor substrate through the patterned resist underlayer film.

17. A method for manufacturing a semiconductor device, the method comprising:
a step of forming a resist underlayer film on a semiconductor substrate using the resist underlayer film-forming composition according to any one of claims 1 to 11;
a step of forming a hard mask on the resist underlayer film;
a step of further forming a resist film on the hard mask;
a step of forming a resist pattern by irradiating the resist film with light or an electron beam and developing the resist film;
a step of etching the hard mask through the resist pattern to form a patterned hard mask;
a step of etching the resist underlayer film through the patterned hard mask to form a patterned resist underlayer film;
a step of removing the hard mask;
a step of forming a deposited film on the resist underlayer film after the removal of the hard mask;
a step of processing the deposited film by etching;
a step of removing the patterned resist underlayer film to leave a patterned deposited film; and
a step of processing the semiconductor substrate through the patterned deposited film.

18. The method for manufacturing a semiconductor device according to claim 15, wherein the hard mask is formed by applying a composition containing an inorganic substance or by depositing an inorganic substance.

19. The method for manufacturing a semiconductor device according to claim 14, wherein the resist film is pattern-formed by a nanoimprint method or a self-assembled film.

20. The method for manufacturing a semiconductor device according to claim 16, wherein the removal of the hard mask is performed either by etching or by using an alkaline chemical solution.
